(19) Europäisches Patentamt
European Patent Office
Office européen des brevets

(11) EP 2 848 391 B1

(12) **EUROPEAN PATENT SPECIFICATION**

(45) Date of publication and mention of the grant of the patent:
**19.09.2018 Bulletin 2018/38**

(21) Application number: **13787905.2**

(22) Date of filing: **30.04.2013**

(51) Int Cl.:
***B29C 59/04*** (2006.01) ***B29C 65/02*** (2006.01)
***H01L 21/027*** (2006.01) ***B29L 7/00*** (2006.01)
***G03F 7/00*** (2006.01)

(86) International application number:
**PCT/JP2013/062590**

(87) International publication number:
**WO 2013/168634 (14.11.2013 Gazette 2013/46)**

(54) **TRANSFER METHOD AND THERMAL NANOIMPRINT DEVICE**

ÜBERTRAGUNGSVERFAHREN UND THERMISCHE NANOIMPRINT-VORRICHTUNG

PROCÉDÉ DE TRANSFERT ET DISPOSITIF DE NANO-IMPRESSION THERMIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.05.2012 JP 2012106937**
**14.06.2012 JP 2012135005**

(43) Date of publication of application:
**18.03.2015 Bulletin 2015/12**

(60) Divisional application:
**15182156.8 / 2 979 845**

(73) Proprietor: **ASAHI KASEI KABUSHIKI KAISHA**
**Tokyo 101-8101 (JP)**

(72) Inventors:
- **HOSOMI, Naoki**
**Tokyo 101-8101 (JP)**
- **KOIKE, Jun**
**Tokyo 101-8101 (JP)**
- **YAMAGUCHI, Fujito**
**Tokyo 101-8101 (JP)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(56) References cited:
**WO-A1-2011/111815**
**JP-A- 2006 164 365**
**JP-A- 2007 144 995**
**JP-A- 2007 144 995**
**JP-A- 2009 190 300**
**JP-A- 2010 105 210**
**JP-A- 2010 284 814**
**JP-A- 2010 284 814**
**JP-A- 2011 020 272**
**US-A1- 2009 046 362**
**US-A1- 2009 087 506**
**US-A1- 2011 195 189**
**US-A1- 2011 290 759**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 848 391 B1

## Description

TECHNICAL FIELD

The present invention relates to a transfer method and to a thermal nanoimprinting apparatus.

TECHNICAL BACKGROUND

Photolithography techniques have recently come to be frequently used as techniques for fabricating a concavo-convex structure in LSI manufacturing. However, in a photolithography technique, it is difficult to fabricate a concavo-convex structure having a size smaller than the wavelength of light used for light exposure. Other techniques for fabricating the concavo-convex structure include mask concavo-convex structure lithography using an electron-beam lithography apparatus (EB method). An EB method has drawbacks in that the mask concavo-convex structure is drawn directly by an electron beam, and the drawing time therefore increases with the number of drawn the concavo-convex structure, and throughput of forming the concavo-convex structure is markedly reduced. Due to high accuracy control of the mask position in an exposure apparatus for photolithography, increased size of the electron-beam lithography apparatus in an exposure apparatus for an EB method, and other factors, the abovementioned methods have the drawback of high equipment cost.

Nanoimprinting techniques have been proposed as concavo-convex structure fabrication techniques whereby the problems described above can be overcome. Among the proposed techniques, an optical nanoimprinting has garnered attention from the perspectives of transfer accuracy and ease of use. In an optical nanoimprinting method, a mold on which a nanoscale concavo-convex structure is formed is pressed to a liquid resist layer formed on a surface of a transfer substrate, and the concavo-convex structure formed on the mold is thereby transferred to the surface of the transfer substrate.

In particular, from the perspective of transfer accuracy, transferring a concavo-convex structure onto a flat-plate-shaped target object using a sheet-shaped mold has been proposed (see Patent Document 1).

However, in the method disclosed in Patent Document 1, (1) a face of a target object is pressed against one principal face (referred to as a concavo-convex structure face hereinafter) of a sheet-shaped mold on which a concavo-convex structure is formed, via a liquid resist layer, in a state in which one principal face of the target object and the concavo-convex structure face of the sheet-shaped mold are parallel or essentially parallel. It is therefore difficult to prevent entrapment of bubbles or to equalize the pressure distribution during pressing. Entrapment of bubbles reduces the transfer accuracy of the concavo-convex structure, and a large pressure distribution leads to significant unevenness of the film thickness of the liquid resist layer. The more effort is made to equalize the pressure distribution, the larger the thermal nanoimprinting apparatus becomes. In particular, the larger the area of the concavo-convex structure used for transfer becomes, the more difficult it becomes to achieve a uniform pressure and increase the area.

(2) The thermal nanoimprinting apparatus is accompanied by a molded article release apparatus for separating a molded article from a mold after transfer. In the molded article release apparatus, the concavo-convex structure face of the sheet-shaped mold and a layered body comprised of the resist layer/target object are peeled as faces in a state in which the one principal face of the target object and the concavo-convex structure face of the sheet-shaped mold are parallel or essentially parallel. The stress applied to the concavo-convex structure of the resist layer on which the concavo-convex structure is transferred and formed is therefore increased, which leads to breakage of the concavo-convex structure or peeling of the first mask layer from the target object. As a result, the transfer accuracy is reduced.

(3) The thermal nanoimprinting apparatus accompanied by a molded article release apparatus for separating the molded article and the mold after transfer is provided between a region where the sheet-shaped mold is wound off from a roll on which the sheet-shaped mold is rolled up and a region where the sheet-shaped mold is taken up. Consequently, since the next transfer cannot be performed unless a step for separating the mold and the molded article is performed after transfer, continuous production is not possible, and transfer efficiency declines.

Since a liquid resist layer is used in an optical nanoimprinting method as described above, the optical nanoimprinting method has the drawback of using a complex and excessively large apparatus.

In order to overcome these problems, a thermal nanoimprinting method that does not use a liquid resist layer has been proposed. A thermal nanoimprinting method always includes a step for pressing a concavo-convex structure of a mold to a transfer object, a step for cooling the transfer object, and a step for releasing the mold from the transfer object. In such a thermal nanoimprinting method, the concavo-convex structure of the mold must be pressed to the transfer object at a temperature equal to or greater than the glass transition temperature (Tg) or the melting point (Tm) of the transfer object. Specifically, heat must be uniformly applied to the transfer object to cause uniform fluidization,

and the mold must be uniformly pressed. From this perspective, a surface pressure mechanism is generally employed as the pressing mechanism. Problems therefore arise in having an excessive pressurization part in order to increase the pressure applied during pressing. A mechanism is also needed for closely controlling the parallel degree between the mold and the transfer object in order to suppress entrapment of outside air. The control mechanism for the apparatus therefore becomes too large, and is prone to complexity. The need for a high temperature during pressing also necessitates an excessively large cooling mechanism, and the control mechanism for the apparatus becomes complex for this reason as well.

A thermal nanoimprinting method is disclosed in Patent Document 2. Patent Document 2 discloses a thermal nanoimprinting method for transferring a concavo-convex structure of a mold to a transfer object (thermoplastic resin). In this method, the volume of the thermoplastic resin and the volume of the concavo-convex structure of the mold satisfy a predetermined relationship, the mold is pressed to the thermoplastic resin in a state in which the mold and the thermoplastic resin are heated, and after cooling in the pressed state, the mold is peeled. However, even in this configuration, since uniform heating and uniform pressing are necessary in order to cause uniform fluidity in the thermoplastic resin as described above, a surface pressure mechanism is employed. It is therefore easy to imagine having an excessive pressurization part in order to increase the pressure applied during pressing. Since a surface pressure mechanism is also necessary, it can easily be inferred that a mechanism is also needed for closely controlling the parallel degree between the mold and the thermoplastic resin. The concavo-convex structure of the mold is also pressed against the thermoplastic resin in the surface pressure mechanism. From this perspective, the heating temperature must be at least equal to or more to the glass transition temperature of the thermoplastic resin, which is a high temperature. Specifically, this method also has drawbacks in that the need for a high temperature during pressing necessitates an excessively large cooling mechanism, and the control mechanism for the apparatus becomes complex in this case as well.

RELATED ART DOCUMENT

Patent Document 1: Japanese Unexamined Patent Application Publication No. 2011-020272

Patent Document 2: Japanese Patent No. 4943876 US-A-2011/195189 discloses a pattern formation method which includes applying an imprint material onto a work piece film; and bringing a transfer surface having a first unevenness of a template into contact with the imprint material to form a second unevenness in the imprint material. The second unevenness reflects a configuration of the first unevenness. The method further includes curing the imprint material; filling a mask material into a recess of the second unevenness of the cured imprint material; exposing a part of the work piece film by using the filled mask material as a mask to pattern the imprint material; and patterning the work piece film by using the patterned imprint material as a mask.

US-A-2011/290759 discloses the formation of a pattern including forming a first imprint mask layer on a processed member; forming a first imprint pattern of the first imprint mask layer using a first template; forming a second imprint mask layer made of a material having a different etching rate from the first imprint mask layer on the first imprint pattern; forming a second imprint pattern of the second imprint mask layer using a second template different from the first template; and etching the processed member using as a mask the second imprint mask layer on which the second imprint pattern is formed and the first imprint mask layer on which the first imprint pattern is formed.

JP-A-2010284814 discloses a method of manufacturing a stamper for nanoimprinting including at least a step (a) of forming a thin metal film on a surface of a substrate, a step (b) of forming a resist layer on the surface of the thin metal film, a step (c) of forming an relief pattern on the resist layer using an electron beam lithography method, a step (d) of etching the thin metal film according to the relief pattern of the resist layer to form a pattern-shaped metal mask, and a step (e) of forming an relief pattern on the substrate according to the metal mask. By side-etching the thin metal film in the step (d), the width of protrusions formed in the substrate in the step (e) is reduced to be smaller than the width of the recess of the relief pattern formed in the step (c).

JP-A-2007144995 discloses a quartz substrate having ultraviolet light-permeable properties that is coated with an electron beam resist. It is further irradiated with an electron beam to form a resist pattern. Thereafter, dry etching is applied on the quartz substrate by using an etching gas such as tetrafluorocarbon to form a pattern on the quartz substrate. Then, on the face of the quartz substrate which has the pattern, a photo-catalytic titanium oxide film is formed by sputtering or the like to prepare the mold.

US-A-2009/046362 discloses an apparatus and methods for a nano-patterning process to fabricate nanostructures. A roller type mold is used to continuously imprint nanostructures onto a flexible web or a rigid substrate. The process includes a coating and an imprinting module, which rotate the web synchronously. Liquid resist materials are used for imprinting and the patterns are set by thermal or UV curing. The process is used to produce bilayer metal wire-grid

polarizers, organic solar cells, and organic light emitting diodes.
JP-A-2009190300 and JP-A-2006164365 disclose a transfer method which comprises filling an irregular pattern of an imprint mold with a resin before pressing the imprint mold onto a transfer substrate.

## SUMMARY OF THE INVENTION

### PROBLEMS TO BE SOLVED BY THE INVENTION

As described above, in a conventional thermal nanoimprinting method, since a surface pressure mechanism is employed in the pressing step, and a mechanism is needed for adjusting the parallel degree between the mold and the transfer object in order to enhance the transfer accuracy, the apparatus becomes complex and excessively large. The conventional thermal nanoimprinting method also has drawbacks in that a high-temperature heating mechanism is needed, which creates the need for an excessively large cooling mechanism.
In order to overcome such drawbacks, a thermal nanoimprinting apparatus is needed that is capable of thermal nanoimprinting at low pressure and low temperature.
The present invention was developed in view of the foregoing, and an object of the present invention is to provide a transfer method and a thermal nanoimprinting apparatus whereby a concavo-convex structure can be transferred with high accuracy at low pressure and low temperature using a thermal nanoimprinting method and without the need for excessively large equipment.

### MEANS FOR SOLVING THE PROBLEMS

The transfer method pertaining to the present invention is a transfer method for transferring a first mask layer and a second mask layer to a target object using a fine-pattern-forming film provided with a cover film having a nanoscale concavo-convex structure formed on one surface thereof, a second mask layer provided in a recess of the concavo-convex structure, and a first mask layer provided so as to cover the concavo-convex structure and the second mask layer; the transfer method characterized in including, at least in this order: a pressing step for pressing a surface of the fine-pattern-forming film on which the first mask layer is provided toward a surface of the target object; an energy-ray irradiation step for irradiating energy rays to the first mask layer; and a release step for removing the cover film from the second mask layer and the first mask layer; the pressing step and the energy-ray irradiation step each being performed independently.
The thermal nanoimprinting apparatus pertaining to the present invention is a thermal nanoimprinting apparatus for transferring the first mask layer and the second mask layer onto the target object by the transfer method described above, and is characterized in that: a laminating part is provided for laminating together the fine-pattern-forming film and the target object in a state in which a surface on which the first mask layer is formed is brought to face one surface of the target object; the laminating part is provided with a pressing part for applying a pressing force essentially in a line to the fine-pattern-forming film or the target object, the pressing part being provided with a rotating body for contacting the fine-pattern-forming film or the target object essentially in a line; and at least a surface layer of the rotating body is comprised of an elastic body having a glass transition temperature of 100°C or below.

### EFFECTS OF THE INVENTION

Through the present invention, a transfer method and a thermal nanoimprinting apparatus can be provided whereby a concavo-convex structure can be transferred with high accuracy at low pressure and low temperature using a thermal nanoimprinting method and without the need for excessively large equipment.

### BRIEF DESCRIPTION OF DRAWINGS

FIG. 1 is a schematic sectional view showing the fine-pattern-forming film pertaining to the present embodiment;
FIG. 2 is a process diagram for describing the method for forming a fine pattern on a target object using the fine-pattern-forming film pertaining to the present embodiment;
FIG. 3 is a process diagram for describing the method for forming a fine pattern on a target object using ' the fine-pattern-forming film pertaining to the present embodiment;
FIG. 4 is a process diagram for describing the method for forming a fine pattern on a target object using the fine-pattern-forming film pertaining to the present embodiment;
FIG. 5 is a process diagram for describing the method for forming a fine pattern on a target object using the fine-pattern-forming film pertaining to the present embodiment;

FIG. 6 is a schematic sectional view showing an example in which an elastic body is provided to the fine-pattern-forming film pertaining to the present embodiment;

FIG. 7 is a schematic sectional view relating to laminating of the target object and the fine-pattern-forming film pertaining to the present embodiment;

FIG. 8 is a schematic sectional view relating to release of the fine-pattern-forming film pertaining to the present embodiment and the first mask layer transferred onto the target object;

FIG. 9 is a schematic sectional view showing an example of the rotating body pertaining to the present embodiment;

FIG. 10 is a view showing the pressing part in the thermal nanoimprinting apparatus pertaining to the present embodiment;

FIG. 11 is a schematic perspective view showing the pressing part provided to the laminating part pertaining to the thermal nanoimprinting apparatus pertaining to the present embodiment;

FIG. 12 is a schematic side view showing the pressing part in the thermal nanoimprinting apparatus pertaining to the present embodiment;

FIG. 13 is a schematic sectional view showing the rotating body accompanied by the press heating part in the thermal nanoimprinting apparatus pertaining to the present embodiment;

FIG. 14 is a schematic view showing the thermal nanoimprinting apparatus pertaining to a first embodiment;

FIG. 15 is a schematic view showing peeling of the fine-pattern-forming film by the peeling part in the thermal nanoimprinting apparatus pertaining to the first embodiment;

FIG. 16 is a schematic view showing peeling of the fine-pattern-forming film by the peeling part in the thermal nanoimprinting apparatus pertaining to the first embodiment;

FIG. 17 is an explanatory diagram for explaining the change in direction of the fine-pattern-forming film at the peeling part in the thermal nanoimprinting apparatus pertaining to the first embodiment;

FIG. 18 is a schematic view showing the thermal nanoimprinting apparatus pertaining to a second embodiment;

FIG. 19 is a schematic plan view showing the position of cutting by the cutting part in the thermal nanoimprinting apparatus pertaining to the second embodiment;

FIG. 20 is a schematic view showing the thermal nanoimprinting apparatus pertaining to the third embodiment;

FIG. 21 is a schematic view showing the relationship between the target object and the fine-pattern-forming film in the laminating part in the thermal nanoimprinting apparatus pertaining to the third embodiment;

FIG. 22 is a schematic view showing a modification of the thermal nanoimprinting apparatus pertaining to the third embodiment;

FIG. 23 is a schematic view showing a modification of the thermal nanoimprinting apparatus pertaining to the third embodiment;

FIG. 24 is a schematic view showing a modification of the thermal nanoimprinting apparatus pertaining to the third embodiment;

FIG. 25 is a schematic view showing a modification of the thermal nanoimprinting apparatus pertaining to the third embodiment;

FIG. 26 is a schematic view showing a modification of the thermal nanoimprinting apparatus pertaining to the third embodiment;

FIG. 27 is a schematic view showing the thermal nanoimprinting apparatus pertaining to a fourth embodiment;

FIG. 28 is a schematic view showing a modification of the thermal nanoimprinting apparatus pertaining to the fourth embodiment;

FIG. 29 is a schematic view showing a modification of the thermal nanoimprinting apparatus pertaining to the fourth embodiment;

FIG. 30 is a schematic view showing the thermal nanoimprinting apparatus pertaining to a fifth embodiment;

FIG. 31 is a schematic view showing the operation of the thermal nanoimprinting apparatus in the transfer method pertaining to the fifth embodiment;

FIG. 32 is a schematic view showing the operation of the thermal nanoimprinting apparatus in the transfer method pertaining to the fifth embodiment;

FIG. 33 is a schematic sectional view showing the steps of the method for manufacturing a fine-pattern-forming film pertaining to the present embodiment;

FIG. 34 is a schematic sectional view showing the steps of the method for manufacturing a fine-pattern-forming film pertaining to the present embodiment;

FIG. 35 is a schematic sectional view showing a pillar-shaped concavo-convex structure in the fine-pattern-forming film pertaining to the present embodiment;

FIG. 36 is a schematic sectional view showing a hole-shaped concavo-convex structure in the fine-pattern-forming film pertaining to the present embodiment;

FIG. 37 is a schematic sectional view showing the steps of the method for manufacturing a fine-pattern-forming film

pertaining to the present embodiment;

FIG. 38 is a schematic sectional view showing the fine-pattern-forming film pertaining to the present embodiment;

FIG. 39 is a view showing an example of the arrangement of protrusions of the concavo-convex structure in the fine-pattern-forming film pertaining to the present embodiment; and

FIG. 40 is a schematic sectional view showing the fine-pattern-forming film pertaining to the present embodiment.

BEST MODE FOR CARRYING OUT THE INVENTION

An embodiment of the present invention (referred to as "embodiments" hereinafter) will next be described in detail. The present invention is not limited to the embodiments described below, and can be implemented with various modifications within the intended scope of the present invention.

<Summary of the fine-pattern-forming film>

A summary of the fine-pattern-forming film pertaining to the present embodiment will first be given.

The fine-pattern-forming film described below is used in the thermal nanoimprinting method of the present invention or a thermal nanoimprinting method that uses the thermal nanoimprinting apparatus of the present invention. Thermal nanoimprinting can thereby be performed with high accuracy at lower temperatures and pressures.

The fine-pattern-forming film pertaining to the present invention is a film in which a second mask layer and a first mask layer are deposited on a concavo-convex structure of a cover film, the concavo-convex structure being formed on one surface of the cover film. FIG. 1 is a schematic sectional view showing the fine-pattern-forming film pertaining to the present embodiment. As shown in FIG. 1, in the fine-pattern-forming film I, a resin layer 3 is provided on a surface of a cover film 2. A concavo-convex structure 3a is formed on a face of the resin layer 3 on the opposite side thereof to a face thereof adjacent to the cover film 2. References to the cover film 2 below shall be understood to include the resin layer 3 in which the concavo-convex structure 3a is formed. A second mask layer 4 is filled into recesses of the concavo-convex structure 3a. A first mask layer 5 is deposited so as to cover the second mask layer 4 and the concavo-convex structure 3a. A protective layer may be provided on the first mask layer 5.

In a laminating part accompanying the thermal nanoimprinting apparatus described hereinafter, a face laminated to a target object is a surface of the first mask layer 5. A film peeled in a peeling part is the cover film 2, and a concavo-convex structure comprising the first mask layer 5 and the second mask layer 4 is transferred onto the target object.

FIGS. 2A through 2C and FIGS. 3A through 3F are process diagrams for describing the method for forming a fine pattern on a target object using the fine-pattern-forming film pertaining to the present embodiment. As shown in FIG. 2A, a concavo-convex structure 11 is formed on a principal face of a cover film 10. The concavo-convex structure 11 is comprised of a plurality of recesses 11a and protrusions 11b. The cover film 10 is a film-shaped or sheet-shaped molded article, for example.

First, as shown in FIG. 2B, a second mask layer 12 for patterning a first mask layer described hereinafter is filled into the recesses 11a of the concavo-convex structure 11 of the cover film 10. The second mask layer 12 comprises a sol-gel material, for example. Here, a layered body provided with the cover film 10 and the second mask layer 12 is referred to as a first fine-pattern-forming film I, or simply as a first layered body I.

As shown in FIG. 2C, a first mask layer 13 is then formed on the concavo-convex structure 11 that includes the second mask layer 12 of the first layered body I. The first mask layer 13 is used in the patterning of the target object described hereinafter. The first mask layer 13 comprises a photocurable resin, a thermosetting resin, or a thermoplastic resin, for example.

A protective layer 14 may furthermore be provided on a top side of the first mask layer 13, as shown in FIG. 2C. The protective layer 14 is for protecting the first mask layer 13, and is not essential. Here, the layered body comprising the cover film 10, the second mask layer 12, and the first mask layer 13 is referred to as a second fine-pattern-forming film II, or simply as a second layered body II. This second layered body II can be used in patterning of the target object by laminating the first mask layer 13 to the target object.

A target object 20 such as the one shown in FIG. 3A is then prepared. The target object 20 is a flat-plate-shaped inorganic substrate, and is a sapphire substrate, a SiC (silicon carbide) substrate, a Si (silicon) substrate, a spinel substrate, or a nitride semiconductor substrate, for example. First, as shown in FIG. 3B, an exposed face of the first mask layer 13 of the second layered body II is laminated on a principal face of the target object 20 so as to face the principal face of the target object 20. As a result, a third layered body III comprised of the second layered body II and the target object 20 is obtained. A lamination, particularly thermal lamination, for example, is suitable as the laminating. This operation is performed by a laminating part of the thermal nanoimprinting apparatus described hereinafter.

Then, as shown in FIG. 3C, the cover film 10 is peeled from the first mask layer 13 and the second mask layer 12. As a result, an intermediate body 21 comprising the target object 20, the first mask layer 13, and the second mask layer 12 is obtained. This operation is performed by a peeling part of the thermal nanoimprinting apparatus described

hereinafter.

The second layered body II is unwound by a feeding roller described hereinafter, and is taken up by a take-up roller described hereinafter. Specifically, the abovementioned laminating is performed downstream from the feeding roller in the conveying direction of the second layered body II, and the abovementioned peeling is performed downstream from the laminating in the conveying direction and upstream from the take-up roller in the conveying direction.

Furthermore, the target object may move in conjunction with conveyance of the second layered body II between the abovementioned laminating and peeling. In other words, the second layered body II serves as a carrier for the target object.

Energy rays may be irradiated to the second layered body II and the first mask layer 13 cured or solidified between the laminating and the peeling described above. The first mask layer 13 may also be cured or solidified by heat applied during laminating and pressing. After energy rays have been irradiated to the second layered body II and the first mask layer 13 cured or solidified, the stability of the first mask layer 13 may be enhanced by heating the third layered body III. Furthermore, the first mask layer 13 may be cured or solidified by energy ray irradiation or heat treatment subsequent to peeling. These operations are performed between laminating and peeling, and are therefore performed in a state in which the pressure applied during laminating is released. In particular, in the step for irradiating energy rays subsequent to laminating, the pressure applied during laminating is released during energy ray irradiation.

The obtained intermediate body 21 is collected by the collection part, and is temporarily stored or immediately sent to the step described below.

The intermediate body 21 collected by the collection part is conveyed to a apparatus different from the thermal nanoimprinting apparatus. The first mask layer 13 is then patterned as shown in FIG. 3D by oxygen ashing, for example, using the second mask layer 12 as a mask. As a result, a fine mask structure body 16 is obtained that is provided with a fine mask pattern 16a comprised of the first mask layer 13 and the second mask layer 12 and having a high aspect ratio. Reactive ion etching, for example, is furthermore performed on the target object 20 using the patterned first mask layer 13 as a mask, and a fine pattern 22 is formed on a principal face of the target object 20, as shown in FIG. 3E. Lastly, as shown in FIG. 3F, the first mask layer 13 remaining on the principal face of the target object 20 is removed, and a target object 20 having the fine pattern 22 is obtained.

In the present embodiment, the process shown in FIGS. 2A through 2C from the cover film 10 to obtaining the second layered body II is performed in a single line (referred to as a first line hereinafter). The subsequent process from FIG. 3A to FIG. 3F is performed in a separate line (referred to as a second line hereinafter). In a more preferred mode, the first line and the second line are performed at separate facilities. The second layered body II is therefore packaged in a scroll shape (roll shape) for storage or transport.

In a more preferred application of the present invention, the first line is the line of a supplier of the second layered body II, and the second line is the line of a user of the second layered body II. Mass-producing the second layered body II in advance at the supplier and providing the second layered body II to the user in this manner produces advantages such as those described below.

(1) The accuracy of the concavo-convex structure 11 of the cover film 10 constituting the second layered body II can be reflected in micro-fabrication on the target object 20. Specifically, the accuracy of the concavo-convex structure 11 of the cover film 10 constituting the second layered body II is guaranteed by the second mask layer 12. Furthermore, since the film thickness accuracy of the first mask layer 13 can be guaranteed by the second layered body II, a high accuracy can be maintained in the film thickness distribution of the first mask layer 13 transferred and formed on the target object 20. Specifically, by using the second layered body II, the second mask layer 12 and the first mask layer 13 can be transferred and formed with high accuracy of the film thickness distribution of the first mask layer 13 and high accuracy of transfer of the concavo-convex structure 11 in the plane of the target object 20. Therefore, by micro-fabrication of the first mask layer 13 using the second mask layer 12, the pattern accuracy (arrangement accuracy of the concavo-convex structure 11) of the cover film 10 can be reflected in the plane of the target object 20, and a fine mask structure body 16 can be formed that is provided with a fine mask pattern 16a comprised of the second mask layer 12 and the first mask layer 13 in a highly precise film thickness distribution and having a high aspect ratio. Through use of a fine mask structure body 16 having high accuracy, the target object 20 can be processed with high accuracy, and it is possible to produce a fine pattern 22 in which the fine pattern accuracy (arrangement accuracy of the concavo-convex structure 11) of the cover film 10 is reflected in the plane of the target object 20.

(2) Since the accuracy of the fine pattern can be assured in the second layered body II, micro-fabrication on the target object 20 can be performed in a facility that is suitable for processing the target object 20 without the use of a complex process or apparatus.

(3) Since the accuracy of the fine pattern can be guaranteed by the second layered body II, the second layered body II can be used in the optimum location for manufacturing a device using the target object 20. Specifically, a device having stable functioning can be manufactured.

By making the first line a line of a supplier of the second layered body II and making the second line a line of a user of the second layered body II as described above, the second layered body II can be used in the optimum environment for processing the target object 20, as well as in the optimum environment for manufacturing a device using the target object 20. The throughput of processing of the target object 20 and assembly of a device can therefore be enhanced. Furthermore, the second layered body II is comprised of the cover film 10 and functional layers (the second mask layer 12 and the first mask layer 13) provided on the concavo-convex structure 11 of the cover film 10. Specifically, the placement precision of the first mask layer 13 and the second mask layer 12, which governs the processing accuracy of the target object 20, can be guaranteed by the accuracy of the concavo-convex structure 11 of the cover film 10 of the second layered body II, and the film thickness accuracy of the first mask layer 13 can be assured in the second layered body II. By making the first line a line of a supplier of the second layered body II and making the second line a line of a user of the second layered body II as described above, the target object 20 can be processed with high accuracy using the second layered body II and used in the optimum environment for manufacturing a device using the target object 20.

As described above, the second layered body II primarily assures the accuracy of the fine pattern of the first mask layer 13 and second mask layer 12, and the film thickness accuracy of the first mask layer 13, and the fine pattern 22 can thereby be provided to the target object 20 with high accuracy in the plane of the target object 20. Here, when the second layered body II bends and air voids occur during laminating of the first mask layer 13 of the second layered body II to the target object 20, the in-plane precision of the fine pattern 22 provided to the target object 20 is significantly reduced. Furthermore, when excessive stress is applied to the fine pattern of the first mask layer 13 and second mask layer 12, or the second layered body II is twisted during peeling of the cover film 10 from the layered body comprising the second layered body II/target object 20, problems occur such as cohesive failure of the first mask layer 13, interfacial delamination between the first mask layer 13 and the target object 20, and peeling defects in the first mask layer 13, the second mask layer 12, and the cover film 10.

Through use of the thermal nanoimprinting apparatus of the present invention, a fine-pattern-forming film can be suitably used. Thermal nanoimprinting can thereby be performed at low temperature and low pressure.

<Mask pattern transfer step>

Steps which use the fine-pattern-forming film will next be described. The method for forming the fine pattern 22 on the target object 20 is divided into a mask pattern transfer step and an etching step.

FIGS. 4 and 5 are process diagrams for describing the method for forming a fine pattern on a target object using the fine-pattern-forming film pertaining to the present embodiment. The mask pattern transfer step is shown in FIGS. 4A and 4B, and FIGS. 5B and 5C.

The mask pattern transfer step is characterized by including at least a pressing step, an energy ray irradiation step, and a release step in this order, and in that the pressing step and the energy ray irradiation step are performed independently of each other. Here, the pressing step is performed by the laminating part of the thermal nanoimprinting apparatus pertaining to the present embodiment. The release step is performed by a peeling means and holding means of the thermal nanoimprinting apparatus pertaining to the present embodiment.

The second layered body II shown in FIG. 4A is comprised of the cover film 10 comprised of a support base material 10a and a resin layer 10b, the second mask layer 12 filled into the concavo-convex structure 11 formed in the resin layer 10b of the cover film 10, and the first mask layer 13 provided on the concavo-convex structure 11 including the second mask layer 12. When the protective layer 14 is provided on the surface of the first mask layer 13 of the second layered body II, the protective layer 14 is first removed from the second layered body II, and the surface of the first mask layer 13 is exposed as shown in FIG. 4B.

(Pressing step)

In the pressing step, as shown in FIG. 5A, the second layered body II is pressed against the target object 20 via the first mask layer 13, the second layered body II and the target object 20 are laminated together and bonded, and the third layered body III is obtained. At this time, the second layered body II and the target object 20 are closely bonded by being pressed while being heated. Regarding the second layered body II, this operation is performed for the purpose of bonding between the target object 20 and the first mask layer 13.

When a thermocompression-bondable resin is selected as the first mask layer 13, heating is preferably performed at the time of pressing in order to increase the fluidity of the first mask layer 13. This heating is preferably performed from at least a side of the target object 20, and the heating temperature is preferably from 60°C to 200°C.

(Elastic body)

FIG. 6 is a schematic sectional view showing an example in which an elastic body is provided to the fine-pattern-forming film pertaining to the present embodiment. As shown in FIG. 6, an elastic body 50 may be provided to either the cover film 10 side of the second layered body II (see FIG. 6A) or the target object 20 side (see FIG. 6B) so that the first mask layer 13 and the target object 20 are laminated without film thickness irregularity being caused by the concavo-convex structure 11 of the cover film 10. By providing the elastic body 50, the second layered body II follows the unevenness and undulation of the surface of the target object 20, and as a result, laminating that is free of film thickness irregularity becomes possible. The elastic body 50 may also be provided on both the cover film 10 side of the second layered body II and the target object 20 side, as shown in FIG. 6C.

A roll provided with the elastic body 50 on a surface thereof is preferred for use as the elastic body 50. By using a roll provided with the elastic body 50 on the surface thereof, the second layered body II can be continuously laminated to the target object 20 in roll-to-roll processing. This elastic body 50 corresponds to the laminating part in the thermal nanoimprinting apparatus pertaining to the present embodiment.

(Low-Tg elastic body)

An elastic body having a glass transition temperature Tg of 100 degrees or lower is preferred as the elastic body 50, and a publicly known, commercially available rubber sheet, resin sheet, film, or the like may be used, but because the degree of elastic deformation increases particularly when the glass transition temperature is 60°C or lower, pressing becomes effective, and thermal nanoimprinting can be performed with high accuracy at lower temperatures and pressures. From the same perspective, the glass transition temperature is more preferably 30 degrees or lower. Furthermore, a glass transition temperature of 30 degrees or lower is preferred because the line width described after the description of laminating part of the thermal nanoimprinting apparatus pertaining to the present embodiment is easily satisfied, and a better heat distribution and pressing force distribution can be obtained in thermal nanoimprinting. From the same perspective, the glass transition temperature is preferably 0°C or lower, and most preferably -20°C or lower. Silicone rubber, nitrile rubber, fluororubber, polyisoprene (natural rubber), polybutadiene, polyvinyl acetate, polyethylene, polypropylene, nylon 6, nylon 66, polyethylene terephthalate, polyvinyl chloride, polyvinylidene chloride, polytetrafluoroethylene, polyvinylidene fluoride, polymethyl methacrylate, and polystyrene are cited as examples of such a low-Tg elastic body. A Young's modulus (longitudinal elastic modulus) of equal to or more than 1 Mpa but equal to or less than 100 Mpa is preferred because the film thickness of the first mask layer 13 can be made small and homogeneous, and a Young's modulus of equal to or more than 4 Mpa but equal to or less than 50 Mpa is more preferred. For the sake of the same effect, the thickness of the elastic body 50 is preferably equal to or more than 0.5 mm but equal to or less than 10 cm, more preferably equal to or more than 1 mm but equal to or less than 8 cm, and most preferably equal to or more than 5 mm but equal to or less than 10 cm.

Compressed air, compressed gas, or the like can also be employed as the elastic body 50. Particularly when compressed air or compressed gas is used, pressure is preferably applied from the cover film 10 side of the second layered body II, as shown in FIG. 6A.

(Laminating)

Entrapped environmental atmosphere during laminating reduces the ratio (transfer ratio) at which the second mask layer 12 and the first mask layer 13 are transferred to the target object 20. Problems therefore occur according to the application of the target object 20. For example, when the target object is used as an LED substrate, micro-entrapment (entrapped environmental atmosphere on the scale of nanometers to tens of micrometers) of oxygen (oxygen in air) during laminating can lead to defects in an LED semiconductor crystal layer, adversely affect the light emission characteristics of the LED, and can increase leakage currents. Micro-entrapment (bubbles on the scale of tens of micrometers to millimeters) during laminating can also lead to significant defects and reduce yield in the manufacture of a high-efficiency LED. Therefore, any of the procedures (1) through (4) described below or a hybrid procedure thereof is preferably employed when laminating the first mask layer 13 to the target object 20.

(1) Laminating is performed in a low-oxygen atmosphere. By having a reduced oxygen concentration, even when the environmental atmosphere is entrapped into the interface between the first mask layer 13 and the target object 20, curability of the first mask layer 13 can be satisfactorily maintained, and the accuracy of transfer can therefore be enhanced. A low-oxygen atmosphere can be created by introducing a vacuum (decompression) or a gas such as $N_2$ gas or Ar gas, by introducing a compressible gas such as pentafluoropropane or carbon dioxide, or by another method. Laminating properties can be improved particularly by employing a vacuum (decompression) environment. FIG. 7 is a schematic sectional view relating to laminating of the target object and the fine-pattern-forming film

pertaining to the present embodiment. In FIGS. 7A through 7C, since the first layered body I and the second layered body II are represented as the same schematic view for the sake of convenience, the unevenness of the surface of the concavo-convex structure 11 of the first layered body I is omitted, and a flat shape is shown. In the second layered body II shown in FIGS. 7A through 7C, the first mask layer 13 is provided to the side thereof that is laminated with the target object 20, and the first mask layer 13 is in contact with the target object 20.

(2) In this method, the second layered body II is brought into contact with the target object 20 from one edge part of the second layered body II toward the other-edge part thereof, and the surface area of contact is gradually increased, as shown in FIG. 7A. In this case, since a route of escape for the environmental atmosphere is created relative to a case of a parallel flat-plate-type laminating, engulfment of the environmental atmosphere is reduced.

(3) In this procedure, the central vicinity of the second layered body II is deformed into a downward-convex shape, the second layered body II in this state is brought into contact with the target object 20, and the deformation is then returned to the original state, as shown in FIG. 7B. In this case, since a route of escape for the environmental atmosphere is created relative to a case of a parallel flat-plate-type laminating, engulfment of the environmental atmosphere is reduced.

(4) In this procedure, the second layered body II is bent, the second layered body II is brought into contact with the elastic body 50 from one edge part of the second layered body II toward the other-edge part thereof, and laminating is performed according to a basic procedure of lamination, as shown in FIG. 7C. In this case, since a route of escape for the environmental atmosphere is created relative to a case of a parallel flat-plate-type laminating, engulfment of the environmental atmosphere is reduced. This method is effective particularly when the cover film of the second layered body II is a flexible mold. By bending the second layered body II using a roll provided with the elastic body 50 on the surface thereof and bringing the second layered body II into contact with the target object 20 from one edge part of the second layered body II to the other-edge part thereof, the second layered body II can be continuously laminated to the target object 20 in roll-to-roll processing.

(Energy ray irradiation step)

As shown in FIG. 5B, in the energy ray irradiation step, energy rays are irradiated to the layered body III, in which the second layered body II and the target object 20 are bonded, in a state in which the pressure applied during laminating is released, and the first mask layer 13 is cured. Since there is thereby no need to cure the first mask layer 13 while applying pressure as in the conventional method, the pressing step and the energy ray irradiation step can be independently performed, and process management in the manufacture of the concavo-convex structure body 40 described hereinafter is facilitated.

The purpose of the energy ray irradiation step is to enhance the stability of the second mask layer 12 and the first mask layer 13, and to markedly enhance the bonding strength at the interface between the second mask layer 12 and the first mask layer 13. A further purpose in the case of the second layered body II is to further bond the first mask layer 13 and the target object 20.

Energy ray irradiation is effective in causing chemical bonding based on a chemical reaction at the interface between the second mask layer 12 and the first mask layer 13. The type of energy rays can be appropriately selected in accordance with the composition of the second mask layer 12 and the first mask layer 13, and is therefore not particularly limited, but X-rays, UV rays, IR rays, and the like are cited as examples thereof. The energy rays are also preferably irradiated from the second layered body II side and/or the target object 20 side. In particular, when the target object 20 or at least a portion of the second layered body II is an energy-ray-absorbent, energy rays are preferably irradiated from the side of a medium for transmitting energy rays.

The integral light intensity during energy ray irradiation is preferably from 500 to 5000 mJ/cm$^2$, and more preferably from 800 to 2500 mJ/cm$^2$. Two or more energy ray sources having different light emission wavelength regions may be selected.

By performing the energy ray irradiation step in a state in which the pressure is released after pressing the second layered body II to the target object 20, it becomes possible to increase the film thickness of the first mask layer 13. A mask having a high aspect ratio can therefore be transferred to the target object 20 by undergoing the etching step described hereinafter.

(Release step)

As shown in FIGS. 5B and 5C, in the release step, the cover film 10 in the second layered body II bonded to the target object 20 in the third layered body III is removed. As a result, the intermediate body 21 comprising the target object 20, the first mask layer 13, and the second mask layer 12 is obtained.

During transfer of the mask pattern onto the target object 20 by the second layered body II, when the residual film thickness of the first mask layer 13 is small, stress during peeling is apparently concentrated at a residual film part,

and peeling of the second mask layer 12 from the first mask layer 13 and other release defects sometimes occur. Such release defects can be addressed by optimizing the composition of the second mask layer 12 and the first mask layer 13, as well as by the release method, and any of the procedures (5) through (8) described below or a hybrid procedure thereof, for example, is preferably employed.

(5) A procedure is cited which uses a difference in coefficient of thermal expansion. By using a difference in coefficient of thermal expansion between the first mask layer 13 and the concavo-convex structure 11 of the second layered body II, stress applied during release can be reduced. The environmental atmosphere that produces a difference in coefficient of thermal expansion varies according to the material of the concavo-convex structure 11 and the composition of the first mask layer 13, and is therefore not particularly limited, but mold releasing in a state of cooling by cooling water, a refrigerant, liquid nitrogen, or the like, or mold releasing in a state of heating to a temperature of about from 40°C to 200°C is cited as an example. Heat peeling in particular is effective when a fluorine component is present on the surface of the concavo-convex structure 11.
FIG. 8 is a schematic sectional view relating to release of the fine-pattern-forming film pertaining to the present embodiment and the first mask layer transferred onto the target object. In FIGS. 8A through 8C, since the first layered body I and the second layered body II are represented as the same schematic view for the sake of convenience, the unevenness of the surface of the concavo-convex structure 11 of the first layered body I is omitted, and a flat shape is shown. In the first layered body I shown in FIGS. 8A through 8C, the concavo-convex structure 11 is formed the side thereof that is laminated with the target object 20. In FIGS. 8A through 8C, the first mask layer 13 and second mask layer 12 transferred to the surface of the target object 20 are provided, but these layers are omitted from FIGS. 8A through 8C, and a flat shape is shown.
(6) A method is cited in which peeling is initiated from one edge part of the second layered body II, peeling proceeds toward the other-edge part thereof, and the surface area of contact with the target object 20 is gradually reduced, as shown in FIG. 8A. In this case, since force on the interface of the second mask layer 12 and the first mask layer 13 is reduced relative to a case of a parallel flat-plate-type mold releasing, release properties are enhanced.
(7) A procedure is cited in which the central vicinity of the second layered body II is deformed into a downward-convex shape, mold releasing of the second layered body II from the target object 20 is initiated in this state, and the degree of deformation is gradually increased as shown in FIG. 8B. In this case, since force on the interface of the second mask layer 12 and the first mask layer 13 is reduced relative to a case of a parallel flat-plate-type mold releasing, release properties are enhanced.
(8) A procedure is cited in which the second layered body II is bent, and the second layered body II is released from the target object 20 starting at one edge part of the second layered body II and proceeding toward the other-edge part thereof, as shown in FIG. 8C. In this case, since force on the interface of the second mask layer 12 and the first mask layer 13 is reduced relative to a case of a parallel flat-plate-type mold releasing, release properties are enhanced. This method is effective particularly when the cover film of the second layered body II is a flexible mold. By bending the second layered body II using a roll provided with the elastic body 50 on the surface thereof and releasing the second layered body II from the target object 20 starting at one edge part of the second layered body II and proceeding toward the other-edge part thereof, the second layered body II can be continuously released from the target object 20 in roll-to-roll processing.

As described above, by the mask pattern transfer step pertaining to the present embodiment, a concavo-convex structure is transferred to the target object 20 using the second layered body II, and the fine mask structure body 16 to which the first mask layer 13 and the second mask layer 12 are provided is obtained on the surface of the target object 20, as shown in FIG. 5D. At this time, a first mask layer 13 having a large thickness can be formed on the target object 20, and by undergoing the etching step described hereinafter, a mask pattern having a high aspect ratio can be formed on the target object 20. The relationship between the second mask layer 12 and first mask layer 13 and the target object in the fine mask structure body 16 will be described in detail hereinafter.
Furthermore, a heating step is preferably added between the energy ray irradiation step and the release step in the mask pattern transfer step. Specifically, the mask pattern transfer step may be configured so that the pressing step, the energy ray irradiation step, the heating step, and the release step are undergone in this order.

(Heating step)

By adding the heating step after energy ray irradiation, depending on the composition of the second mask layer 12 and the first mask layer 13, effects are obtained whereby the stability of the second mask layer 12 and first mask layer 13 is enhanced, and transfer defects during the release step, particularly cohesive failure of the first mask layer 13, are reduced. The heating temperature is generally in the range of from 40°C to 200°C, and a temperature lower than the glass transition temperature Tg of the second mask layer 12 and the first mask layer 13 is preferred. The preferred

heating time is generally from five seconds to 60 minutes, and from the perspective of enhancing transfer accuracy and increasing industrial properties, a heating time of from five seconds to three minutes is most preferred. The heating step may be performed in a low-oxygen atmosphere.

After the heating step, the layered body comprising the cover film 10, the second mask layer12, the first mask layer 13, and the target object 20 is preferably moved to the release step after being cooled preferably to a temperature of from 5°C to 80°C, more preferably from 18°C to 30°C. The cooling method is not particularly limited insofar as the layered body is cooled to within the aforementioned temperature range.

Furthermore, a post-treatment step may be added after the release step in the mask pattern transfer step. Specifically, the mask pattern transfer step may be configured so that the pressing step, the energy ray irradiation step, the release step, and the post-treatment step are undergone in this order, or may be configured so that the pressing step, the energy ray irradiation step, the heating step, the release step, and the post-treatment step are undergone in this order.

(Post-treatment step)

The post-treatment step is performed by irradiating energy rays from both or any one of the second mask layer 12 side and the target object 20 side of the fine mask structure body 16 shown in FIG. 5D. The post-treatment step is also performed by subjecting the fine mask structure body 16 to any one or both of heating and energy ray irradiation.

Energy ray irradiation makes it possible to promote reaction of unreacted components included in any one or both of the second mask layer 12 and the first mask layer 13, and is preferred because the stability of the second mask layer 12 and the first mask layer 13 is thereby enhanced, and the residual film removing step for the second mask layer 12, the etching step for the first mask layer 13, and the etching step for the target object 20 can be satisfactorily performed. The energy rays may be X-rays, UV rays, IR rays, or the like. The energy rays are preferably irradiated to the fine mask structure body 16 from the second mask layer 12 side and/or the target object 20 side. Irradiation from the second mask layer 12 side is particularly preferred.

<Etching step>

The intermediate body 21 is a layered body comprising the second mask layer 12, the first mask layer 13, and the target object 20 that is manufactured by laminating the second layered body II to the target object 20 and then peeling the cover film 10 therefrom, and the details of the method for manufacturing the intermediate body 21 are as previously described in the mask pattern transfer step. Here, the fine mask structure body 16 can be manufactured by etching the intermediate body 21 as shown in FIG. 5D. The fine pattern 22 can be furthermore formed on the target object 20 and the concavo-convex structure body 40 obtained by etching the fine mask structure body 16 as shown in FIGS. 5E and 5F.

The method of processing the intermediate body 21 into the fine mask structure body 16 comprises etching the first mask layer 13 using the second mask layer 12 as a mask. A fine mask structure body 16 provided with a fine mask pattern 16a comprised of the first mask layer 13 and the second mask layer 12 and having a high aspect ratio is thereby obtained.

In the etching conditions, $O_2$ gas and $H_2$ gas may be selected from the perspective of etching the first mask layer 13 in chemically reactive fashion, for example. From the perspective of enhancing the vertically directed etching rate by increasing ion-injecting components, Ar gas and Xe gas may be selected. A gas mixture including at least one of $O_2$ gas, $H_2$ gas, and Ar gas is used as the gas used for etching. The use of $O_2$ gas alone is particularly preferred. The pressure during etching is preferably from 0.1 to 5 Pa, more preferably from 0.1 to 1 Pa, because such a pressure makes it possible to increase the ion incident energy contributing to reactive etching, and to further enhance etching anisotropy. Anisotropy is enhanced when the ratio of the gas mixture of $O_2$ gas or $H_2$ gas and Ar gas or Xe gas is such that the chemically reactive etching component and the ion incident component are present in optimal amounts. Therefore, when the total flow of the gas is 100 sccm, the ratio of gas flow is preferably from 99 sccm:1 sccm to 50 sccm:50 sccm, more preferably from 95 sccm:5 sccm to 60 sccm:40 sccm, and more preferably from 90 sccm:10 sccm to 70 sccm:30 sccm. When the total flow is changed, the gas mixture is according to the flow ratios described above. The etching is preferably plasma etching. For example, the etching is performed using capacitively coupled RIE, inductively coupled RIE, or RIE using a biased ion attraction. For example, an etching method may be used in which $O_2$ gas alone or a gas in which $O_2$ gas and Ar are mixed in a flow ratio of between 90 sccm:10 sccm and 70 sccm:30 sccm is used, the processing pressure is set in the range of from 0.1 to 1 Pa, and capacitively coupled RIE or RIE using an ion attraction voltage is used, or another method may be used. When the total flow of the gas is changed, the gas mixture is according to the flow ratio described above.

Reactive ion etching, for example, is furthermore performed on the target object 20 using the patterned first mask layer 13 as a mask, and a fine pattern 22 is formed on a principal face of the target object 20, as shown in FIG. 5E. Lastly, as shown in FIG. 5F, the first mask layer 13 remaining on the principal face of the target object 20 is removed,

and a target object 20 having the fine pattern 22, i.e., the concavo-convex structure body 40, is obtained.

Here, the reactive ion etching can be designed, as appropriate, in accordance with the type of the target object 20, but etching using a chlorine-based gas is cited as an example thereof. The chlorine gas used may be $BCl_3$ gas alone or a gas mixture of $BCl_3$ gas and $Cl_2$ gas. Ar gas or Xe gas may be further added to these gases. In order to enhance the etching rate, a gas flow ratio in the gas mixture of from 99 sccm:1 sccm to 50 sccm:50 sccm is preferred, from 99 sccm:1 sccm to 70 sccm:30 sccm is more preferred, and from 99 sccm:1 sccm to 90 sccm:10 sccm is more preferred. The etching is preferably plasma etching. For example, the etching is performed using capacitively coupled RIE, inductively coupled RIE, or RIE using a biased ion attraction. For example, an etching method may be used in which $CHF_3$ gas alone or a gas in which $CF_4$ and $C_4F_8$ are mixed in a flow ratio of between 90 sccm:10 sccm and 60 sccm:40 sccm is used, the processing pressure is set in the range of from 0.1 to 5 Pa, and capacitively coupled RIE or RIE using an ion attraction voltage is used, or another method may be used. When a chlorine-based gas, for example, is used, an etching method may be used in which $BCl_3$ gas alone or a gas in which $BCl_3$ and $Cl_2$ or Ar are mixed in a flow ratio of between 95 sccm:5 sccm and 85 sccm:15 sccm is used, the processing pressure is set in the range of from 0.1 to 10 Pa, and capacitively coupled RIE, inductively coupled RIE, or RIE using an ion attraction voltage is used, or another method may be used. Furthermore, when a chlorine-based gas, for example, is used, an etching method may be used in which $BCl_3$ gas alone or a gas in which $BCl_3$ gas and $Cl_2$ gas or Ar gas are mixed in a flow ratio of between 95 sccm:5 sccm and 70 sccm:30 sccm is used, the processing pressure is set in the range of from 0.1 to 10 Pa, and capacitively coupled RIE, inductively coupled RIE, or RIE using an ion attraction voltage is used, or another method may be used.

<Intermediate body>

In order to manufacture the fine pattern 22 with high accuracy, an etching step must be undergone in which the accuracy of the second mask layer 12 and first mask layer 13 of the fine mask structure body 16 is reflected. Specifically, a fine mask structure body 16 having high accuracy is necessary. A fine mask structure body 16 having high accuracy can be manufactured by etching that reflects the accuracy of the second mask layer 12 and first mask layer 13 of the intermediate body 21. Here, the accuracy of the second mask layer 12 and first mask layer 13 of the intermediate body 21 is guaranteed by the accuracy of the concavo-convex structure 11 of the cover film 10 of the second layered body II, the placement precision of the second mask layer 12, and the film thickness accuracy of the first mask layer 13. Specifically, defects in the etching step performed on the intermediate body 21 must be reduced in order to manufacture a fine pattern 22 having high accuracy.

The accuracy of the etching step is determined by the placement relationship of the second mask layer 12 and the first mask layer 13 and by the composition of the second mask layer 12 and the first mask layer 13 described hereinafter, but when foreign substances is present on the surface of the second mask layer 12 during the etching step, these mechanisms for guaranteeing accuracy break down. Specifically, instances of foreign substances on the surface of the intermediate body 21 (surface of the second mask layer 12) during the etching step must be reduced.

Such foreign substances can occur during the etching step and in the process of conveying the intermediate body 21 to the etching step. Here, the portion of the expected value for the occurrence of foreign substances due to conveyance of the intermediate body 21 is confirmed to be high. In particular, it has been learned that foreign substances scattered and adhering from the environmental atmosphere is significantly reduced by taking such measures as controlling the degree of environmental cleanliness or removing static electricity. However, it has not been possible to bring the occurrence of foreign substances all the way to zero solely by these measures.

Upon investigating the causes of foreign substances, it was confirmed that foreign substances occurs from end parts of the intermediate body 21. Specifically, it was learned that when the intermediate body 21 is conveyed in a case in which the second mask layer 12 and the first mask layer 13 are transferred and imparted to the entire face of the target object 20 including the end parts thereof, the second mask layer 12 and first mask layer 13 positioned at an outer edge part of the intermediate body 21 are partially broken, and the broken second mask layer 12 and first mask layer 13 are scattered and adhere on the face of the second mask layer 12 of the intermediate body 21, thereby being identified as foreign substances.

From the perspective of the above phenomenon, a more preferred state of the intermediate body 21 is one in which a portion of at least the outer edge part of the target object includes an exposed area. Specifically, when a line segment AB is drawn from one point A of the outer edge part of the target object 20 to another point B of the outer edge part, this state is one in which at least the point A is provided to the target object 20, and a point C positioned on the second mask layer 12 is provided along the line segment AB in the direction from the point A to the point B. In other words, the target object 20 has an exposed area in which the first mask layer 13 and the second mask layer 12 are not present in a portion of the outer edge part, and the surface thereof is exposed, and the second mask layer 12 and first mask layer 13 are disposed toward the inside of the target object relative to the exposed area. By this configuration, it is possible to suppress foreign substances comprising the second mask layer 12 and the first mask layer 13 that occurs from the end parts of the fine mask structure body 16 during conveyance of the fine mask structure body 16, and the

accuracy of the fine pattern 22 can therefore be enhanced. From the same perspective, the average length of the exposed area provided to the outer edge part of the target object is preferably 1 μm or greater, and more preferably 3 μm or greater. The average length is obtained by a 10-point measurement of the exposed area, and is calculated as a 10-point arithmetic mean value. The upper-limit value is determined from the size of the target object 20 and a yield or recovery rate computed from an application of the target object 20 to which the fine pattern 22 is provided, and is therefore not particularly limited, but in general, the upper-limit value is preferably 8 mm or less, more preferably 5 mm or less, and most preferably 1 mm or less. By adopting a configuration in which the target object 20 has an exposed area in which the first mask layer 13 and the second mask layer 12 are not present in a portion of the outer edge part, and the surface thereof is exposed, only the first mask layer 13 is disposed toward the inside of the target object 20 relative to the exposed area, and the second mask layer 12 and first mask layer 13 are disposed further toward the inside, it is possible to more effectively suppress breakage of the second mask layer 12 and the first mask layer 13 during conveyance of the intermediate body 21. Most preferably, a configuration is included in which the target object 20 (A) has an exposed area in which the first mask layer 13 and the second mask layer 12 are not present in a portion of the outer edge part, and the surface thereof is exposed, (B) only the first mask layer 13 is disposed toward the inside of the target object 20 relative to the exposed area, and (C) the second mask layer 12 and first mask layer 13 are disposed further toward the inside, and the film thickness of the first mask layer 13 of (B) increases from the outer edge part side of the target object 20 toward the second mask layer 12 and first mask layer 13 of (C).

The effect of the average length of the exposed area provided to the outer edge part of the target object was studied using the thermal nanoimprinting apparatus 600 pertaining to the third embodiment described hereinafter. First, the first layered body I was prepared, and a photocurable resin was deposited on a sapphire substrate having a diameter of four inches as a target object by a spin coating method. A first layered body I was then laminated using the thermal nanoimprinting apparatus pertaining to the third embodiment. UV light was then irradiated thereto, and the cover film of the first layered body I was peeled off. The intermediate body obtained by the present manufacturing method is referred to as the intermediate body (1). Meanwhile, a second layered body II was prepared and laminated to a sapphire substrate having a diameter of four inches as a target object using the thermal nanoimprinting apparatus 600, UV light was then irradiated, and the cover film was lastly peeled off. The intermediate body obtained by the present manufacturing method is referred to as the intermediate body (2). The average length of the exposed area provided to the outer edge part of the target object in the intermediate body (1) and the intermediate body (2) was measured, and was 500 nm or less in the intermediate body (1) and 1.2 μm in the intermediate body (2). Observation was performed by joint use of an optical microscope and a laser microscope. The reason for this is that in the case of the intermediate body (1), since the first layered body I is used, i.e., the liquid second mask layer is used, the second mask layer flows satisfactorily to the end parts of the target object 20. The intermediate body (1) having an average length of the exposed area of 500 nm or less and the intermediate body (2) having an average length of the exposed area of 1.2 μm were conveyed to a dry-etching apparatus and attached to the inside of the dry-etching apparatus, and were then extracted without processing. The number of particles occurring on the extracted intermediate body (1) and intermediate body (2) was counted, and the intermediate body (1) had five times the number particles of the intermediate body (2). It is apparent from the above description that the occurrence of particles can be suppressed by making the average length of the exposed area provided to the outer edge part of the target object exceeded zero. The average length is preferably 1 μm or greater. Dry etching was furthermore performed twice for the abovementioned intermediate body (1) and intermediate body (2), and the target object 20 was processed. Dry etching was performed first by plasma etching using oxygen gas under conditions of a pressure of 1 Pa and a power of 300 W. The first mask layer 13 was thereby fabricated using the second mask layer 12 as an etching mask, and a fine mask structure body 16 was obtained. Reactive ion etching (ICP-RIE) using a reactive ion etching apparatus (RIE-101ipH, manufactured by SAMCO Inc.) was then performed using a gas mixture of $BCl_3$ gas and chlorine gas. The following conditions were used: ICP: 150 W, BIAS: 50 W, pressure: 0.2 Pa. The target object 20 was thereby processed using the first mask layer 13 as an etching mask, and a fine pattern 22 was formed on the target object 20, i.e., a concavo-convex structure body 40 was obtained. The concavo-convex structure body 40 was observed by optical microscopy, and the macro defect rate of the fine pattern 22 was measured. The defect rate was calculated as an average value from producing and observing five each of the intermediate body (1) and the intermediate body (2). When the intermediate body (1) was used, 29.6 defect points were observed per four inches of diameter, but when the intermediate body (2) was used, only 6.1 defect points were observed per four inches of diameter. It is thus apparent that the occurrence of particles can be suppressed by making the average length of the exposed area provided to the outer edge part of the target object 20 exceeded zero, and that the defect rate of the concavo-convex structure body 40 can thereby be significantly reduced.

Another study was conducted using the second layered body II. Silicone rubber having a glass transition temperature (Tg) of 20°C or lower was selected as the surface material of a rotating body 102, the pressure during laminating was changed to 0.01 MPa, 0.03 MPa, 0.05 MPa, and 0.1 MPa, and intermediate bodies (3) were produced. Within the studied range of pressures, the average length of the exposed area provided to the outer edge part of a sapphire substrate having a diameter of four inches as the target object increased as the pressure during laminating

increased during production of the intermediate bodies (3). This phenomenon is assumed to be caused by the effects of residual stress in the first mask layer 13 due to thermal expansion and laminating pressure, due to the temperature during laminating having been set to 105°C. Specifically, the average lengths of the exposed areas provided to the outer edge parts of the target objects 20 were, in order by the laminating pressure, 1.5 $\mu$m, 1.7 $\mu$m, 2.0 $\mu$m, and 3.2 $\mu$m. The obtained intermediate bodies (3) were conveyed to a dry etching apparatus and attached to the inside of the dry-etching apparatus, and were then extracted without processing. The number of particles occurring on the extracted intermediate bodies (3) was counted, and, using the number of particles on the previously described intermediate body (1) as a reference, the number of particles was 1/6, 1/7.5, 1/9, and 1/13. In each intermediate body (3) obtained by the study described above, the exposed area provided to the outer edge part of the target object 20 was not provided to the entire outer edge part of the target object 20, but was provided to approximately half to 2/3 the circumference of the outer edge part of the target object 20. The exposed area was also scanned and observed by atomic force microscopy from the outer edge part of the target object 20 toward the second mask layer, showing a configuration in which (A) an exposed area is present, (B) followed by the first mask layer 13, and (C) lastly the second mask layer 12 is provided. Furthermore, the film thickness of the first mask layer 13 (B) gradually increased from the exposed area toward the inside of the target object 20, and the film thickness was saturated at the stage where the second mask layer 12 was provided. Dry etching was performed twice in the same manner as for the intermediate body (1) and the intermediate body (2), a concavo-convex structure body 40 was produced, and the macro defect rate of the fine pattern 22 was measured from optical microscope observation. The number of defects was calculated as the average value thereof for five produced intermediate bodies (3). It was confirmed that the number of defects per four inches of diameter decreased, being 5.2, 4.0, 2.9, and 1.9 defect points, as the average length of the exposed area increased.

The study described above is of a case in which a sapphire substrate having a diameter of four inches was used as the target object, but the trend in the effect of the exposed area of the target object on particles was observed to be the same when a sapphire substrate having a diameter of two inches or a sapphire substrate having a diameter of six inches was used.

The abovementioned intermediate body 21 can be manufactured by the previously described method for using the second layered body II and the thermal nanoimprinting apparatus pertaining to the present embodiment described below. It is particularly preferable to satisfy the line width described hereinafter of the laminating part of the thermal nanoimprinting apparatus pertaining to the present embodiment, because the controllability of the exposed area of the target object 20 is thereby enhanced. As described above, this line width can easily be realized by satisfying the glass transition temperature Tg of the elastic body in the laminating part.

Furthermore, in order to manufacture the above-described intermediate body 21 with higher controllability, in the second layered body II after the intermediate body 21 has been manufactured, there is preferably a difference (A - B) of at least five degrees between the contact angle A of a water droplet with respect to the location used for manufacturing the intermediate body 21, i.e., with respect to the portion in which the second mask layer 12 and the first mask layer 13 have been removed, and the contact angle B of a water droplet with respect to the face of the first mask layer 13 of the second layered body II. In this case, since a shearing force can be applied from the concavo-convex structure 11 of the cover film 10 toward the interface of the first mask layer 13 and the target object 20, the controllability of the exposed area of the target object 20 of the intermediate body 21 increases. From the same effect, the difference (A - B) of the contact angles is preferably 10 degrees or greater, more preferably 30 degrees or greater, and most preferably 60 degrees or greater.

<Thermal nanoimprinting apparatus>

The thermal nanoimprinting apparatus pertaining to the present embodiment will next be described. The details of the fine-pattern-forming film will be described hereinafter.

The thermal nanoimprinting apparatus pertaining to the present embodiment is used in thermal nanoimprinting. Thermal nanoimprinting is a transfer method in which a mold having a concavo-convex structure formed on a surface thereof, particularly a mold provided with a nanoscale concavo-convex structure, is laminated and pressed to a target object while heat is applied, whereby the concavo-convex structure is transferred to a surface of the target object (also referred to as the processed face).

The thermal nanoimprinting apparatus pertaining to the present embodiment is characterized by being provided with a laminating part for laminating a fine-pattern-forming film and a target object in a state in which a surface of a nanoscale first mask layer of the fine-pattern-forming film is facing one surface of the target object, the laminating part including a pressing part for applying a pressing force to the fine-pattern-forming film or the target object essentially in a line, the pressing part being provided with a rotating body for contacting the fine-pattern-forming film or the target object essentially in a line, and at least a surface layer of the rotating body being comprised of an elastic body having a glass transition temperature Tg of 100°C or lower.

By this configuration, since the rotating body provided to the pressing part contacts the fine-pattern-forming

film or the target object essentially in a line and applies a pressing force along a line rather than a face, the pressing force can be small. Since the rotating body presses on the fine-pattern-forming film or the target object while rotating, flow of the first mask layer due to the pressing can be promoted and entrapment of outside air can be suppressed. Transfer accuracy is therefore enhanced. Furthermore, since at least a surface layer of the rotating body is comprised of an elastic body having a glass transition temperature of 100°C or lower, the temperature used in thermal nanoimprinting can be reduced and the uniformity of the pressing force can be enhanced. As a result, highly precise thermal nanoimprinting can be performed at low temperature and low pressure, and the size of the target object can easily be increased while keeping the apparatus from becoming excessively large.

In the thermal nanoimprinting apparatus pertaining to the present embodiment, the rotating body is preferably a laminating roller having a substantially true-circular cross-section.

In the thermal nanoimprinting apparatus pertaining to the present embodiment, a peeling part is preferably further provided for releasing the cover film from the fine-pattern-forming film and the target object laminated by the laminating part and obtaining the target object, to a surface of which the first mask layer and the second mask layer have been transferred.

The thermal nanoimprinting apparatus pertaining to the present embodiment will next be described using the fine-pattern-forming film I shown in FIG. 1, citing examples of cases in which a flat-plate-shaped inorganic substrate, a sapphire substrate, a silicon substrate, a nitride semiconductor substrate, or a silicon carbide substrate is used as the target object.

(Laminating part)

First, in the laminating part of the thermal nanoimprinting apparatus, the fine-pattern-forming film and the target object are laminated together in a state in which the surface of the fine-pattern-forming film on which the first mask layer is formed (also referred to hereinafter as the first mask layer face) is facing the process face of the target object. This laminating part is provided with a pressing part for applying a pressing force to the fine-pattern-forming film and the target object essentially in a line, the pressing part being provided with a rotating body for contacting the fine-pattern-forming film or the target object essentially in a line.

(Pressing part)

The rotating body provided to the pressing part can be arranged so as to come in contact with the face of the fine-pattern-forming film to which the target object is laminated, i.e., the face of the fine-pattern-forming film on the opposite side of the first mask layer face. The rotating body may also be arranged so as to come in contact with the face of the target object to which the fine-pattern-forming film is laminated, i.e., the face of the target object on the opposite side thereof of the processed face.

The rotating body provided to the pressing part applies a pressing force to the fine-pattern-forming film while rotating, and therefore continuously contacts the target object from one edge part to the other-edge part thereof, and the fine-pattern-forming film can be pressed to the target object. As a result, the fine-pattern-forming film can be laminated to, i.e., thermal-nanoimprinted to, the target object.

(Rotating body)

The pressing part pertaining to the present embodiment will next be described in further detail. At least the surface layer of the rotating body provided to the pressing part is comprised of an elastic body having a glass transition temperature (also referred to as Tg hereinafter) of 100°C or lower, i.e., a low-Tg elastic body. By such a configuration, the temperature necessary for thermal nanoimprinting can be reduced, the pressure can be reduced, and the apparatus can be kept from becoming excessively large. In the pressing part, the rotating body is preferably a laminating roller having a substantially true-circular cross-section. Through use of a laminating roller having a substantially true-circular cross-section, since there are essentially no angled parts on the outer periphery of the laminating roller, the uniformity of elastic deformation of the low-Tg elastic body can be enhanced, thereby enhancing the uniformity of the temperature necessary for thermal nanoimprinting, and pressure can be uniformly applied. The abovementioned effects can therefore be effectively realized.

The glass transition temperature Tg of the elastic body is preferably 60°C or lower, more preferably 30°C or lower. Because the degree of elastic deformation is increased by a Tg of 60°C or lower, pressing essentially in a line becomes effective, and thermal nanoimprinting can be performed with high accuracy at lower temperatures and pressures. Furthermore, a glass transition temperature of 30 °C or lower is preferred because the line width described after the description of the laminating part is easily satisfied, and a better heat distribution and pressing force distribution can be obtained in thermal nanoimprinting. In particular, by having a Tg of 0°C or lower, extreme stress concentration on

the first mask layer can be suppressed, and adhesion at the interface of the first mask layer and the second mask layer can therefore be increased. Not only are laminating properties therefore enhanced, but transfer properties accompanying peeling are also significantly enhanced. From the same perspective, the Tg is most preferably -20°C or lower.

Examples of a low-Tg elastic body that satisfies such a Tg include silicone rubber, nitrile rubber, fluororubber, polyisoprene (natural rubber), polybutadiene, polyvinyl acetate, polyethylene, polypropylene, nylon 6, nylon 66, polyethylene terephthalate, polyvinyl chloride, polyvinylidene chloride, polytetrafluoroethylene, polyvinylidene fluoride, polymethyl methacrylate, and polystyrene.

Here, at least the surface layer of the rotating body being comprised of a low-Tg elastic body such as described above encompasses the two cases described below. FIG. 9 is a schematic sectional view showing an example of the rotating body pertaining to the present embodiment. One of the abovementioned cases is a case in which an outermost layer of the rotating body is comprised of a low-Tg elastic body. In the rotating body 30 shown in FIG. 9A, the outermost layer 32 provided to an outer periphery of a core part 31 comprising a non-elastic body is comprised of a low-Tg elastic body. In the rotating body 33 shown in FIG. 9B, a surface layer 35 provided to an outer periphery of a core part 34 comprising a non-elastic body is comprised of a low-Tg elastic body, and an outermost layer 36 provided to an outer periphery of the surface layer 35 is comprised of a low-elastic body. In this case, the surface layer 35 is comprised of the abovementioned low-Tg elastic body, and has a thickness greater than that of the non-elastic body constituting the outermost layer. The term "low-elastic body" refers to an elastic body having a higher Tg than the elastic body in the present specification, and for which the absolute value of the Tg is more than 30°C.

In particular, the outermost layer 32 of the rotating body 30 is preferably comprised of the low-Tg elastic body, as shown in FIG. 9A. In this case, the configuration of layers inside relative to the outermost layer 32 is not limited, and the core part 31 or a layer comprised of another elastic body, a metal, a metal oxide, or the like may be disposed inside relative to the outermost layer 32.

An antistatic treatment, an adhesion-preventing treatment, or other treatment may also be performed on the surface of the outermost layer 32 of the rotating body 30 shown in FIG. 9A.

By configuring at least the surface layer of the rotating bodies 30, 33 from a low-Tg elastic body, the temperature used in thermal nanoimprinting can be reduced, and the uniformity of the pressing force can be enhanced. Specifically, thermal nanoimprinting can be performed with high accuracy at low temperature and low pressure. Furthermore, the size of the target object can easily be increased while keeping the apparatus from becoming excessively large.

In particular, pressing essentially in a line, i.e., along a line width, as described in detail hereinafter is possible at low temperature and low pressure. Therefore, since the uniformity of heat with respect to the second mask layer is enhanced, and extreme stress concentration in laminating can be suppressed, high accuracy can be maintained in the interface of the second mask layer and the first mask layer. Transfer properties are thereby enhanced during peeling of the cover film from the layered body (third layered body III) comprising the fine-pattern-forming film and the target object. Thermal nanoimprinting can thereby be performed with high accuracy at low temperature and low pressure. Furthermore, the size of the target object can easily be increased while keeping the apparatus from becoming excessively large.

At least the surface layer of the rotating body is comprised of a low-Tg elastic body, and elastic deformation can be produced therein. By this elastic deformation, the pressing force can be reduced. Since fluidity of an interface layer between the fine-pattern-forming film and the target object can be promoted even when thermal nanoimprinting is performed at a low temperature, transfer accuracy is enhanced, and there is no need for an excessive pressurizing means, an excessively large heating means, or an excessively large cooling means.

The rotating body may also be a rotating body in which a cylindrical roll is attached to the periphery of a rotating shaft. The rotating shaft itself may also be heating means, as described hereinafter. The rotating body may also be a rotating body in which heating means is disposed on the periphery of a rotating shaft, and a cylindrical roll is attached to the periphery of a heating mechanism.

The material of the low-Tg elastic body used in the rotating body in the present embodiment is not particularly limited insofar as the Tg thereof is 100°C or lower, and a publicly known, commercially available rubber, resin, or the like, for example may be used, and examples thereof include silicone rubber, nitrile rubber, fluororubber, polyisoprene (natural rubber), polybutadiene, polyvinyl acetate, polyethylene, polypropylene, nylon 6, nylon 66, polyethylene terephthalate, polyvinyl chloride, polyvinylidene chloride, polytetrafluoroethylene, polyvinylidene fluoride, polymethyl methacrylate, and polystyrene. When the Young's modulus (longitudinal elastic modulus) thereof is equal to or more than 1 Mpa but equal to or less than 100 Mpa, since elastic deformation of the rotating body can easily be induced while suppressing deformation of the interface of the first mask layer and the second mask layer, the abovementioned effect of thermal nanoimprinting at low temperature and low pressure is increased. From the same perspective, the Young's modulus is more preferably equal to or more than 4 Mpa but equal to or less than 50 Mpa. For the sake of the same effect, the thickness of the low-Tg elastic body is preferably equal to or more than 0.1 mm but equal to or less than 10 cm, more preferably equal to or more than 0.5 mm but equal to or less than 8 cm, and most preferably equal to or more than 3 mm but equal to or less than 1 cm.

The pressing part provided with a rotating body such as described above may be provided with a rotating means

for bringing the fine-pattern-forming film into contact with the target object while rotating the rotating body, and a pressurizing means for pushing the rotating body against the fine-pattern-forming film and the target object. By these means, a pressing force can be applied essentially in a line rather than a face when the fine-pattern-forming film is pressed to the target object.

(Rotating means)

The rotating means of the pressing part will next be described. The laminating part provided with the pressing part laminates and presses together the fine-pattern-forming film and the target object. Laminating of the fine-pattern-forming film and the target object in the laminating part may be performed at the same time that the fine-pattern-forming film is conveyed, or may be performed in a state in which conveyance of the fine-pattern-forming film is stopped.

When laminating is performed at the same time that the fine-pattern-forming film is conveyed, the rotating means provided to the pressing means is preferably configured so as to cause the rotating body to passively rotate in synchrony with the conveyance of the fine-pattern-forming film, since the accuracy of thermal nanoimprinting is thereby enhanced. In this case, the rotating means employed may be one that causes the rotating body to passively rotate in conjunction with the conveyance of the fine-pattern-forming film, such as a free roller, or that causes the rotating body to passively rotate while controlling the rotation speed thereof so as to synchronize with the conveyance speed of the fine-pattern-forming film.

Meanwhile, in the case of laminating the fine-pattern-forming film and the target object in a state in which conveyance of the fine-pattern-forming film is stopped, the rotating body preferably rotates about the rotating shaft and moves in the direction of flow of the fine-pattern-forming film or in the direction opposite thereto in a plane parallel to a principal face of the target object. FIG. 10 is a view showing the pressing part in the thermal nanoimprinting apparatus pertaining to the present embodiment. In this case, as shown in FIG. 10, the distance (X) between the process face position (St) of the target object 20 and a plane (Sl) passing through a point (A) of the rotating body 30 closest to the process face position (St) and parallel to the principal face of the target object 20 is preferably equal to - (minus) the thickness (T) of the fine-pattern-forming film or greater, preferably 0 $\mu$m or greater, because the laminating precision is thereby enhanced, and the accuracy of thermal nanoimprinting at low temperature and low pressure using elastic deformation is enhanced. The distance X is preferably 0 $\mu$m or greater, more preferably 5 $\mu$m or greater, and most preferably 10 $\mu$m or greater. Meanwhile, the upper limit for the distance X is the thickness of the target object 20. The arrow in FIG. 10 indicates the direction of movement of the rotating body 30. In the abovementioned distance (X), using the process face position (St) as a reference plane, the direction facing away from the position (St) in the target object 20 from the process face position (St) is positive (+). Specifically, the negative (minus) direction of the distance X is the direction away from the target object in the thickness direction of the target object 20 when the process face position (St) is used as a reference. In other words, when the distance X is negative (minus), in a state in which the fine-pattern-forming film is not being fed, the rotating body 30 and the target object 20 are not in contact with each other when the rotating body 30 is moved in a plane parallel to the process face (St).

(Pressurizing means)

The pressurizing means of the pressing part will next be described. By a configuration in which the distance (X) is - (minus) the thickness (T)of the fine-pattern-forming film I or greater, as described above, a pressure (first pressure hereinafter) determined by the distance X and the material of surface layer of the rotating body can be applied, and there is therefore no need to provide a special pressurizing means. However, even in this case, the pressurizing means described hereinafter is preferably provided in order to even further enhance the uniformity of the pressing force.

A pressurizing means for pushing the rotating body toward the fine-pattern-forming film or the target object may be provided to the pressing part. The pressure (referred to as the second pressure hereinafter) applied to the fine-pattern-forming film and the target object by the pressurizing means is dispersed by the elastic deformation of the rotating body, and is made uniform. Since the uniformity of heat and uniformity of pressure are therefore enhanced, the uniformity of force and heat at the interface of the fine-pattern-forming film and the target object are enhanced. Uniformity of pressure can be enhanced as described above particularly when a pressurizing means is provided. The absolute value of the pressure can therefore be reduced. The accuracy of the interface of the first mask layer and the second mask layer can thereby be suitably maintained, and it is therefore possible to enhance the transfer accuracy and processing accuracy of the target object when the cover film is peeled off and the intermediate body 21 shown in FIG. 5C is obtained. Air (air voids) that permeates between the fine-pattern-forming film and the target object can also be reduced without compromising cycle time. The pressing force by the pressing part, which is the combination of the first pressure and the second pressure, is preferably from 0.01 Mpa to 5 Mpa, and more preferably from 0.03 MPa to 2 Mpa.

(Linear pressing)

The mechanism whereby the pressing force is applied essentially in a line during pressing of the fine-pattern-forming film to the target object by the pressing part such as described above will next be described.

FIG. 11 is a schematic perspective view showing the pressing part provided to the laminating part pertaining to the thermal nanoimprinting apparatus pertaining to the present embodiment. In the pressing part 100 shown in FIG. 11, a rotating body 102 extends along a transverse direction TD, i.e., the width direction of a fine-pattern-forming film 101, perpendicular to the conveying direction (machine direction) MD of the fine-pattern-forming film 101. In other words, the longitudinal direction 103 of the rotating body 102 is parallel or essentially parallel to the width direction of the fine-pattern-forming film 101, i.e., to the transverse direction TD. As a result, a peripheral face of the rotating body 102 contacts the fine-pattern-forming film 101 essentially in a line. Specifically, a pressing force can be applied essentially in a line. This line is a line AB connecting an intersection point A of a perpendicular line Z-a passing through the center O of one end face of the rotating body 102 with the peripheral face of the rotating body 102, and an intersection point B of a perpendicular line Z-b passing through the center O of the other end face of the rotating body 102 with the peripheral face of the rotating body 102, and has a line width described hereinafter. This line is referred to essentially as a line. Pressure is therefore applied by the rotating body 102 in a line rather than a face when the fine-pattern-forming film 101 and a target object 104 are laminated.

In the pressing part 100 shown in FIG. 11, the rotating body 102 is a laminating roller having a substantially true-circular cross-section, and may be cylindrical or columnar.

The "line width" will next be described with reference to FIG. 12. FIG. 12 is a schematic side view showing the pressing part in the thermal nanoimprinting apparatus pertaining to the present embodiment. When the elastically deformed rotating body 102 is viewed transversely, a portion of the substantially true-circular end face is flattened. This flat-deformed portion continues along the longitudinal direction of the rotating body 102, forming a face. The flat-deformed portion is seen as a bottom side. The length of the flat-deformed portion, i.e., the line width, is represented by $2d \sin(\Theta/2)$, where $\Theta$ is the angle formed by two line segments connecting the ends of the bottom side and the center O of the circle, and d is the radius of the circle. The angle $\Theta$ for laminating the fine-pattern-forming film 101 and the target object 104 with high laminating precision and performing thermal nanoimprinting with high accuracy realizing the effects described above is preferably equal to or more than 1° but equal to or less than 60°. Therefore, the linear pressing in the present specification includes a case in which the line width is such that the angle $\Theta$ is 60° or less. In other words, cases are included not only of applying a pressure along a mathematical line, but also of applying a pressure in a line having a width that satisfies the abovementioned conditions. In the present embodiment, the definition of "applying pressure essentially in a line," includes cases in which pressure is applied in a line, as well as cases in which pressure is applied in a constant line width as described above. From the perspective of more significantly demonstrating the abovementioned effects, the angle $\Theta$ is preferably equal to or more than 3 degrees but equal to or less than 45 degrees, and more preferably equal to or more than 5 degrees but equal to or less than 30 degrees.

In the thermal nanoimprinting apparatus pertaining to the present embodiment, the fine-pattern-forming film and the target object are pressed by the rotating body described above, and thermal nanoimprinting can be performed at low temperature and low pressure. Here, a target object holding part is preferably provided on a face of the target object on the opposite side thereof of the processed face in order to suppress vibration of the target object in the direction perpendicular to the in-plane direction thereof and to enhance the uniformity of the pressure during pressing.

The target object holding part is not particularly limited insofar as the target object holding part does not touch the process face of the target object. In particular, the height (gap) of a region protruding toward the fine-pattern-forming film relative to the process face position of the target object is preferably one fifth or less of the thickness of the target object, because the laminating precision is thereby enhanced. A state in which there is no protruding region is most preferred. A vacuum chuck, for example, is preferred because the face of the target object on the opposite side thereof of the process face can be held by contact with a chuck face, and the target object can be freely withdrawn by releasing the vacuum. From the perspective of entrapment of bubbles during laminating, the target object holding part preferably holds the target object in a position in which the target object and the fine-pattern-forming film do not come in contact.

The target object is fixed and held by the target object holding part, and the first mask layer of the fine-pattern-forming film is laminated by the pressing part described above to the process face of the fixed and held target object. Here, the precision in the target object surface of laminating of the fine-pattern-forming film can be further enhanced by undergoing a laminating process described hereinafter. First, the face of the target object on the opposite side thereof of the processed face is fixed by the target object holding part. Vacuum fixing, for example, may be employed. Laminating of the fine-pattern-forming film is then initiated from one edge part of the target object by the rotating body of the pressing part. Laminating of the fine-pattern-forming film in an amount commensurate with the pressing is then performed toward the other-edge part of the target object while the rotating body rotates. Here, fixing of the target object is released before the rotating body finishes passing the other-edge part of the target object. When retention by the target object holding part is by a vacuum chuck, for example, the vacuum is released. In this state, the rotating body of the pressing part

passes the other-edge part of the target object while rotating. The fine-pattern-forming film can thereby be laminated throughout the plane that includes the end parts of the target object.

(Press heating part)

A press heating part preferably accompanies the rotating body and/or the target object holding part in the thermal nanoimprinting apparatus pertaining to the present embodiment. Here, a press heating part is introduced for the purpose of heating the interface of the fine-pattern-forming film and the target object during laminating and pressing of the fine-pattern-forming film and the target object by the pressing part. By providing a press heating part, the temperature of the interface of the fine-pattern-forming film and the target object is enhanced, thereby promoting fluidity of the first mask layer and enhancing the thermal nanoimprinting precision.

A press heating part accompanies the rotating body and/or the target object holding part. A press heating part may therefore accompany both the rotating body and the target object holding part. When the press heating part is added to the target object holding part, the target object holding part can fix the target object as well as heat the target object.

When a press heating part accompanies the rotating body, the press heating part is preferably disposed further inside than the low-Tg elastic body provided to the surface layer of the rotating body. Specifically, the rotating body may be comprised of the rotating shaft, the press heating part, and the low-Tg elastic body. Here, the press heating part and the rotating shaft may be the same, or a heat-conductive adhesive or the like may be disposed between the press heating part and the low-Tg elastic body, for example. FIG. 13 is a schematic sectional view showing the rotating body accompanied by the press heating part in the thermal nanoimprinting apparatus pertaining to the present embodiment. In the rotating body 41 shown in FIG. 13A, a low-Tg elastic body 43 is provided to an outer periphery of a press heating part 42. In the rotating body 44 shown in FIG. 13B, a press heating part 46 is provided to an outer periphery of a rotating shaft 45, and a low-Tg elastic body 47 is furthermore provided to an outer periphery of the press heating part 46.

In either of these cases, the low-Tg elastic body 43, 47 provided to the surface layer of the rotating body 41, 44 can be heated by the press heating part 42, 46. By this heating, since the temperature of the surface of the low-Tg elastic body 43, 47 is raised, the flexibility of the fine-pattern-forming film 101, particularly the fluidity of the first mask layer, is enhanced, and pressing precision is enhanced during pressing of the fine-pattern-forming film 101 to the target object 104. Here, since the heat distribution during laminating of the fine-pattern-forming film 101 and the target object 104 by the low-Tg elastic body 43, 47 is improved, the heating temperature of the press heating part 42, 46 can be kept low.

The heating temperature of the press heating part is preferably set so that the surface of the rotating body 102 can be heated to a temperature in the range of equal to or more than 0°C but equal to or less than 250°C, more preferably heated to a temperature of equal to or more than 40°C equal to or less than 150°C, and most preferably heated to a temperature of equal to or more than 60°C but equal to or less than 130°C. Particularly in the thermal nanoimprinting method using the thermal nanoimprinting apparatus pertaining to the present embodiment, the temperature (Ts) of the surface of the rotating body is preferably in a range less than the melting point (Tmc) of the cover film of the fine-pattern-forming film 101. Since it is possible to satisfactorily utilize the elastic deformation of the low-Tg elastic body having the Tg described above even when such a rotating body having a temperature (Ts) less than the melting point (Tmc) of the cover film of the fine-pattern-forming film 101 is used, the thermal nanoimprinting precision can be enhanced. Specifically, there is no need for an excessively large heating means. A compact apparatus having no need for an excessively large cooling means is thus obtained. In particular, from the perspective of suppressing excess deformation of the fine-pattern-forming film 101 and enhancing thermal nanoimprinting precision during pressing of the fine-pattern-forming film 101 to the target object 104, the heating temperature is preferably set so that the surface of the rotating body can be heated to a temperature (Ts) in the range of 0.9 Tmc or lower, more preferably heated to a temperature of 0.6 Tmc or lower, and most preferably heated to a temperature of 0.5 Tmc or lower. When the material of the cover film and the material of the concavo-convex structure are different, the lower of the melting point for the material of the cover film and the melting point for the material of the concavo-convex structure is the abovementioned melting point (Tmc).

The thermal nanoimprinting apparatus pertaining to the present embodiment will next be described in further detail.

<First Embodiment>

FIG. 14 is a schematic view showing the thermal nanoimprinting apparatus pertaining to a first embodiment. The thermal nanoimprinting apparatus 200 is provided with a feeding roller 202 on which a long fine-pattern-forming film 101 is wound. The feeding roller 202 sends out the fine-pattern-forming film 101 at a predetermined speed. A take-up roller 203 paired with the feeding roller 202 is provided for winding the sent fine-pattern-forming film 101. The rotation speed of the take-up roller 203 and the rotation speed of the feeding roller 202 may be controlled so that the delivery speed and the take-up speed of the fine-pattern-forming film 101 are synchronized, but a dancer roller, a torque motor,

a tension controller, or the like can be used to control the tension of the fine-pattern-forming film 101. The mechanism for conveying the fine-pattern-forming film 101 may therefore be designed, as appropriate, in accordance with the tension control scheme employed. A drive part may be connected to each of the feeding roller 202 and the take-up roller 203.

A laminating part 201 is provided downstream from the feeding roller 202 in the conveying (machine) direction MD. The laminating part 201 is provided with the pressing part 100 provided with the rotating body 102. The rotating body 102 is as previously described. In the first embodiment, the surface layer of the rotating body 102 was comprised of silicone rubber. Silicone rubber having a glass transition temperature Tg of 20°C or lower was employed. A static eliminator (not shown) for eliminating static electricity from the laminating atmosphere was separately provided.

The rotating body 102 is laterally installed in the width direction of the fine-pattern-forming film 101. The rotating body 102 has a substantially true-circular cross-sectional shape. The length of the rotating body 102 in the width direction of the fine-pattern-forming film 101 is not particularly limited insofar as this length is greater than the size of the target object 104 to which the fine-pattern-forming film 101 is laminated. This length is just over two inches, just over four inches, just over six inches, or just over eight inches, for example. In a preferred configuration, a plurality of target objects 104 are arranged in the width direction of the fine-pattern-forming film 101, and the rotating body 102 is provided so as to span the entire width of the fine-pattern-forming film 101 in order to laminate the fine-pattern-forming film 101 to the target objects 104 simultaneously. In the first embodiment, three widths, being 2.1 inches, 4.5 inches, and 6.5 inches, were used as the width of the fine-pattern-forming film 101. The length of the rotating body 102 in the width direction thereof was 300 mm for each of these fine-pattern-forming films 101.

Laminating of the fine-pattern-forming film 101 and the target object 104 by the rotating body 102 may be performed at the same time that the fine-pattern-forming film 101 is conveyed, or may be performed in a state in which conveyance of the fine-pattern-forming film 101 is stopped. In the first embodiment, laminating was performed with the fine-pattern-forming film 101 in a stationary state.

When pressing of the fine-pattern-forming film 101 to the target object 104 is performed at the same time that the fine-pattern-forming film 101 is conveyed, the rotating body 102 preferably rotates without impeding conveyance of the fine-pattern-forming film 101. The rotating means of the rotating body 102 therefore may be configured so as to cause the rotating body 102 to passively rotate in conjunction with conveyance of the fine-pattern-forming film 101, or may be configured so as to actively rotate the rotating body 102. In particular, causing the rotating body 102 to passively rotate in conjunction with conveyance of the fine-pattern-forming film 101 enhances the laminating precision, and is therefore preferred. In this case, a rotating means for the rotating body 102 for causing the rotating body 102 to passively rotate in the manner of a free roller may be employed, or a rotating means may be employed for causing the rotating body 102 to passively rotate while controlling the rotation speed thereof so as to synchronize with the conveyance speed of the fine-pattern-forming film 101.

Meanwhile, when the fine-pattern-forming film 101 and the target object 104 are laminated in a state in which conveyance of the fine-pattern-forming film 101 is stopped, the rotating body 102 preferably rotates around the rotating shaft and moves in the direction opposite the conveying direction MD of the fine-pattern-forming film 101 or in a direction parallel to the conveying direction MD of the fine-pattern-forming film 101 in a plane parallel to the principal face of the target object 104.

In this case, laminating precision can be enhanced by satisfying the previously described range for the distance (X). In the first embodiment, laminating was performed using ranges of minus 30 $\mu$m, minus 20 $\mu$m, minus 10 $\mu$m, 0 $\mu$m, 10 $\mu$m, 30 $\mu$m, and 100 $\mu$m for the distance (X). A thickness of 104 $\mu$m was used as the thickness of the fine-pattern-forming film 101, which is the distance from the exposed face of the cover film to the surface of the first mask layer.

Furthermore, regarding the pressing force during pressing of the fine-pattern-forming film 101 and the target object 104 by the rotating body 102, pressure can be applied without specially providing a pressurizing means when the distance X is equal to or greater than minus the thickness of the fine-pattern-forming film 101. However, separately providing a pressurizing means 204 is preferred from the perspective of uniformly applying the pressing force. By providing the pressurizing means 204, air (air voids) that permeates between the fine-pattern-forming film 101 and a target object 104 can be reduced without compromising cycle time, and from this perspective, a pressurizing means is preferably provided to the rotating body 102. The pressing force for this laminating is preferably from 0.01 MPa to 5 MPa, more preferably from 0.03 MPa to 2 Mpa.

In the laminating part 201 of the thermal nanoimprinting apparatus 200 pertaining to the first embodiment, the fine-pattern-forming film 101 and the target object 104 are pressed by the rotating body 102 of the pressing part 100 described above, and thermal nanoimprinting can be performed at low temperature and low pressure. Here, a target object holding part 205 is preferably provided on a face of the target object 104 on the opposite side thereof of the face thereof adjacent to the fine-pattern-forming film 101 in order to suppress vibration of the target object 104 in the direction perpendicular to the in-plane direction thereof and to enhance the uniformity of the pressure during pressing of the fine-pattern-forming film 101 to the target object 104.

The holding mechanism of the target object holding part 205 is not particularly limited insofar as the target object holding part 205 does not touch the process face of the target object 104. The previously described mechanism

may be employed in the target object holding part 205. The method for holding the target object 104 is preferably on in which the target object 104 is held in a position in which the target object 104 and the fine-pattern-forming film 101 do not come in contact, as described above. A decompression (suction) chuck was employed in the first embodiment.

The abovementioned press heating part preferably accompanies the rotating body 102 and/or the target object holding part 205 in the thermal nanoimprinting apparatus 200 pertaining to the first embodiment. Here, a press heating part is introduced for the purpose of heating the interface of the fine-pattern-forming film 101 and the target object 104 during pressing of the fine-pattern-forming film 101 and the target object 104 by the rotating body 102. By providing a press heating part, the temperature of the interface of the fine-pattern-forming film 101 and the target object 104 is enhanced, and the thermal nanoimprinting precision is therefore enhanced. In the first embodiment, a press heating part was provided to both the rotating body 102 and the target object holding part 205, the surface of the rotating body 102 was heated to from 90°C to 130°C, and heating was performed with the surface of the target object holding part 205 in a temperature range of from 80°C to 150°C.

A peeling part 206 is provided downstream from the laminating part 201 in the conveying direction MD and previous to the take-up roller 203. A gap sufficient for jointly providing the energy-ray irradiation part or the like described hereinafter is preferably provided between the take-up roller 203 and the rotating body 102. The peeling part 206 is not particularly limited insofar as the cover film can thereby be peeled from a layered body 207 comprising the fine-pattern-forming film 101 and the target object 104. Specifically, in the layered body 207, the target object 104 is fixed and there is virtually no movement thereof in the direction perpendicular to the principal face thereof, and the cover film is pulled away from the target object 104. In particular, when the peeling part 206 is capable of utilizing the flow of the fine-pattern-forming film 101 to perform peeling, twisting of the fine-pattern-forming film 101 can be further suppressed, and transfer accuracy can be enhanced. Furthermore, since pressing of the fine-pattern-forming film 101 with one target object 104 (A) and peeling of the fine-pattern-forming film 101 from another target object 104 (B) can be performed simultaneously, cycle time can be enhanced while keeping the apparatus from becoming excessively large. Furthermore, in the peeling part 206, the cover film is preferably peeled by a change in the conveying direction of the fine-pattern-forming film 101, and a peeling roller or peeling edge such as described hereinafter may be utilized.

The layered body 207 corresponds to the third layered body III shown in FIGS. 3B and 5A. The target object 104 constituting the layered body 207 is laminated to and integrated with the fine-pattern-forming film 101.

The peeling force in the peeling part 206 includes at least a component perpendicular to the process face of the target object 104 and in the conveying direction MD of the fine-pattern-forming film 101. For example, by holding and fixing the exposed face of the target object 104 of the layered body 207 and changing the conveying direction MD of the fine-pattern-forming film 101 by a roller or an edge, the cover film can be peeled with high transfer accuracy.

(Peeling part)

FIG. 15 is a schematic view showing peeling of the cover film by the peeling part in the thermal nanoimprinting apparatus pertaining to the first embodiment. FIGS. 15A and 15B show cases in which the layered body 207 comprising the fine-pattern-forming film 101/target object 104 is conveyed, and the cover film is peeled from the target object 104 by a change in the conveying direction MD of the fine-pattern-forming film 101. The target object 104 moves in the direction indicated by the arrow A in the drawings.

In FIG. 15A, the conveying direction MD of the fine-pattern-forming film 101 is changed by a peeling edge 301 having a curvature radius of exceeded zero. Meanwhile, in FIG. 15B, the conveying direction MD of the fine-pattern-forming film 101 is changed by a cylindrical peeling roller 302. In both cases, the face (also referred to as the exposed face hereinafter) of the target object 104 on the opposite side thereof of the process face is preferably held by holding means and the target object 104 is fixed, because the physical stability of the target object 104 during peeling of the cover film of the fine-pattern-forming film 101 is thereby enhanced.

FIG. 16 is a schematic view showing peeling of the fine-pattern-forming film by the peeling part in the thermal nanoimprinting apparatus pertaining to the first embodiment. In FIGS. 16A and 16B, a case is shown in which the layered body 207 is stationary, and a peeling part 206 comprising a movement roll 401 and a peeling roll 402 moves in a direction parallel to the process face of the target object 104 and parallel to the conveying direction MD of the fine-pattern-forming film 101, whereby the cover film is peeled. More specifically, the movement roll 401 moves in the direction opposite to the conveying direction MD of the fine-pattern-forming film 101, as indicated by the arrow B in the drawings. In conjunction with this movement, the peeling roll 402 also moves in the direction opposite to the conveying direction MD of the fine-pattern-forming film 101, and the cover film is peeled.

The change in direction of the fine-pattern-forming film 101 in the peeling part 206 will be described in further detail. FIG. 17 is an explanatory diagram for explaining the change in direction of the fine-pattern-forming film 101 at the peeling part in the thermal nanoimprinting apparatus pertaining to the first embodiment. As shown in FIG. 17, the angle $\theta 1$ formed by the plane of the conveying direction MD-1 of the fine-pattern-forming film 101 before passing the peeling part 206 and the plane of the conveying direction MD-2 of the fine-pattern-forming film 101 (cover film) after

passing the peeling part 206 can be defined as the amount of change in the peeling direction. This angle $\theta 1$ is the peeling angle. The peeling angle $\theta 1$ is preferably 15 degrees to 170 degrees. Since a peeling angle of 15 or greater makes it possible to decrease the peeling stress applied to the interface of the first mask layer and the cover film, the load (peeling stress) on the intermediate body 21 obtained by thermal nanoimprinting is reduced, and transfer accuracy is therefore enhanced. Meanwhile, since a peeling angle of 170 degrees or less reduces the load placed on conveyance of the fine-pattern-forming film 101, conveyance precision is enhanced. For the same reasons, the peeling angle $\theta 1$ is more preferably equal to or more than 30 degrees but equal to or less than 160 degrees, and most preferably equal to or more than 60 degrees but equal to or less than 160 degrees. A peeling angle $\theta 1$ of 90 degrees or greater makes it possible to keep the apparatus from becoming excessively large. From the perspective of designing a more compact apparatus, the peeling angle $\theta 1$ is preferably 100 degrees or greater, more preferably 110 degrees or greater, and most preferably 125 degrees or greater. The plane of the conveying direction MD-1 of the fine-pattern-forming film 101 before passing the peeling part 206 is substantially parallel to the process face of the target object 104 before peeling of the fine-pattern-forming film 101.

Here, by further providing holding means capable of detachably fixing the exposed face of the target object 104, the physical balance of the target object 104 during peeling by the peeling part 206 is improved, and twisting of the fine-pattern-forming film 101 or deficiency of the concavo-convex structure obtained by thermal nanoimprinting can be better suppressed. The holding means is a vacuum chuck, an electrostatic chuck, a means for grasping an external peripheral edge part, or a cassette-support-type means well-known to a person skilled in the art, for example. In the first embodiment, a decompression (suction) chuck is employed, and a static eliminator (not shown) is attached to a peripheral side of the peeling part 206 for the purpose of suppressing static electricity.

By the pressing part 100 provided with the rotating body 102 described above, the fine-pattern-forming film 101 and the target object 104 are pressed, and the layered body 207 comprising the fine-pattern-forming film 101/target object 104 is obtained. The peeling part 206 and the laminating part 201 provided with the pressing part 100 are disposed apart from each other in the conveying direction MD of the fine-pattern-forming film 101. Specifically, the layered body 207 is conveyed to the peeling part 206, and the cover film of the fine-pattern-forming film 101 is peeled from the layered body 207 in the peeling part 206. Here, conveyance of the layered body 207 can be performed also by separately providing a target object conveyance means for holding and conveying the exposed face of the target object 104 of the layered body 207, but from the perspective of keeping the apparatus from becoming excessively large, the fine-pattern-forming film 101 is preferably conveyed through use of the flow thereof, i.e., the fine-pattern-forming film 101 is preferably caused to function as a carrier film for the target object 104.

In general, a work piece (target object 104) and a carrier (fine-pattern-forming film 101) are moved and conveyed by separate movement mechanisms, but for the present embodiment, the work piece can be moved by the conveyance of the carrier. Specifically, a state may be undergone in which the work piece and the carrier are integrated with each other. Since there is thereby no need to separately provide a conveyance mechanism for the work piece, the apparatus can have a compact design, and an optional constituent element, e.g., an energy-ray irradiation part, can easily be incorporated between the laminating part 201 and the peeling part 206.

Specifically, in FIG. 14, the target object 104 is disposed on the face of the fine-pattern-forming film 101 on the opposite side thereof of the side where the rotating body 102 is provided; i.e., the target object 104 is disposed on the first mask layer face. The target object 104 also moves in conjunction with conveyance of the fine-pattern-forming film 101. When the fine-pattern-forming film 101 is conveyed in a state in which the front and back thereof are inverted (so that the first mask layer face is downward), the rotating body 102 is disposed on the top side of the fine-pattern-forming film 101, the target object 104 is disposed on the bottom side of the fine-pattern-forming film 101, i.e., on the first mask layer face, and the fine-pattern-forming film 101 and the target object 104 are pressed. In this case, the fine-pattern-forming film 101 and the target object 104 may move in conjunction with the conveyance of the fine-pattern-forming film 101 in a state of suspension.

When a protective layer is provided on a surface of the fine-pattern-forming film 101, the protective layer must be removed before the fine-pattern-forming film 101 and the target object 104 are laminated by the laminating part 201. In this case, a protective-layer peeling roller part for peeling the protective layer (indicated by reference numeral 14 in FIG. 4) from the fine-pattern-forming film 101 is provided downstream from the feeding roller 202 in the conveying direction MD of the fine-pattern-forming film 101. A protective layer take-up roller for winding and recovering the protective film is jointly provided to the protective-layer peeling roller downstream from the protective-layer peeling roller in the conveying direction of the protective layer. The protective-layer peeling roller may be provided as a free roller not equipped with a drive part, or may be a roller not accompanied by a drive part, and is not particularly limited insofar as the protective-layer peeling roller is capable of peeling the protective layer from the fine-pattern-forming film 101. Meanwhile, the protective layer take-up roller serves to wind and recover the protective layer peeled from the fine-pattern-forming film 101, and is therefore preferably accompanied by a drive part. The protective layer take-up roller rotated by a drive part may be designed, as appropriate, to rotate at a rotation speed so that twisting of the protective layer, twisting and meandering of the fine-pattern-forming film 101, or the like is suppressed. The protective-layer peeling roller is preferably

provided in a position near the rotating body 102, because adhesion of foreign substances to the exposed surface from which the protective layer has been peeled is thereby suppressed, and as a result, the laminating precision of the fine-pattern-forming film 101 and the target object 104 is enhanced.

During laminating of the fine-pattern-forming film to the target object 104 in the laminating part 201 described above, a static eliminator may be provided from the perspective of further enhancing the accuracy of laminating of the fine-pattern-forming film 101 to the target object 104. By providing a static eliminator, since adhesion of particles to the first mask layer face of the fine-pattern-forming film 101 or the process face of the target object 104 can be suppressed, stress concentration due to particles on the first mask layer can be suppressed, and transfer accuracy can thereby be enhanced.

The optional constituent element provided between the laminating part 201 and the peeling part 206 will next be described.

(Energy-ray irradiation part)

An energy-ray irradiation part may be provided between the laminating part 201 and the peeling part 206. In the energy-ray irradiation part, energy rays are irradiated to the layered body 207 obtained by the laminating part 201. The energy-ray irradiation part may therefore irradiate energy toward the fine-pattern-forming film 101, irradiate energy toward the target object 104, or both. Irradiating energy at least toward the target object 104 is particularly preferred, because the strength of the interface of the fine-pattern-forming film 101 and the target object 104 can thereby be enhanced.

The energy-ray irradiation part may irradiate energy rays to a region having a length of at least 50% of the film width of the fine-pattern-forming film 101 with respect to the width direction of the fine-pattern-forming film 101, and to a region of a portion thereof in the conveying direction. In particular, the energy-ray irradiation part is preferably capable of irradiating energy rays to a region having a length of at least 75% of the film width of the fine-pattern-forming film 101 with respect to the width direction of the fine-pattern-forming film 101, because productivity is thereby enhanced, and environmental responsibility is enhanced. The abovementioned percentage is more preferably 85% or greater. From the perspective of environmental responsibility and keeping equipment from becoming too large, the abovementioned percentage is preferably 150% or less, and more preferably 110% or less.

Here, when the length of the fine-pattern-forming film 101 in the width direction thereof is designated as W, the length of the target object in the width direction is designated as w, and the irradiated length of the energy-ray irradiation part in the width direction is designated as We, it is assumed that $w/W < 1$, and from the perspective of environmental responsibility and keeping equipment from becoming too large, the relationship of these lengths is preferably $w/W < We/W \leq 1.5$, more preferably $w/W < We/W \leq 1.1$.

The energy rays can be selected, as appropriate, on the basis of the material constituting the fine-pattern-forming film 101, and are therefore not particularly limited, but a UV-LED light source, a metal halide light source, a high-pressure mercury lamp light source, or the like may be employed. The integral light intensity from the start of energy ray irradiation to the end of irradiation is preferably from 500 $mJ/cm^2$ to 5000 $mJ/cm^2$, because the transfer accuracy in thermal nanoimprinting is thereby enhanced. This integral light intensity is more preferably from 800 $mJ/cm^2$ to 2500 $mJ/cm^2$. In the case of the continuous laminating described hereinafter, a plurality of energy ray irradiation mechanisms may be provided in the conveying direction of the fine-pattern-forming film 101. In this case, the energy ray sources of all of the energy ray irradiation mechanisms may be the same, or energy ray irradiation mechanisms having different energy ray spectrums may be provided. In the case of the intermittent laminating described hereinafter, the energy ray irradiation range is preferably 100% or more of the target object, and when the illuminance distribution within the energy ray irradiation range is taken into account, the energy ray irradiation range is more preferably 150% or more.

(Layered-body heating part)

A layered-body heating part for heating the layered body 207 may be provided upstream from the peeling part 206 in the conveying direction MD of the fine-pattern-forming film 101 and subsequent to energy ray irradiation part in the conveying direction MD. By providing a layered-body heating part, the strength of the interface of the fine-pattern-forming film 101 and the target object 104 can be enhanced, and the thermal nanoimprinting precision is therefore enhanced. The temperature of heating by the layered-body heating part can be selected, as appropriate, in accordance with the characteristics of the fine-pattern-forming film 101, and is therefore not particularly limited, but a heating temperature less than the melting point (Tmc) of the fine-pattern-forming film 101 is preferred, because the apparatus can thereby be kept from becoming excessively large, and the thermal nanoimprinting precision is enhanced. A heating temperature of the target object 104 that enables heating to a temperature range of from 30°C to 200°C is preferred, and a temperature range of from 60°C to 130°C is more preferred. From the perspective of conveyance of the fine-pattern-forming film 101, the heating temperature is preferably no more than about 0.6 times the Tmc. The layered body

207 is thus heated under heating conditions.

(Cooling part)

A cooling part for cooling the layered body 207 may be provided upstream from the peeling part 206 in the conveying direction MD of the fine-pattern-forming film 101 and subsequent to the layered-body heating part in the conveying direction MD. By providing a cooling part, the peeling properties during peeling of the cover film can be enhanced. In the thermal nanoimprinting apparatus 200 pertaining to the first embodiment, the cooling part is provided so as to be separated from the laminating part 201 in the conveying direction MD of the fine-pattern-forming film 101. Furthermore, since a rotating body 102 such as described above is employed in the first embodiment, the temperature necessary for thermal nanoimprinting is kept low. The cooling part can therefore be kept from becoming excessively large. The cooling part may merely blow air onto the layered body 207. The cooling part preferably cools the target object 104 to a temperature of 120°C or below, since peeling properties are thereby enhanced. The optimum temperature of the target object 104 after cooling is determined in accordance with the characteristics of the fine-pattern-forming film 101, but is generally preferably equal to or more than 5°C but equal to or less than 60°C, more preferably equal to or more than 18°C but equal to or less than 30°C.

Other optional constituent elements provided upstream from the laminating part 201 in the conveying direction MD will next be described.

(Conveyance part)

A conveyance part may be provided upstream from the laminating part 201 in the conveying direction MD. Here, the conveyance part extracts a stored target object 104 and conveys the target object 104 to the position of the rotating body 102 of the laminating part 201. The conveyance part may also be caused to function as the target object holding part for the target object 104 during laminating. Here, the target object 104 is preferably fixed in the conveyance part by holding means capable of detachably fixing the exposed face of the target object 104. The holding means is a vacuum chuck, an electrostatic chuck, a means for grasping an external peripheral edge part, or a cassette-support-type means well-known to a person skilled in the art, for example.

(Preprocessing part)

A preprocessing part may be provided upstream from the conveyance part in the conveying direction MD. In the preprocessing part, the principal face of the target object, i.e., the process face, can be preprocessed. Examples of the preprocessing part may include a UV-$O_3$ processing mechanism, an excimer processing mechanism, an oxygen ashing mechanism, a silane coupling material film deposition mechanism, and a resin layer deposition mechanism. Equipment can be kept from becoming too large particularly by employing a UV-$O_3$ processing mechanism or an excimer processing mechanism.

Optional constituent elements provided downstream from the peeling part in the conveying direction MD will next be described.

(Collection part)

A collection part may be provided downstream from the peeling part in the conveying direction MD. The collection part recovers the target object 104 from which the fine-pattern-forming film 101 has been peeled on the peeling part. This collection part conveys the target object 104 from which the fine-pattern-forming film 101 has been peeled to an apparatus for the next processing or to a temporary storage apparatus while holding the target object 104 from which the fine-pattern-forming film 101 has been peeled. Retention of the target object 104 by the collection part may be realized by holding an external peripheral edge part of the target object 104 or supporting the face of the target object 104 on the opposite side thereof of the face to which the fine-pattern-forming film 101 is laminated, i.e., supporting the exposed face of the target object 104. A cassette support system well known to a person skilled in the art may be employed as the collection part.

(Energy-ray irradiation part, heating part, and cooling part)

An energy-ray irradiation part may be provided downstream from the peeling part 206 and previous to the collection part in the conveying direction MD of the fine-pattern-forming film 101. By the energy-ray irradiation part, energy rays are irradiated to the target object 104, i.e., to a product corresponding to the fine mask structure body 16 shown in FIG. 5C, from which the fine-pattern-forming film 101 has been peeled and to the surface of which the concavo-convex structure has been transferred. The target object 104 can thereby be stabilized, and the fitness or storage stability in the next processing is enhanced. The same effects can be obtained also by providing a heating part instead of an energy-ray irradiation part. When a heating part is provided, a cooling part may be provided downstream from the heating part and previous to the collection part in the conveying direction MD of the fine-pattern-forming film 101. The energy-ray irradiation part, the heating part, and the cooling part may also be provided in this order downstream from the peeling part and previous to the collection part in the conveying direction MD of the fine-pattern-forming film 101.

In the first embodiment described above, a roller having a mirror finish on the surface thereof was used as the roller for directly contacting the surface of the first mask layer of the fine-pattern-forming film 101.

<Second Embodiment>

FIG. 18 is a schematic view showing the thermal nanoimprinting apparatus pertaining to a second embodiment. In the description below, constituent members that are the same as those described in the first embodiment are referred to by the same reference numerals, and no description thereof will be given.

The thermal nanoimprinting apparatus 300 pertaining to the second embodiment differs from the first embodiment in that a cutting part 501 is provided.

(Cutting part)

As shown in FIG. 18, a cutting part 501 is provided downstream from the laminating part 201 and previous to the take-up roller 203 in the conveying direction MD. A gap sufficient for jointly providing an energy-ray irradiation part or other optional constituent element is preferably provided between the rotating body 102 and the cutting part 501, or between the take-up roller 203 and the cutting part 501.

The cutting part 501 completely or partially cuts the fine-pattern-forming film 101 positioned outside the external periphery of the target object 104 from the target object 104 to which the fine-pattern-forming film 101 has been laminated, i.e., from the layered body 207. FIG. 19 is a schematic plan view showing the position of cutting by the cutting part in the thermal nanoimprinting apparatus pertaining to the second embodiment. As shown in FIG. 19, the cutting part 501 cuts outside of the external periphery of the target object 104 with respect to the layered body 207 comprising the fine-pattern-forming film 101/target object 104. A cutting position 502 is indicated by a dot-dashed line in FIG. 19.

Here, the cutting may be complete cutting out of the fine-pattern-forming film 101 at the cutting position 502 set outside of the target object 104 so that the fine-pattern-forming film 101 and the layered body 207 are completely separated. The fine-pattern-forming film 101 may also be partially cut at the cutting position 502 so that the fine-pattern-forming film 101 and the layered body 207 do not separate. For example, cutting may be performed so that a fine-pattern-forming film 101a outside of the cutting position 502 shown in FIG. 19 and a fine-pattern-forming film 101b constituting the layered body 207 inside of the cutting position 502 are partially joined together. A method for cutting in perforated fashion, or a method whereby the fine-pattern-forming film 101a outside of the cutting position 502 and the fine-pattern-forming film 101b inside of the cutting position 502 remain joined together at one or more locations, and the remainder is cut, for example.

From the perspective of the conveyance precision of the fine-pattern-forming film 101 after cutting, the cutting width (l) in the width direction of the fine-pattern-forming film 101 and the width (W) of the fine-pattern-forming film 101 shown in FIG. 19 preferably satisfy the relationship $l < W$, more preferably $l \leq 0.99W$, and most preferably $l \leq 0.95W$.

In FIG. 19, the cut shape by the cutting part 501 is schematically depicted as being circular, but the cut shape may be n-polygonal ($n \geq 3$) or n-polygonal ($n \geq 3$) having rounded corners. A case in which n increases without limit is circular. Particularly from the perspective of cutting properties and the conveyance precision of the fine-pattern-forming film 101 after passing the cutting part 501, the cut shape is preferably line-symmetrical about a line parallel to the conveying direction MD of the fine-pattern-forming film 101.

The cutting part 501 is comprised of at least a cutting blade part 501a for severing the fine-pattern-forming film 101, and a support part 501b for supporting the layered body 207. The cutting blade part 501a is positioned above the target object 104 of the layered body 207, and moves in a direction (vertical direction) perpendicular to the conveying direction MD of the fine-pattern-forming film 101. The support part 501b supports the layered body 207 from below the fine-pattern-forming film 101, and in particular, suppresses vibration of the layered body 207 in the direction perpendicular to the conveying direction MD of the fine-pattern-forming film 101. The cutting blade part 501a moves toward the layered body 207 supported by the support part 501b, and cutting is performed.

The layered body 207 obtained through the laminating part 201 is conveyed to the cutting part 501 and cutting is performed. Here, when the fine-pattern-forming film 101 is completely cut at the cutting position 502 by the cutting part 501, since the fine-pattern-forming film 101a outside of the cutting position 502 and the fine-pattern-forming film 101b constituting the cut layered body 207 are not joined together, the layered body 207 must be conveyed by a separately provided conveyance part (not shown).

Meanwhile, in the case of partial cutting at the cutting position 502 by the cutting part 501, the fine-pattern-forming film 101a outside of the cutting position 502 and the fine-pattern-forming film 101b constituting the cut layered body 207 are partially joined together. This portion where the fine-pattern-forming film 101a and the fine-pattern-forming film 101b are joined together is referred to as a connected part. Since this connected part remains, the layered body 207 also moves in conjunction with conveyance of the cut fine-pattern-forming film 101a. In the second embodiment, when a connected part was provided, the width of the connected part was set to 2 mm or less, and two types of connected parts were implemented, one having four points and one having two points.

Here, conveyance of the layered body 207 between the laminating part 201 and the cutting part 501 may also be realized by separately providing holding means for fixing the target object of the layered body 207. However, from the perspective of keeping the apparatus from becoming excessively large, the flow of the fine-pattern-forming film 101 is preferably utilized for conveyance; i.e., the fine-pattern-forming film 101 is preferably caused to function as a carrier for the target object, as described in the first embodiment.

An energy ray irradiation part, a layered-body heating part, and a cooling part may be incorporated between the laminating part 201 and the cutting part 501 in the thermal nanoimprinting apparatus 300 pertaining to the second embodiment, the same as in the first embodiment. A conveyance part and a preprocessing part may also be incorporated upstream from the laminating part 201 in the conveying direction MD.

(Separation part)

Furthermore, in the thermal nanoimprinting apparatus 300 pertaining to the second embodiment, a separation part may be provided instead of the peeling part 206 of the first embodiment.

When the fine-pattern-forming film 101 of the layered body 207 is partially cut at the cutting position 502 by the cutting part 501, since the connected part is present between the fine-pattern-forming film 101a from which the layered body 207 has been cut and the fine-pattern-forming film 101b of the layered body 207, and the fine-pattern-forming film 101a and fine-pattern-forming film 101b are partially joined together, the layered body 207 moves in conjunction with conveyance of the fine-pattern-forming film 101. Specifically, as shown in FIG. 18, by providing a separation part 503 downstream from the cutting part 501 in the conveying direction MD of the fine-pattern-forming film 101, the fine-pattern-forming film 101a and the layered body 207 can be separated.

The separation part 503 is not particularly limited insofar as the fine-pattern-forming film 101a and the layered body 207 can be separated thereby. Specifically, in the separation part 503, the layered body 207 is substantially fixed from moving in the transverse Direction , and the layered body 207 is separated from the fine-pattern-forming film 101a. Particularly when the separation part 503 is capable of utilizing the flow of the conveyed fine-pattern-forming film 101a to perform separation, twisting of the fine-pattern-forming film 101a is better suppressed, and concentrated stress at the interface of the target object 104 and the fine-pattern-forming film 101b of the layered body 207 can be suppressed. Furthermore, since pressing of the fine-pattern-forming film 101 with one target object 104 (A) in the laminating part 201 and separation of the fine-pattern-forming film 101 from another target object 104 (B) in the separation part 503 can be performed simultaneously, cycle time can be enhanced while keeping the apparatus from becoming excessively large.

Furthermore, in the separation part 503, the layered body 207 is preferably separated by a change in the conveying direction MD of the fine-pattern-forming film 101a, and a separating roller or separating edge such as described hereinafter may be utilized. For example, by holding (fixing) the exposed face of the target object 104 of the layered body 207 and changing the conveying direction MD of the fine-pattern-forming film 101a through use of a separating edge or separating roller, the layered body 207 can be separated with high accuracy.

The separation part 503 may be specifically configured in the same manner as the peeling part 206 described with reference to FIGS. 15 and 16 in the first embodiment.

The direction change of the partially cut fine-pattern-forming film 101 in the separation part 503 can be defined by replacing the peeling angle $\theta 1$ described using FIG. 17 in the first embodiment with a separation angle $\theta 1$. Specifically, as shown in FIG. 17, the angle $\theta 1$ formed by the plane of the conveying direction (MD-1) of the fine-pattern-forming film 101 before passing the separation part 503 and the plane of the conveying direction (MD-2) of the fine-pattern-forming film 101 after passing the separation part 503 can be defined as the amount of change in the separation direction. This angle $\theta 1$ is the separation angle. The separation angle $\theta 1$ is preferably equal to or more than 15 degrees but equal to or less than 170 degrees. Since a separation angle of 15 or greater makes it possible to decrease the separation stress applied to the interface of the fine-pattern-forming film 101 and the target object 104 of the layered body 207, the transfer accuracy of thermal nanoimprinting is enhanced. Meanwhile, since a separation angle of 170 degrees or less reduces the load placed on conveyance of the fine-pattern-forming film 101, conveyance precision is enhanced. For the same reasons, the separation angle $\theta 1$ is more preferably equal to or more than 30 degrees but equal to or less than 160 degrees, and most preferably equal to or more than 60 degrees but equal to or less than 160 degrees. A separation angle $\theta 1$ of 90 degrees or greater makes it possible to keep the apparatus from becoming excessively large. From the perspective of designing a more compact apparatus, the separation angle $\theta 1$ is preferably 100 degrees or greater, more

preferably 110 degrees or greater, and most preferably 125 degrees or greater. The plane of the conveying direction (MD-1) of the fine-pattern-forming film 101 before passing the separation part is substantially parallel to the process face of the target object 104 before separating.

A collection part may be provided in the same manner as in the first embodiment downstream from the cutting part 501 or the separation part 503 in the conveying direction MD. Furthermore, an energy-ray irradiation part, a heating part, and a cooling part may be provided in the same manner as in the first embodiment downstream from the collection part in the conveying direction MD.

<Third Embodiment>

The thermal nanoimprinting apparatus pertaining to a third embodiment will next be described in detail with reference to the drawings. The thermal nanoimprinting apparatus pertaining to the third embodiment has a peeling part 206, the same as in the thermal nanoimprinting apparatus 200 pertaining to the first embodiment. Constituent members that are the same as those described in the embodiments above are referred to by the same reference numerals, and no description thereof will be given.

FIG. 20 is a schematic view showing the thermal nanoimprinting apparatus pertaining to the third embodiment. The thermal nanoimprinting apparatus 600 pertaining to the third embodiment is provided with a feeding roller 202 on which a long fine-pattern-forming film 101 is wound. The feeding roller 202 sends out the fine-pattern-forming film 101 at a predetermined speed. A take-up roller 203 paired with the feeding roller 202 is provided for winding the sent fine-pattern-forming film 101.

In the third embodiment described above, a roller having a mirror finish on the surface thereof was used as the roller for directly contacting the surface of the first mask layer of the fine-pattern-forming film 101, the same as in the first embodiment.

(Peeling of the protective layer)

When a protective layer 601 is provided on the fine-pattern-forming film 101, a protective-layer peeling roller part 602 for peeling the protective layer 601 from the fine-pattern-forming film 101 is provided downstream from the feeding roller 202 in the conveying direction MD of the fine-pattern-forming film 101. When a dancer roller is provided in the vicinity of the feeding roller 202, the protective-layer peeling roller part 602 is provided downstream from the dancer roller in the conveying direction MD of the fine-pattern-forming film 101. A protective-layer take-up roller 603 for winding and recovering the protective layer 601 is jointly provided to the protective-layer peeling roller 602 downstream in the conveying direction of the protective layer 601. The protective-layer peeling roller 602 may be provided as a free roller not equipped with a drive part, or may be a roller not accompanied by a drive part, and is not particularly limited insofar as the protective-layer peeling roller 602 is capable of peeling the protective layer 601 from the fine-pattern-forming film 101. Meanwhile, the protective layer take-up roller 603 serves to wind and recover the protective layer 601 peeled from the fine-pattern-forming film 101, and is therefore preferably accompanied by a drive part. The protective layer take-up roller 603 rotated by a drive part may be synchronized with the speed of the fine-pattern-forming film 101 sent from the feeding roller 202, tension control of the fine-pattern-forming film 101 may be employed in order to suppress conveyance defects such as twisting or meandering of the fine-pattern-forming film 101, and a torque motor may be used to drive the protective-layer take-up roller 603, or a dancer roller may be provided between the protective-layer take-up roller 603 and the protective-layer peeling roller part 602. Providing a torque motor or a dancer roller enables a constant tension to be applied to the protective layer 601. The protective-layer peeling roller 602 is preferably provided in a position near the rotating body 102 of the laminating part 201, because adhesion of foreign substances to the exposed surface of the fine-pattern-forming film 101 from which the protective layer 601 has been peeled is thereby suppressed, and as a result, the laminating precision of the fine-pattern-forming film 101 and the target object 104 is enhanced.

As shown in FIG. 20, when the protective layer 601 is present on the fine-pattern-forming film 101, the target object holding part 205 is provided further downstream from the protective-layer peeling roller part 602 in the conveying direction MD. When the fine-pattern-forming film 101 is not equipped with the protective layer 601, the target object holding part 205 can be provided further downstream from the feeding roller 202 in the conveying direction MD.

Here, there is preferably an inclination between the process face of the target object 104 held by the target object holding part 205 and the first mask layer face of the fine-pattern-forming film 101 upstream from the rotating body 102 in the conveying direction MD. A more specific description will be given using FIG. 21. FIG. 21 is a schematic view showing the relationship between the target object and the fine-pattern-forming film in the laminating part in the thermal nanoimprinting apparatus pertaining to the third embodiment. As shown in FIG. 21, the fine-pattern-forming film 101 is sent from the feeding roller 202. A guide roller 701, a dancer roller 702, and a guide roller 703 are disposed downstream from the feeding roller 202. The conveying direction MD of the fine-pattern-forming film 101 is varied by the guide roller 703. The conveying direction MD is furthermore varied by the rotating body 102 positioned downstream from the guide

roller 703. Specifically, between the guide roller 703 and the rotating body 102, the fine-pattern-forming film 101 and the target object 104 are not parallel to each other. Creating such a state makes it possible to use of the rotating body 102 and prevent entrapment of bubbles during laminating of the fine-pattern-forming film 101 and the target object 104. Here, between the guide roller 703 and the rotating body 102, the angle $\theta 2$ formed by the first mask layer face of the fine-pattern-forming film 101 and the process face of the target object 104 in a plane parallel to the process face of the target object 104 preferably ranges equal to or more than 0 degrees but equal to or less than 80 degrees, because the laminating properties are thereby enhanced. The angle $\theta 2$ is more preferably equal to or more than 0.1 degrees but equal to or less than 60 degrees, and most preferably equal to or more than 0.2 degrees but equal to or less than 30 degrees.

(Intermittent laminating, continuous laminating)

Conveyance of the fine-pattern-forming film 101 is stopped during laminating and pressing of the first mask layer face of the fine-pattern-forming film 101 and the process face of the target object 104 by the rotating body 102. Conveyance of the fine-pattern-forming film 101 is stopped, and the rotating body 102 moves in the direction opposite to the conveying direction MD and in a plane parallel to the process face of the target object 104. The fine-pattern-forming film 101 and the target object 104 fixed by the target object holding part 205 are thereby laminated together. Conveyance of the fine-pattern-forming film 101 is then resumed. Here, the target object 104 is released from the target object holding part 205 before or substantially at the same time as conveyance of the fine-pattern-forming film 101 is resumed. Specifically, resumption of conveyance of the fine-pattern-forming film 101 causes the target object 104 to be conveyed by the fine-pattern-forming film 101. Then, after the target object 104 on the fine-pattern-forming film 101 has passed the initial position of the rotating body 102, the rotating body 102 returns to the initial position thereof.

Alternatively, the rotating body 102 returns to the initial position after laminating, and conveyance of the fine-pattern-forming film 101 is then resumed. Here, the target object 104 is released from the target object holding part 205 before or substantially at the same time as conveyance of the fine-pattern-forming film 101 is resumed. Specifically, resumption of conveyance of the fine-pattern-forming film 101 causes the target object 104 to be conveyed by the fine-pattern-forming film 101.

The target object 104 is preferably released from the target object holding part 205 before conveyance of the fine-pattern-forming film 101 is resumed, as described above, since the laminating precision of the fine-pattern-forming film 101 in the plane including the end parts of the target object 104 is thereby enhanced. More specifically, the face of the target object 104 on the opposite side thereof of the process face is first fixed by the target object holding part 205. Decompression fixing, for example, may be employed. Laminating of the fine-pattern-forming film 101 is then initiated from one edge part of the target object 104 by the rotating body 102 of the pressing part 100. Laminating of the fine-pattern-forming film 101 in an amount commensurate with the pressing is then performed toward the other-edge part of the target object 104 while the rotating body 102 rotates. Here, fixing of the target object is released before the rotating body 102 finishes passing the other-edge part of the target object 104. When retention by the target object holding part 205 is by a decompression chuck, for example, the decompression is released. In this state, the rotating body 102 passes the other-edge part of the target object 104 while rotating. The fine-pattern-forming film 101 can thereby be laminated throughout the plane that includes the end parts of the target object 104.

Laminating in intermittent fashion such as described above is referred to hereinafter as intermittent laminating. Laminating and pressing of the fine-pattern-forming film 101 to the target object 104 can be performed not only in the intermittent laminating described above, but in continuous laminating as well. The term "continuous laminating" refers to a case in which conveyance of the fine-pattern-forming film 101 is not stopped at each step, and laminating of the fine-pattern-forming film 101 to the target object 104 is performed continuously. In continuous laminating, the position of the rotating body 102 is fixed or moves, and continuous laminating is performed by moving the target object holding part 205 in the conveying direction MD of the fine-pattern-forming film 101.

In both intermittent laminating and continuous laminating, the rotating body 102 preferably rotates about a rotating shaft. In this case, the relationship between the rotating body 102 and the target object 104 preferably satisfies the range for the distance X previously described with reference to FIG. 10.

The rotating body 102 moves parallel to the process face of the target object 104, and the fine-pattern-forming film 101 and the target object 104 are thereby laminated and pressed. When laminating of the fine-pattern-forming film 101 to the target object 104 is by intermittent laminating, the rotating body 102 moves parallel and in the direction opposite to the conveying direction MD of the fine-pattern-forming film 101 in a state in which the target object holding part 205 is stationary. At this time, the process face of the target object 104 and the fine-pattern-forming film 101 are laminated and pressed by the rotating body 102. The target object 104 then separates from the target object holding part 205, and is conveyed integrally with the fine-pattern-forming film 101. Specifically, the fine-pattern-forming film 101 functions as a carrier for the target object 104. Then, after the target object 104 on the fine-pattern-forming film 101 has passed the initial position of the rotating body 102, the rotating body 102 returns to the initial position thereof.

When laminating of the fine-pattern-forming film 101 to the target object 104 is by continuous laminating, the

rotating body 102 is either fixed or moves in the direction opposite to the conveying direction MD of the fine-pattern-forming film 101. In the former case, the movement speed of the target object holding part 205 is synchronized with the conveyance speed of the fine-pattern-forming film 101, and the conveyance speed of the fine-pattern-forming film 101 becomes the laminating/pressing speed. In the latter case, the relative speed difference between the conveyance speed of the fine-pattern-forming film 101 and the movement speed of the rotating body 102 becomes the laminating/pressing speed of the fine-pattern-forming film 101, and this laminating/pressing speed can be increased relative to the conveyance speed of the fine-pattern-forming film 101. When laminating of the fine-pattern-forming film 101 to the target object 104 is by continuous laminating, the peeling speed at the peeling part 206 described hereinafter becomes the same as the conveyance speed of the fine-pattern-forming film 101, which is effective when it is necessary that the laminating/pressing speed be higher than the peeling speed.

On the rotating body 102, the fine-pattern-forming film 101 and the process face of the target object 104 are facing each other in a state of contact with each other. In this state, by movement of the rotating body 102, the fine-pattern-forming film 101 and the target object 104 are placed in a state of being held under pressure between the rotating body 102 and the target object holding part 205. As a result, the fine-pattern-forming film 101 and the target object 104 are laminated/pressed.

The pressurizing means for the rotating body 102 may press the rotating body 102 toward the fine-pattern-forming film 101 from below, in the manner of the pressurizing means 204 shown in FIG. 20, may press the target object 104 and the fine-pattern-forming film 101 toward the rotating body 102 from above through use of the target object holding part 205, or may perform both these functions.

Furthermore, a press heating part (not shown) accompanies the rotating body 102 and/or the target object holding part 205.

The angle $\Theta$ described with reference to FIG. 12 during pressing of the fine-pattern-forming film 101 and the target object 104 by the rotating body 102 preferably ranges equal to or more than 1 degree but equal to or less than 60 degrees, because the thermal nanoimprinting precision at low temperature and low pressure is thereby enhanced. In the third embodiment, the angle $\Theta$ is set in the range of equal to or more than 1 degree but equal to or less than 10 degrees.

A rotation assisting part (not shown) for reducing the rolling friction of the rotating body 102 may be connected to the rotating body 102 in such a manner as not to impede conveyance of the fine-pattern-forming film 101. The rotation assisting part is a bearing, for example, connected to the rotating shaft of the rotating body 102.

The peeling part 206 is provided in a gap sufficient for jointly providing the energy-ray irradiation part described hereinafter downstream from the laminating part 201 and upstream from the take-up roller 203 in the conveying direction MD. The peeling part 206 is provided with a peeling roller 604. The peeling roller 604 is provided so as to span the entire width of the fine-pattern-forming film 101. The cross-sectional shape of the peeling roller 604 is substantially true-circular. The length of the peeling roller 604 in the width direction of the fine-pattern-forming film 101 is not particularly limited insofar as this length is greater than the size of the layered body 207 from which the fine-pattern-forming film 101 is peeled, i.e., the size of the target object 104. In a particularly preferred configuration, a plurality of target objects 104 are arranged in the width direction of the fine-pattern-forming film 101, and the peeling roller 604 is provided so as to span the entire width of the fine-pattern-forming film 101 in order to peel the fine-pattern-forming film 101 from the layered bodies 207 simultaneously. Furthermore, the length of the peeling roller 604 with respect to the width direction of the fine-pattern-forming film 101 is preferably equal to or greater than the length of the laminating part 201 with respect to the width direction of the fine-pattern-forming film 101. Particularly from the perspective of keeping equipment from becoming too large, it is more preferred that the length of the peeling roller 604 with respect to the width direction of the fine-pattern-forming film 101 and the length of the laminating part 201 with respect to the width direction of the fine-pattern-forming film 101 be substantially equal.

The peeling roller 604 preferably rotates passively in conjunction with the conveyance of the fine-pattern-forming film 101, since the accuracy of peeling is thereby enhanced. A rotation mechanism using a free roller, or a rotation mechanism synchronized with the conveyance of the fine-pattern-forming film 101, i.e., synchronized with the rotation of the feeding roller 202 or the take-up roller 203 by a drive part, may be employed as a rotation mechanism for the peeling roller 604.

In the peeling roller 604, a cylindrical roll is attached to the periphery of a rotating shaft, for example, and the material of the surface of the roll is not particularly limited, but is preferably a resin, rubber, or other elastic body, since the accuracy of peeling can thereby be enhanced.

Holding means 605 for fixing the target object 104 is jointly provided to the peeling roller 604. The holding means 605 is configured so as to hold an exposed face of the target object 104 on the opposite side thereof of the process face.

In the peeling part 206, the peeling angle $\theta 1$ as described with reference to FIG. 17 is preferably equal to more than 15 degrees but equal to less than 170 degrees, since the load (peeling stress) on the concavo-convex structure obtained by thermal nanoimprinting is thereby reduced, and the load placed on conveyance of the fine-pattern-forming

film 101 is thereby reduced. In the third embodiment, the peeling angle $\theta 1$ is set in the range of equal to more than 95 degrees but equal to less than 150 degrees.

An energy-ray irradiation part 610 is provided between the rotating body 102 and the peeling part 206. The energy-ray irradiation part 610 is provided on the target object 104 side, and energy rays are irradiated toward the target object 104.

The energy rays can be selected, as appropriate, on the basis of the material constituting the fine-pattern-forming film 101, and are therefore not particularly limited, but in the third embodiment, a UV-LED light source is selected and the integral light intensity from the start of energy ray irradiation to the end of irradiation is in the range of from 800 $mJ/cm^2$ to 2000 $mJ/cm^2$.

A preprocessing part (not shown) may be provided upstream from the feeding roller 202 in the conveying direction MD. In the preprocessing part, the process face of the target object 104 held by the target object holding part can be preprocessed.

Meanwhile, the collection part (not shown) described above may be provided downstream from the peeling part 206 in the conveying direction MD. In the third embodiment, the holding means 605 is configured to serve also as a collection part. Specifically, when the fine-pattern-forming film 101 is peeled from the target object 104 in the peeling part 206, the exposed face of the target object 104 is fixed by the holding means 605, and after the cover film has been peeled, the target object 104 is held by the holding means 605, and the target object 104 is collected by moving the holding means 605.

A layered-body heating part 611 is furthermore provided upstream from the peeling part 206 and downstream from the energy-ray irradiation part 610 in the conveying direction MD of the fine-pattern-forming film 101. Providing the layered-body heating part 611 makes it possible to stabilize the interface of the fine-pattern-forming film 101 and the target object 104. The temperature of heating by the layered-body heating part 611 is preferably set so that the target object 104 can be heated to a temperature in the range of from 30°C to 200°C, as previously described. In the third embodiment, the heating temperature is set so that the temperature of the target object 104 is placed in the range of equal to or more than 80°C but equal to or less than 130°C.

A cooling part 612 is furthermore provided upstream from the peeling part 206 and downstream from the layered-body heating part 611 in the conveying direction MD of the fine-pattern-forming film 101. By providing the cooling part 612, the peeling properties of the fine-pattern-forming film 101 can be enhanced. As previously described, the cooling part 612 preferably cools the target object 104 to a temperature of 120°C or below, since peeling properties are thereby enhanced. In the third embodiment, cooling is performed by blowing air until the temperature reaches 30°C or below.

Another energy-ray irradiating part not shown in the drawing may be provided downstream from the peeling part 206 and upstream from the collection part in the conveying direction MD of the fine-pattern-forming film 101. The other energy-ray irradiation part makes it possible to stabilize the concavo-convex structure transferred by thermal nanoimprinting to the surface of the target object 104, and the fitness or storage stability of the concavo-convex structure in processes subsequent to transfer is thereby enhanced. The same effects can be obtained by providing another heating part instead of another energy-ray irradiation part.

FIG. 22 is a schematic view showing a modification of the thermal nanoimprinting apparatus pertaining to the third embodiment. As shown in FIG. 22, the thermal nanoimprinting apparatus 600 pertaining to the third embodiment may be provided with a peeling edge 620 instead of the peeling roller 604.

FIG. 23 is a schematic view showing a modification of the thermal nanoimprinting apparatus pertaining to the third embodiment. FIG. 23 shows a reconfiguration of the thermal nanoimprinting apparatus 600 pertaining to the third embodiment shown in FIG. 20, in which the first mask layer face of the fine-pattern-forming film 101 faces downward, and the target object 104 is brought to face the fine-pattern-forming film 101 from below and is laminated thereto.

FIG. 24 is a schematic view showing a modification of the thermal nanoimprinting apparatus pertaining to the third embodiment. FIG. 24 shows a reconfiguration of the thermal nanoimprinting apparatus 600 pertaining to the third embodiment shown in FIG. 22, in which the first mask layer face of the fine-pattern-forming film 101 faces downward, and the target object 104 is brought to face the fine-pattern-forming film 101 from below and is laminated thereto.

FIG. 25 is a schematic view showing a modification of the thermal nanoimprinting apparatus pertaining to the third embodiment. As shown in FIG. 25, the thermal nanoimprinting apparatus 600 pertaining to the third embodiment may be provided with a movement roller 631 and a peeling roller 632 instead of the peeling roller 604.

Peeling of the fine-pattern-forming film 101 by the movement roller 631 and the peeling roller 632 is as described with reference to FIGS. 16A and 16B.

FIG. 26 is a schematic view showing a modification of the thermal nanoimprinting apparatus pertaining to the third embodiment. FIG. 26 shows a reconfiguration of the thermal nanoimprinting apparatus 600 pertaining to the third embodiment shown in FIG. 25, in which the first mask layer face of the fine-pattern-forming film 101 faces downward, and the target object 104 is brought to face the fine-pattern-forming film 101 from below and is laminated thereto.

In the third embodiment as well, the roller for directly contacting the surface of the first mask layer of the fine-pattern-forming film 101 is preferably a roller having a mirror finish on the surface thereof, the same as in the first

embodiment and the second embodiment. A static eliminator for suppressing static electricity may also be provided to the laminating part. A static eliminator may likewise be provided to the peeling part 206 as well.

(Thermal nanoimprinting method)

A description will be given of a thermal nanoimprinting method using the thermal nanoimprinting apparatus 600 pertaining to the third embodiment configured such as described above.

First, the fine-pattern-forming film 101 is carried out from the feeding roller 202 and taken up by the take-up roller 203, whereby the fine-pattern-forming film 101 is conveyed through the protective-layer peeling roller part 602 and the laminating part 201 in this order.

The protective layer 601 is peeled from the fine-pattern-forming film 101 in the protective-layer peeling roller part 602, and is taken up and collected by the protective-layer take-up roller 603.

Meanwhile, the target object 104 is extracted from a storage room (not shown). A preprocessing may be performed on the process face of the target object 104 by a preprocessing part (not shown). In the third embodiment, UV-$O_3$ processing, air blowing, and destaticizing are sequentially performed.

The target object 104 is then held by the target object holding part 205. In the third embodiment, the target object 104 is held by decompression chucking. The target object 104 is then conveyed in front of the rotating body 102 by the target object holding part 205. In the third embodiment, the target object holding part 205 is provided with a decompression chucking means 205a, and the target object 104 is placed on and suction-fixed to the target object holding part 205 in a state in which the decompression chucking means 205a faces upward. The target object holding part 205 then moves and rotates so as to turn upside-down, whereby the target object 104 is conveyed in front of the rotating body 102 and brought to rest. At this time, the process face of the target object 104 and the fine-pattern-forming film 101 are facing each other at an angle without contacting each other.

The rotating body 102 then moves in the direction opposite to the conveying direction MD of the fine-pattern-forming film 101, or the target object holding part 205 moves at a speed the same as the conveyance speed of the fine-pattern-forming film 101 in a state in which the fine-pattern-forming film 101 is being conveyed. The target object 104 and the fine-pattern-forming film 101 are thereby held between the target object holding part 205 and the rotating body 102.

The fine-pattern-forming film 101 then receives the pressing force of the rotating body 102, and is pressed against the target object 104. At this time, the surface of the fine-pattern-forming film 101 and the surface of the target object 104 are facing each other. In the third embodiment, the angle $\Theta$ described with reference to FIG. 12 when the fine-pattern-forming film 101 and the target object 104 are pressed by the rotating body 102 is set in the range of equal to or more than one degree but equal to or less than ten degrees.

At this time, the target object 104 is heated by the press heating part. In the third embodiment, a press heating part accompanies both the target object holding part 205 and the rotating body 102, and the surface of the rotating body 102 and the face of the target object holding part 205 adjacent to the target object 104 are heated to a temperature in the range of from 60 degrees to 130 degrees.

Here, by laminating and pressing the fine-pattern-forming film 101 and the target object 104 while pressure is applied essentially in a line by the rotating body 102 to the target object 104 heated by the press heating part, thermal nanoimprinting can be satisfactorily performed at low temperature and low pressure.

As a result, the layered body 207 comprised of the fine-pattern-forming film 101/target object 104 is obtained by laminating and pressing by the rotating body 102 in the laminating part 201.

When laminating and pressing are completed, the target object holding part 205 releases the target object 104, and the conveyance of the fine-pattern-forming film 101 moves the layered body 207 to the energy-ray irradiation part 610.

The layered body 207 is then conveyed to the irradiation region of the energy-ray irradiation part 610 by the conveyance of the fine-pattern-forming film 101, and energy rays are irradiated. In the case of intermittent laminating, energy ray irradiation is performed by stopping the fine-pattern-forming film 101 in the irradiation region of the energy-ray irradiation part 610. In the case of continuous laminating, energy rays are irradiated to the layered body 207 by conveying the fine-pattern-forming film 101.

In the third embodiment, energy rays are irradiated toward the target object 104. A UV-LED light source having a central wavelength of 365 nm is selected as the light source and set so that the integral light intensity is from 800 $mJ/cm^2$ to 2000 $mJ/cm^2$.

By then conveying the fine-pattern-forming film 101, the layered body 207 is conveyed downstream in the conveying direction MD of the fine-pattern-forming film 101 to the layered-body heating part 611. In the third embodiment, the layered-body heating part 611 is set so that the temperature of the target object 104 in in the range of equal to or more than 80°C but equal to or less than 130°C.

In the third embodiment, the layered body 207 is held between a pair of flat plates (not shown), and each of the flat plates is heated, thereby heating the layered body 207.

By then conveying the fine-pattern-forming film 101, the layered body 207 is conveyed downstream in the

conveying direction MD of the fine-pattern-forming film 101 to the cooling part 612. In the third embodiment, cooling is performed by blowing air until the temperature of the layered body 207 reaches 30°C or below.

By furthermore conveying the fine-pattern-forming film 101, the layered body 207 is conveyed downstream in the conveying direction MD of the fine-pattern-forming film 101 to the peeling part 206. The cover film is peeled from the layered body 207 by the peeling part 206.

In the case of intermittent laminating, the thermal nanoimprinting apparatus 600 described using FIGS. 25 and 26 is used, in which the peeling part 206 is provided with the movement roller 631 and the peeling roller 632. Specifically, in a state in which the exposed face of the target object 104 of the layered body 207 is suction-held by the holding means 605, and the layered body 207 and the fine-pattern-forming film 101 are stationary, the movement roller 631 moves in the direction opposite to the conveying direction MD of the fine-pattern-forming film 101 as indicated by the arrow B in the drawing, whereby the peeling roller 632 also moves in the same manner, and the cover film is peeled from the layered body 207. The fine-pattern-forming film 101 is then taken up by the take-up roller 203.

Meanwhile, in the case of continuous laminating, the thermal nanoimprinting apparatus 600 described using FIGS. 23 and 24 is used, in which the peeling part 206 is provided with the peeling edge 620, for example. Specifically, the exposed face of the target object 104 of the layered body 207 is suction-held by the holding means 605, and the holding means 605 is moved at the same speed as the conveyance speed of the fine-pattern-forming film 101, and in a direction parallel to the conveying direction MD of the fine-pattern-forming film 101. Meanwhile, the conveying direction MD of the fine-pattern-forming film 101 is changed by the peeling edge 620. The target object 104 is thereby peeled from the fine-pattern-forming film 101 in the layered body 207. The target object 104 moves to a collection part 621 while still being held by the holding means 605. Meanwhile, the fine-pattern-forming film 101 is taken up by the take-up roller 203.

The cover film is thus peeled from the layered body 207 in the peeling part 206, and a target object 104 provided with a concavo-convex structure transferred thereto by thermal nanoimprinting, i.e., the intermediate body 21 shown in FIG. 5C, is obtained.

In the third embodiment, in the case of intermittent laminating, the layered body 207 moved by conveyance of the fine-pattern-forming film 101 to a point immediately before the peeling part 206 is brought to rest in conjunction with the stopping of conveyance of the fine-pattern-forming film 101. The holding means 605 then moves to a point directly over the target object 104, then descends toward the target object 104 and decompression-fixes the target object 104.

Lastly, the target object 104 provided with the first mask layer and the second mask layer is collected by the collection part. In the thermal nanoimprinting apparatus 600 shown in FIGS. 20, 23, 25, and 26, the holding means 605 is jointly used as a collection part.

A third embodiment is described above, but by arranging the constituent elements thereof circularly rather than linearly, the apparatus can be kept from becoming excessively large.

<Fourth Embodiment>

The thermal nanoimprinting apparatus pertaining to a fourth embodiment will next be described in detail with reference to the drawings. FIG. 27 is a schematic view showing the thermal nanoimprinting apparatus pertaining to the fourth embodiment. Members having the same configuration as in the embodiments described above are referred to by the same reference numerals, and no description thereof will be given.

The thermal nanoimprinting apparatus 800 pertaining to the fourth embodiment is characterized by being provided with the cutting part 501 described using FIG. 18.

The thermal nanoimprinting apparatus 800 is provided with a feeding roller 202 on which a long fine-pattern-forming film 101 is wound. The feeding roller 202 sends out the fine-pattern-forming film 101 at a predetermined speed. A take-up roller 203 paired with the feeding roller 202 is provided for winding the sent fine-pattern-forming film 101. The mechanism of the take-up roller 203 for winding the fine-pattern-forming film 101 is as described in the second embodiment.

When a protective layer 601 is provided to the fine-pattern-forming film 101, a protective-layer peeling roller part 602 and a protective-layer take-up roller 603 may be provided downstream from the feeding roller 202 in the conveying direction MD of the fine-pattern-forming film 101, in the same manner as in the embodiments described above.

The laminating part 201 is provided further downstream from the protective-layer peeling roller part 602 in the conveying direction MD. The laminating part 201 is provided with a pressing part 100 including a rotating body 102 and a pressurizing means 204, the same as in the third embodiment described above. A target object holding part 205 is also provided between the protective-layer peeling roller part 602 and the laminating part 201. A mechanism the same as described in the third embodiment above may be employed as the holding mechanism for the target object holding part 205.

Here, there is preferably an inclination between the fine-pattern-forming film 101 and the process face of the target object 104 held by the target object holding part 205 upstream from the laminating part 201 in the conveying direction MD, the same as in the third embodiment described above.

Laminating and pressing of the concavo-convex structure face of the fine-pattern-forming film 101 and the process face of the target object 104 by the rotating body 102 may be performed in the same manner as in the third embodiment described above, whether in the case of intermittent laminating or in the case of continuous laminating.

A press heating part (not shown) may be provided to the rotating body 102 and/or the target object holding part 205, the same as in the third embodiment. A press heating part is provided both to the rotating body 102 and to the target object holding part 205 in the fourth embodiment as well, the same as in the third embodiment.

The target object 104 may also be extracted from a storage room (not shown) and preprocessing of the process face of the target object 104 performed by a preprocessing part (not shown). In the fourth embodiment, excimer processing, air blowing, and destaticizing are sequentially performed.

A cutting part 501 is provided downstream from the rotating body 102 and upstream from the take-up roller 203 in the conveying direction MD. A gap sufficient for jointly providing the energy-ray irradiation part or the like described hereinafter is preferably provided between the rotating body 102 and the cutting part 501, or between the take-up roller 203 and the cutting part 501.

Here, conveyance of the layered body 207 comprising the fine-pattern-forming film 101/target object 104 between the rotating body 102 and the cutting part 501 may also be realized by separately providing holding means for fixing the exposed face of the target object 104 of the layered body 207. However, from the perspective of keeping the apparatus from becoming excessively large, the flow of the fine-pattern-forming film 101 is preferably utilized for conveyance; i.e., the fine-pattern-forming film 101 is preferably caused to function as a carrier for the target object 104, in the same manner as in the third embodiment.

As described above, the cutting part 501 completely or partially cuts the fine-pattern-forming film 101 positioned outside the external periphery of the target object 104 from the target object 104 to which the fine-pattern-forming film 101 has been laminated. In the fourth embodiment, a form of partial cutting is employed. More specifically, in the fourth embodiment, the cutting part 501 is comprised of a cutting blade part 501a for severing the fine-pattern-forming film 101, and a support part 501b for supporting the layered body 207. A cutting blade 504 which is larger than the target object 104 and has an external peripheral shape substantially similar to that of the target object 104 is used in the cutting blade part 501a. The cutting blade 504 is provided with four point-symmetrical portions where there is no blade. Specifically, the fine-pattern-forming film 101 cut by the cutting part 501 is cut so that four partial connected parts remain which are point-symmetrical about the target object 104 between the outside (101a in FIG. 19) and the inside (101b in FIG. 19) of the cutting position. As previously described, from the perspective of the conveyance precision of the fine-pattern-forming film 101, the cutting width (I) in the width direction of the fine-pattern-forming film 101 is set so as to be in the range of from 0.8 W to 0.99 W with respect to the width (W) of the fine-pattern-forming film 101 in the fourth embodiment.

The cutting part 501 is further provided with a substantially columnar elastic body 505 comprised of a sponge, for example. The thickness of the elastic body 505 is greater than that of the cutting blade 504. A groove part 505a is provided in a circle in the elastic body 505. The cutting blade 504 is attached in embedded fashion so that the entire cutting blade 504 can be accommodated in the groove part 505a. Through this configuration, when the elastic body 505 is compressed by an external force, a blade tip of the cutting blade 504 protrudes to the outside. The cutting part 501 can be raised and lowered by a drive means not shown in the drawing.

A metal-made support base 506 for supporting the layered body 207 from the target object 104 side thereof is provided on the opposite side of the fine-pattern-forming film 101 from the cutting blade part 501a. The support base 506 is fixed, for example. The support part 501b is comprised of the support base 506 and the elastic body 505 of the cutting blade part 501a described above, and holds top and bottom faces of the layered body 207. More specifically, when the fine-pattern-forming film 101 is cut, the cutting part 501 is lowered, and the support base 506 is fixed. The layered body 207 can therefore be held from above and below. Further lowering the cutting part 501 causes the elastic body 505 to elastically deform, and the cutting blade part 501a is pushed into the fine-pattern-forming film 101. Specifically, by lowering the cutting part 501, pressure is applied to the elastic body 505, the elastic body 505 is compressed, and the cutting blade 504 protrudes. As a result, the fine-pattern-forming film 101 is cut.

As described above, the fine-pattern-forming film 101 of the layered body 207 is partially cut by the cutting part 501. Specifically, as shown in FIG. 19, connected points are present between the fine-pattern-forming film 101a on the target object 104 and the fine-pattern-forming film 101b on the target object 104. The layered body 207 can therefore be conveyed further downstream in the conveying direction MD of the fine-pattern-forming film 101 by the conveyance of the fine-pattern-forming film 101.

An energy-ray irradiation part may be provided upstream from the cutting part 501 in the conveying direction MD of the fine-pattern-forming film 101. The energy-ray irradiation part is as previously described. In the fourth embodiment, energy rays are irradiated toward the target object 104. A UV-LED light source having a central wavelength of 365 nm is selected as the light source and set so that the integral light intensity is from 800 $mJ/cm^2$ to 2000 $mJ/cm^2$.

A separation part 503 may be provided downstream from the cutting part 501 in the conveying direction MD of the fine-pattern-forming film 101. By providing the separation part 503, the layered body 207 comprising the partially cut fine-pattern-forming film 101b/target object 104 can be completely separated from the fine-pattern-forming film 101a,

and the layered body 207 can be continuously obtained.

The separation part 503 is configured as previously described in the second embodiment. In the fourth embodiment, the exposed face of the target object 104 of the layered body 207 is held (fixed), and the layered body 207 is separated from the fine-pattern-forming film 101a by changing the conveying direction MD of the partially cut fine-pattern-forming film 101a through use of a peeling roller 503a.

In the fourth embodiment, the separation angle $\theta 1$ described with reference to FIG. 17 is set in the range of equal to or more than 95 degrees but equal to or less than 170 degrees.

In the separation part 503, by further providing holding means capable of detachably fixing the exposed face of the target object 104, the physical balance of the layered body 207 during separation by the separation part 503 is improved, and twisting of the fine-pattern-forming film 101a or deficiency of the concavo-convex structure obtained by thermal nanoimprinting can be better suppressed. The holding means is a decompression chuck, an electrostatic chuck, a means for grasping an external peripheral edge part, or a cassette-support-type means well-known to a person skilled in the art.

A collection part (not shown) may be provided downstream from the separation part 503 in the conveying direction MD. The collection part recovers the layered body 207. This collection part conveys the layered body 207 to an apparatus for the next processing or to a temporary storage apparatus while holding the layered body 207. Retention of the layered body 207 by the collection part may be realized by supporting the exposed face of the target object 104 or the exposed face of the fine-pattern-forming film 101. In the fourth embodiment, the holding means used in the separation part 503 is jointly used as a recovery means. Specifically, in the separation part 503, holding means 801 fixes the surface of the target object 104, and the layered body 207 is separated therefrom. The holding means 801 then moves while suction chucking by the holding means 801 is maintained, and recovers the layered body 207.

Furthermore, in the fourth embodiment, other constituent elements may be further added downstream from the separation part 503 in the conveying direction MD of the fine-pattern-forming film 101, as shown in FIGS. 28 and 29.

FIG. 28 is a schematic view showing a modification of the thermal nanoimprinting apparatus pertaining to the fourth embodiment. As shown in FIG. 28, the thermal nanoimprinting apparatus 800 is provided with a conveyance part 810 for conveying the layered body 207 from which the fine-pattern-forming film 101a has been separated by the separation part 503. The conveyance part 810 is a conveyor in which a conveyor belt 813 is passed between a pair of conveyor rolls 811, 812.

A peeling part 814 is provided in the vicinity of a conveyor terminal end of the conveyance part 810. The peeling part 814 utilizes suction chucking of the exposed face of the target object 104 constituting the layered body 207 by holding means 815, and the curvature of the conveyor belt 813 (referred to hereinafter as the curvature of the conveyor terminal end) on the conveyor roll 812 to peel the fine-pattern-forming film 101b from the target object 104.

When the curvature of the conveyor terminal end is utilized in this manner, the holding means 815 moves parallel to the conveying direction of the layered body 207 while holding the target object 104 at a speed synchronized with the conveyance speed of the layered body 207 by the conveyance part 810, and the fine-pattern-forming film 101b is held by the conveyor belt 813. A layered body comprising the holding means 815/target object 104/fine-pattern-forming film 101b/conveyor belt 813 enters the curvature of the conveyor terminal end, and peeling is performed. The peeling properties of the fine-pattern-forming film 101b are thereby improved. Here, from the perspective of mass production, it is preferred that a plurality of holding means 815 be provided, and that all of the holding means 815 repeatedly perform the same operation.

As shown in FIG. 28, an energy-ray irradiation part 820, a heating part 821, and a cooling part 822 may be provided along the conveyance part 810 upstream from the peeling part 814.

In the heating part 821, the heating temperature of the target object 104 is set in the range of equal to or more than 90°C but equal to or less than 140°C in the fourth embodiment. In the heating part 821, the layered body 207 is held between a pair of flat plates, and each of the flat plates is heated, thereby heating the layered body 207.

In the cooling part 822 in the fourth embodiment, the layered body 207 is cooled by blowing air thereon until the temperature thereof reaches 30°C or below.

The target object 104 from which the fine-pattern-forming film 101b has been peeled by the peeling part 814 is collected by a separately provided collection part (not shown). The mechanism of the collection part is as previously described.

FIG. 29 is a schematic view showing a modification of the thermal nanoimprinting apparatus pertaining to the fourth embodiment. As shown in FIG. 29, the thermal nanoimprinting apparatus 900 is provided with a conveyance part 830 comprised of a plurality of movable holding means 831 for conveying the layered body 207 separated from the fine-pattern-forming film 101a by the separation part 503 while the layered body 207 remains in a held state. The thermal nanoimprinting apparatus 900 shown in FIG. 29 is configured so that processing is performed in a state in which the concavo-convex structure face of the fine-pattern-forming film 101 faces upward and the process face of the target object 104 faces downward, the same as in the second embodiment shown in FIG. 18.

The energy-ray irradiation part 820, the heating part 821, and the cooling part 822 are provided in sequence

on the path of conveyance of the layered body 207 by the conveyance part 830.

A peeling part 832 is provided at a terminal end of the conveyance part 830. By this peeling part 832, in a state in which the exposed face of the target object 104 is held by the holding means 831 and stationary, the fine-pattern-forming film 101b is held, and the fine-pattern-forming film 101b is peeled so that movement is applied thereto in the in-plane direction of the target object 104. A peeling part that is the same as the previously described peeling part 206 may be employed as the peeling part 832.

In the fourth embodiment as well, the roll for directly contacting the surface of the first mask layer of the fine-pattern-forming film is preferably a roll having a mirror finish on the surface thereof, the same as in the first through third embodiments. A static eliminator for suppressing static electricity may also be provided to the laminating part 201. A static eliminator may likewise be provided to the peeling part 832 as well.

A fourth embodiment is described above, but by arranging the constituent elements thereof circularly rather than linearly, the apparatus can be kept from becoming excessively large.

<Fifth Embodiment>

A fifth embodiment will next be described in detail with reference to the accompanying drawings. FIG. 30 is a schematic view showing the thermal nanoimprinting apparatus pertaining to the fifth embodiment. Members having the same configuration as in the third embodiment are referred to by the same reference numerals, and no description thereof will be given.

The thermal nanoimprinting apparatus 1000 pertaining to the fifth embodiment is provided with a feeding roller 202 on which a long fine-pattern-forming film 101 is wound. The feeding roller 202 sends out the fine-pattern-forming film 101 at a predetermined speed. A take-up roller 203 paired with the feeding roller 202 is provided for winding the sent fine-pattern-forming film 101.

When a protective layer 601 is provided to the fine-pattern-forming film 101, a protective-layer peeling roller part 602 and a protective-layer take-up roller 603 may be provided downstream from the feeding roller 202 in the conveying direction MD of the fine-pattern-forming film 101.

The laminating part 201 is provided further downstream than the protective-layer peeling roller part 602 in the conveying direction MD. In the laminating part 201, a rotation assisting part 1009 for reducing the rolling friction of the rotating body 102 may be connected to the rotating body 102 in such a manner as not to impede conveyance of the fine-pattern-forming film 101. The rotation assisting part 1009 is a bearing, for example, connected to the rotating shaft of the rotating body 102. The rotation assisting part 1009 may also be omitted.

A press heating part may also be provided to the laminating part 201 and/or the target object holding part 205. In the fifth embodiment, a press heating part (not shown) is provided both to the laminating part 201 and to the target object holding part 205.

As shown in FIG. 30, the laminating part 201 is disposed in a higher position than the feeding roller 202. Through this configuration, the conveying direction MD of the fine-pattern-forming film 101 is changed from an upward-inclined direction to the horizontal direction. In other words, the laminating part 201 functions as a guide roller.

The peeling roller 604 is provided in a gap sufficient for jointly providing an energy-ray irradiation part 1002 described hereinafter downstream from the laminating part 201 and upstream from the take-up roller 203 in the conveying direction MD.

A rotation assisting part 1001 for reducing the rolling friction of the peeling roller 604 may be connected to the peeling roller 604 in such a manner as not to impede conveyance of the fine-pattern-forming film 101.

As shown in FIG. 30, the peeling roller 604 is disposed in a higher position than the take-up roller 203. Through this configuration, the conveying direction MD of the fine-pattern-forming film 101 is changed from the horizontal direction to a downward-inclined direction. In other words, the peeling roller 604 functions as a guide roller.

The fine-pattern-forming film 101 is thus conveyed substantially horizontally between the laminating part 201 and the peeling roller 604.

An energy-ray irradiating part 1002 is provided between the laminating part 201 and the peeling roller 604, on the opposite side of the fine-pattern-forming film 101 from the target object 104.

In the thermal nanoimprinting apparatus 1000, the face of the fine-pattern-forming film 101 to be laminated to the target object 104 faces vertically upward. The laminating part 201, the energy-ray irradiating part 1002, and the peeling roller 604 are also disposed on the bottom side of the fine-pattern-forming film 101, i.e., on the opposite side of the target object 104.

The thermal nanoimprinting apparatus 1000 pertaining to the fifth embodiment is provided with a target object loading part 1003. The target object loading part 1003 loads the target object 104 in a preprocessing part 1004, and the surface of the target object is preprocessed in the same manner as in the first embodiment. Since the target object 104 must be supported, the target object loading part 1003 preferably grasps an external peripheral edge part of the target object 104, but the target object loading part 1003 is not limited to this configuration.

The thermal nanoimprinting apparatus 1000 pertaining to the fifth embodiment is also provided with a target object holding part 205 for receiving the target object 104 from the target object loading part 1003. This target object holding part 205 moves the received target object 104 to a point above the laminating part 201 and mounts the target object 104 on the fine-pattern-forming film 101 so that the preprocessed face of the target object 104 is on the bottom side thereof.

In the target object holding part 205, the target object 104 is detachably fixed by a decompression chuck (not shown). Besides a decompression chuck, an electrostatic chuck or the like may be used as the target object holding part 205. A means for grasping an external peripheral edge part of the target object 104, or a cassette-support-type means well-known to a person skilled in the art may also be employed.

The thermal nanoimprinting apparatus 1000 pertaining to the fifth embodiment is provided with a collection part 1006 for recovering the target object, i.e., an intermediate body 1005, obtained by peeling the cover film. In the collection part 1006, the intermediate body is detachably fixed by a decompression chuck (not shown). Besides a decompression chuck, an electrostatic chuck or the like may be used as the holding means. A means for grasping an external peripheral edge part of the intermediate body 1005, or a cassette-support-type means well-known to a person skilled in the art may also be employed.

In the thermal nanoimprinting apparatus 1000 pertaining to the fifth embodiment, the target object 104 is conveyed over the rotating body 102, the energy-ray irradiating part 1002, and the peeling roller 604 in sequence along the conveying direction MD by the fine-pattern-forming film 101, and the laminating, energy ray irradiation, and peeling processes are performed.

First, on the rotating body 102, the fine-pattern-forming film 101 and the process face of the target object 104 are conveyed facing each other and in contact with each other. The pressurizing means 204 for pressing the fine-pattern-forming film 101 toward a preprocessed face of the target object 104 is provided to the rotating body 102, and the pressing force of the pressurizing means 204 is applied to the fine-pattern-forming film 101 and the target object 104. At this time, since the target object 104 is heated to a predetermined temperature by a press heating part, adhesion to the target object 104 is realized. As a result, laminating and pressing of the fine-pattern-forming film 101 and the target object 104 are performed essentially in a line, and a layered body 207 comprised of the fine-pattern-forming film 101/target object 104 is obtained.

At this time, the target object holding part 205 supports the target object 104. The laminating part 201 is thus comprised of the rotating body 102, the target object holding part 205, the press heating part, and the pressurizing means 204 in the thermal nanoimprinting apparatus 1000 pertaining to the fifth embodiment. By this laminating part 201, pressure is applied to the fine-pattern-forming film 101 and the target object 104 essentially in a line, and laminating of the fine-pattern-forming film 101 and the target object 104 is thereby realized.

The conditions and method for laminating/pressing of the fine-pattern-forming film 101 and the target object 104, and the mechanism of the target object holding part 205 are as described in the first embodiment.

Support of the target object 104 supported by the target object holding part 205 is released after the target object 104 has completely passed the laminating part 201 or immediately before the target object 104 finishes passing the laminating part 201. Specifically, after or immediately before one principal face of the target object 104 is completely laminated with the fine-pattern-forming film 101, retention of the target object 104 by the target object holding part 205 is released, and only the layered body 207 comprising the fine-pattern-forming film 101/target object 104 is moved by the flow of the fine-pattern-forming film 101 and conveyed toward the energy-ray irradiating part 1002.

A heating part 1007 and a cooling part 1008 are disposed in sequence downstream from the energy-ray irradiating part 1002 in the conveying direction MD. An energy-ray irradiation part 1010 may furthermore be provided downstream from the peeling roller 604 and upstream from the collection part 1006 in the conveying direction MD. By irradiating energy rays to the intermediate body through use of the energy-ray irradiation part 1010, the first mask layer can be stabilized, and storage stability or fitness in a subsequent process not shown in the drawing is enhanced. The same effects can also be obtained by providing a heating part instead of the energy-ray irradiation part 1010.

Meanwhile, in the thermal nanoimprinting apparatus 1000 pertaining to the fifth embodiment, the intermediate body 1005 is fixed to the collection part 1006 by a decompression chuck (not shown), and in this state, the intermediate body 1005 is peeled from the fine-pattern-forming film 101 on the peeling roller 604. The peeling part is thus comprised of the peeling roller 604 and the collection part 1006 in the thermal nanoimprinting apparatus 1000 pertaining to the fifth embodiment. The peeling part is as described in the first through fourth embodiments.

Thermal nanoimprinting transfer using the thermal nanoimprinting apparatus 1000 pertaining to the fifth embodiment will next be described. FIGS. 31A through 31C and 32A through 32C are schematic views showing the operation of the thermal nanoimprinting apparatus in a transfer method pertaining to the fifth embodiment.

As shown in FIG. 31A, the fine-pattern-forming film 101 is carried out from the feeding roller 202 and taken up by the take-up roller 203, whereby the fine-pattern-forming film 101 is conveyed through the protective-layer peeling roller part 602, the rotating body 102, and the peeling roller 604 in this order. The protective layer 601 is then peeled from the fine-pattern-forming film 101 in the protective-layer peeling roller part 602, and is taken up and collected by the

protective-layer take-up roller 603.

The target object 104 is loaded from a storage room (not shown) for storing the target object 104 into the preprocessing part 1004 by the target object loading part 1003, as shown in FIG. 31A. The target object loading part 1003 approaches from a preprocessed-face-side of the target object 104 and grasps the external peripheral edge part of the target object 104.

The target object 104 is then passed from the target object loading part 1003 to the target object holding part 205 as shown in FIG. 31B. At this time, the target object loading part 1003 rotates 180 degrees to cause the opposite side of the target object 104 from the preprocessed face to face toward and come in contact with the target object holding part 205. In this state, a vacuum chuck (not shown) fixes the target object 104 to the target object holding part 205.

The target object 104 is then conveyed to a point over the fine-pattern-forming film 101 along with the conveyance of the fine-pattern-forming film 101, as shown in FIG. 31C. The target object 104 continues to move to a point over the laminating part 201. The target object 104 is heated by the press heating part included in the target object holding part 205, the fine-pattern-forming film 101 and the target object 104 are brought into contact over the laminating part 201 and receive the pressing force of the pressurizing means 204, the target object 104 and the fine-pattern-forming film 101 are laminated together, and a layered body 207 comprised of the fine-pattern-forming film 101/target object 104 is obtained. decompression chucking of the target object holding part 205 is then released, and the target object holding part 205 separates from the target object 104. Laminating and pressing of the fine-pattern-forming film 101 and the target object 104 may be by continuous laminating or intermittent laminating, as described above.

The previously described ranges may be applied for the conditions of heating by the press heating part.

As shown in FIG. 32A, the target object 104 having been laminated to the fine-pattern-forming film 101 is then conveyed to the irradiation region of the energy-ray irradiating part 1002 in conjunction with the conveyance of the fine-pattern-forming film 101, and energy rays are irradiated thereto. The previously described conditions may be employed for energy ray irradiation.

In FIG. 30, the energy-ray irradiating part 1002 is provided on the fine-pattern-forming film 101 on the opposite side to the target object 104, but in the fifth embodiment, the energy-ray irradiating part 1002 may also be provided on the target object side of the fine-pattern-forming film 101.

As shown in FIG. 32B, the layered body 207 is then conveyed toward the heating part 1007 downstream in the conveying direction MD of the fine-pattern-forming film 101, together with the conveyance of the fine-pattern-forming film 101. The layered body 207 is heated by the heating part 1007. It is thereby possible to enhance the stability of the first mask layer of the fine-pattern-forming film 101, and to enhance the stability of the interface of the fine-pattern-forming film 101 and the target object 104. Accordingly, the subsequent peeling properties of the fine-pattern-forming film 101 can be enhanced. The previously described ranges may be employed for the mechanism and conditions of the heating part 1007.

The layered body 207 is then conveyed toward the cooling part 1008 downstream in the conveying direction MD of the fine-pattern-forming film 101, together with the conveyance of the fine-pattern-forming film 101. Providing the cooling part 1008 makes it possible to enhance the peeling properties during peeling of the fine-pattern-forming film 101. The previously described ranges may be employed for the mechanism and conditions of the cooling part 1008.

As shown in FIG. 32B, the layered body 207 is further conveyed downstream in the conveying direction MD of the fine-pattern-forming film 101 to a point on the peeling roller 604, together with the conveyance of the fine-pattern-forming film 101. Here, before the target object 104 reaches the point on the peeling roller 604, the exposed face of the target object 104 is supported by the collection part 1006. In the target object 104 supported by the collection part 1006, the cover film of the fine-pattern-forming film 101 is peeled from the layered body 207 on the peripheral face of the peeling roller 604. The peeled fine-pattern-forming film 101 is taken up by the take-up roller 203. As a result, a target object provided with a concavo-convex structure on a surface thereof, i.e., the intermediate body 1005, is obtained. Lastly, the intermediate body 1005 is collected by the collection part 1006, as shown in FIG. 32C.

Effects equivalent to those of the third embodiment are obtained by the thermal nanoimprinting apparatus 1000 pertaining to the fifth embodiment as described above and the transfer method using the same. Furthermore, according to the thermal nanoimprinting apparatus 1000 pertaining to the fifth embodiment, by utilizing the fine-pattern-forming film 101 as a means for sequentially conveying the target object 104 to the laminating part 201, the energy-ray irradiating part 1002, and the peeling roller 604, the intermediate body 1005 can be continuously obtained. The degree of freedom of arrangement of the energy-ray irradiating part 1002 is also enhanced through use of the thermal nanoimprinting apparatus 1000 pertaining to the fifth embodiment.

<Etching Step>

After the mask pattern transfer step described in the first through fifth embodiments above, an etching step is performed on the intermediate body 21 comprising the second mask layer 12/first mask layer 13/target object 20 shown in FIG. 3C, and a concavo-convex structure body is formed. At this time, by using the previously described intermediate

body 21 including a predetermined exposed area in an outer edge part of the target object 20, the defect rate in the fine mask structure body 16 can be reduced, and as a result, the defect rate in the concavo-convex structure body 40 can be reduced. An intermediate body 21 in which a predetermined exposed area is included in an outer edge part of the target object 20 can be manufactured with high controllability by undergoing the mask pattern transfer step described in the first through fifth embodiments, and particularly through use of the rotating body 102 in which a low-Tg elastic body is provided on a surface layer thereof. The etching step is comprised of the first mask layer etching step and the target object etching step in this order. Various etching conditions can be designed according to the material, but the etching method described below is cited as an example.

(First mask layer etching)

The first mask layer etching is an etching of the first mask layer, in which the second mask layer is caused to function as an etching mask, and dry etching can be used for the first mask layer etching. The gas used to etch the first mask layer 13 is a gas mixture including at least one of $O_2$ gas, $H_2$ gas, and Ar gas. The use of $O_2$ alone is particularly preferred. From the perspective of etching the first mask layer 13 in chemically reactive fashion, $O_2$ gas and $H_2$ gas may be selected as gases used for etching. From the perspective of enhancing the vertically directed etching rate by increasing ion-injecting components, Ar gas and Xe gas may be selected as gases used for etching.

The pressure during etching is preferably from 0.1 to 5 Pa, more preferably from 0.1 to 1 Pa, because such a pressure makes it possible to increase the ion incident energy contributing to reactive etching, and to further enhance etching anisotropy.

Since anisotropy is enhanced when the ratio of the gas mixture of $O_2$ gas and $H_2$ gas, Ar gas, or Xe gas is such that the chemically reactive etching component and the ion incident component are present in optimal amounts, the gas mixture ratio is preferably from 99 sccm:1 sccm to 50 sccm: 50 sccm, more preferably from 95 sccm:5 sccm to 60 sccm:40 sccm, and more preferably from 90 sccm:10 sccm to 70 sccm:30 sccm.

The first mask layer etching is preferably a plasma etching, since the fabrication accuracy of the first mask layer is thereby enhanced. The plasma etching is performed using capacitively coupled RIE, inductively coupled RIE, or RIE using a biased ion attraction. For example, an etching method may be used in which $O_2$ gas alone or a gas in which $O_2$ gas and Ar are mixed in a flow ratio of between 90 sccm:10 sccm and 70 sccm:30 sccm is used, the processing pressure is set in the range of from 0.1 to 1 Pa, and capacitively coupled RIE, inductively coupled RIE, or RIE using an ion attraction voltage is used, or another method may be used.

In the fine-pattern-forming film I shown in FIG. 2B, a portion having a low vapor pressure (e.g., a sol-gel material having Ti, Zr, Ta, or the like as a metal element) included in the second mask layer 12 serves to protect a side wall of the first mask layer 13 during etching of the first mask layer 13, and as a result, the thick first mask layer 13 can easily be etched.

By etching of the first mask layer 13 using the second mask layer 12 as a mask, since the etching rate of the second mask layer 12 is less than the etching rate of the first mask layer 13, even when there is residual thickness distribution in the first mask layer 13, the residual thickness distribution of the first mask layer 13 is absorbed in the etching step, and the height of the mask constituted by the first mask layer 13 can be made uniform.

(Target object etching step)

The target object etching step is a step for etching the target object 20 using the first mask layer 13 as an etching mask, and wet etching or dry etching may be used. Dry etching is particularly preferred, since the degree of freedom of processing the target object 20 is thereby increased. From the perspective of enhancing the etching mask resistance of the first mask layer 13 during dry etching, etching can be performed using a chlorine-based gas or CFC-based gas. Oxygen gas, argon gas, or a gas mixture of oxygen gas and argon gas may be added to the chlorine-based gas.

Among gases that can be represented by the general formula $C_xH_zF_y$, for example, a gas for which x = from 1 to 4, y = from 1 to 8, and z = from 0 to 3 may be used as the CFC-based gas. Such a gas may be used singly or a mixture of a plurality of species thereof may be used.

By mixing two species of CFC-based gas having different C and F ratios (y/x) (integers in the range of $C_xH_zF_y$: x = from 1 to 4, y = from 1 to 8, z = from 0 to 3) and increasing or decreasing the deposited amount of a fluorocarbon film for protecting etched side walls of the target object 20, angles in a tapered shape can be separately created. When the mask shape of the target object 20 is to be more closely controlled by dry etching, the flow ratio of CFC gas for which $F/C \geq 3$ and CFC gas for which $F/C < 3$ is preferably from 95 sccm:5 sccm to 60 sccm:40 sccm, and more preferably from 70 sccm:30 sccm to 60 sccm:40 sccm. Examples include $CF_4$, $CHF_3$, $C_2F_6$, $C_3F_8$, $C_4F_6$, $C_4F_8$, $CH_2F_2$, and $CH_3F$. In order to enhance the etching rate of the target object 20, a gas may also be used in which at least one gas selected from the group consisting of Ar gas, $O_2$ gas, and Xe gas is mixed with a CFC-based gas in the amount of 50% or less of the total gas flow rate. In a gas mixture of $O_2$ gas or Xe gas with a gas mixture of a CFC-based gas and Ar gas, when

the chemically reactive etching component and the ion incident component are present in optimal amounts, the gas flow ratio is preferably from 99 sccm:1 sccm to 50 sccm:50 sccm, more preferably from 95 sccm: 5 sccm to 60 sccm:40 sccm, and more preferably from 90 sccm:10 sccm to 70 sccm:30 sccm, from the perspective of enhancing the etching rate of the target object 20. A mixture with a chlorine-based gas described below may also be used.

Examples of the chlorine-based gas include $Cl_2$, $BCl_3$, $CCl_4$, $PCl_3$, $SiCl_4$, HCl, $CCl_2F_2$, and $CCl_3F$. Oxygen gas, argon gas, or a gas mixture of oxygen gas and argon gas may be added to the chlorine-based gas in order to enhance the etching rate of a hardly etchable target object. In a gas mixture of $O_2$ gas or Xe gas with a gas mixture of a chlorine-based gas and Ar gas, when the chemically reactive etching component and the ion incident component are present in optimal amounts, the gas flow ratio is preferably from 99 sccm:1 sccm to 50 sccm: 50 sccm, more preferably from 99 sccm: 1 sccm to 80 sccm:20 sccm, and more preferably from 99 sccm:1 sccm to 90 sccm:10 sccm, from the perspective of enhancing the etching rate of the target object 20.

The pressure during etching is preferably from 0.1 to 20 Pa, more preferably from 0.1 to 10 Pa, because such a pressure makes it possible to increase the ion incident energy contributing to reactive etching, and to enhance the etching rate of the target object 20.

The plasma etching is performed using capacitively coupled RIE, inductively coupled RIE, or RIE using a biased ion attraction. For example, an etching method may be used in which $CHF_3$ gas alone or a gas in which $CF_4$ and $C_4F_8$ are mixed in a flow ratio of between 90 sccm:10 sccm and 60 sccm:40 sccm is used, the processing pressure is set in the range of from 0.1 to 5 Pa, and capacitively coupled RIE, inductively coupled RIE, or RIE using an ion attraction voltage is used, or another method may be used. When a chlorine-based gas, for example, is used, an etching method may be used in which $BCl_3$ gas alone or a gas in which $BCl_3$ and $Cl_2$ or Ar are mixed in a flow ratio of between 95 sccm:5 sccm and 85 sccm:15 sccm is used, the processing pressure is set in the range of from 0.1 to 10 Pa, and capacitively coupled RIE, inductively coupled RIE, or RIE using an ion attraction voltage is used, or another method may be used.

(Method for manufacturing fine-pattern-forming film)

The method for manufacturing a fine-pattern-forming film pertaining to an embodiment of the present invention will next be described.

FIG. 33 is a schematic sectional view showing the steps of the method for manufacturing a fine-pattern-forming film pertaining to the present embodiment. A first layered body I provided with a second mask layer can be manufactured by sequentially performing the steps (1-1) through (1-6) described below. The steps described below are preferably performed in roll-to-roll processing.

Step (1-1): a step for applying a curable resin composition 111 on a support base material 110 (resin coating step; see FIG. 33A).

Step (1-2): a step for pressing the applied curable resin composition 111 into a master mold 112 which has been subjected to release processing (step for pressing the resin into a mold; see FIG. 33B).

Step (1-3): a step for irradiating light from the support base material 110 side, photoradical-polymerizing the curable resin composition 111, and obtaining a cured layer 113 (step for photocuring the resin; see FIG. 33C).

Step (1-4) : a step for peeling the cured layer 113 from the master mold 112 and obtaining a concavo-convex structure provided with the inverse shape of the pattern shape of the master mold 112 (step for peeling the cured layer 113 from the mold, and step for obtaining a cover film A; see FIG. 33D).

Step (1-5): a step for coating the concavo-convex structure of the cured layer 113 with a diluted second mask layer material 114 (see FIG. 33E).

Step (1-6) : a step for drying and removing a solvent and obtaining the first layered body I provided with the second mask layer (see FIG. 33F).

By the steps (1-1) through (1-6) described above, a first layered body I comprised of the second mask layer 12 and the cover film A comprising the support base material 110 and the cured layer 113 is obtained.

In step (1-5), all of the following conditions (1) through (4) must be satisfied, particularly in order to achieve the condition lcv = 0 described below. (1) The dilution solvent must be an alcohol, ether, ketone, or other aqueous solvent. (2) The open area ratio of the cover film A must be 45% or greater, preferably 55% or greater, and most preferably 65% or greater. (3) The water contact angle CA of the surface of the concavo-convex structure of the cover film A must be CA ≥ 80°, preferably CA ≥ 90°, and more preferably CA ≥ 95°. (4) The value of Es/Eb of the cover film A must be $1 < Es/Eb \leq 30000$.

In FIG. 33, the master mold 112 is shown as being flat-plate shaped, but the master mold 112 is preferably a cylindrical roll. Using a roll on which a fine structure if provided on a cylindrical surface thereof as the master mold 112 makes it possible to manufacture the first layered body I by a continuous process. Specifically, the first layered body I can be manufactured as a long film, e.g., a molded article having a width of 300 mm and a length of 200 m, or a width

of 500 mm and a length of 500 m.

FIG. 34 is a schematic sectional view showing the steps of the method for manufacturing a fine-pattern-forming film pertaining to the present embodiment. A cover film B may be produced as shown in FIG. 34 using the cover film A obtained by step (1-4) as a mold, and the steps subsequent to step (1-4) described above may be performed using the cover film B.

Step (2-1): a step for applying a curable resin composition 116 on a support base material 115 (resin applying step; see FIG. 34A).

Step (2-2): a step for pressing the applied curable resin composition 116 to the cover film A (step for pressing the resin into a mold; see FIG. 34B).

Step (2-3): a step for irradiating light from one or both the support base material 110 side and the support base material 115 side, photoradical-polymerizing the curable resin composition 116, and obtaining a cured layer 117 (step for photocuring the resin; see FIG. 34C).

Step (2-4) : a step for peeling the cured layer 117 from the cover film A and obtaining a concavo-convex structure provided with the same shape as the pattern shape of the master mold 112 (step for peeling the mold from the cured product, and step for obtaining a cover film B; see FIG. 34D).

The coating method used in steps (1-1) and (2-1) may be roller coating, gravure coating, bar coating, die coating, spray coating, air knife coating, flow coating, curtain coating, or the like.

A step for covering (placing together) the protective and winding the first layered body I may be added after step (1-6). Photoirradiation may also be performed and curable portions included in the second mask layer 12 may be partially photopolymerized after step (1-6).

When the second mask layer 12 includes a sol-gel material, step (1-6) dries the solvent as well as condenses the sol-gel material. When a sol-gel material is included in the second mask layer 12, a step for curing after take-up may be added. Curing is preferably performed between room temperature and 120°C. A temperature range of room temperature to 105°C is particularly preferred.

A coating improvement structure may be included in the concavo-convex structure of the cover film A produced by steps (1-1) through (1-4). The coating improvement structure is arranged so as to interpose a basic structure for producing a desired mask, and the pitch of the coating improvement structure is preferably larger than the basic structure. It is particularly preferred that the pitch in the coating improvement structure gradually increase from the basic structure side to end parts of the film.

The structure and inorganic material described below are preferably used to form a structure that satisfies the lcc and lcv described hereinafter.

FIG. 35 is a schematic sectional view showing a pillar-shaped concavo-convex structure in the fine-pattern-forming film pertaining to the present embodiment. When the concavo-convex structure 11 of the first layered body I is pillar shaped, the length (lx) of the longest line segment in a face forming the top of one protrusion 11b is preferably sub-micron scale, because the diluted second mask layer material for coating thereby efficiently fills the inside of a recess 11a so that the energy of the system is reduced, and as a result, the lcv described hereinafter can be made small. In order to make the abovementioned effect more significant, it is particularly preferred that the length of the longest line segment be 500 nm or less, more preferably 300 nm or less, and most preferably 150 nm or less. A "face forming the top of one protrusion 11b" is defined as the face where the top of one protrusion 11b and a plane passing through the top positions of the protrusions 11b intersect.

The protrusions 11b preferably have a structure in which the surface area of a bottom part is larger than the surface area of the top, i.e., a structure in which each protrusion 11b is inclined, as shown in FIG. 35A, because the abovementioned can thereby be more significantly demonstrated. It is also preferred that the top and inclined parts of each protrusion 11b be continuously and smoothly connected, because the abovementioned effects can thereby be even more significantly demonstrated.

FIG. 36 is a top view showing a hole-shaped concavo-convex structure in the fine-pattern-forming film pertaining to the present embodiment. When the concavo-convex structure 11 of the first layered body I is hole shaped, for one hole (A) and the hole (B) most closely adjacent to the hole (A), the length of the shortest line segment (ly) connecting an open chasm part of the hole (A) and an open chasm part of the hole (B) is preferably sub-micron scale, because the diluted second mask layer material for coating thereby efficiently fills the inside of a recess 11a so that the energy of the system is reduced, and as a result, the lcv described hereinafter can be made small. In order to make the abovementioned effect more significant, it is particularly preferred that the length of the shortest line segment be 500 nm or less, more preferably 400 nm or less, and most preferably 300 nm or less. Within this range, the length of the shortest line segment is preferably 150 nm or less, more preferably 100 nm or less, and most preferably 0 nm. For the length of the shortest line segment to be 0 nm means that the open chasm parts of the hole (A) and the hole (B) partially overlap.

In order for the abovementioned effects to be more significantly demonstrated, the pitch P and the pitch S are

both preferably 1200 nm or less, more preferably 800 nm or less, and most preferably 500 nm or less. A pitch of 200 nm or more is preferred from the perspective of transfer properties. An open area ratio of 45% or more is preferred during coating of the concavo-convex structure 11 with the second mask layer 12 and filling of the second mask layer 12 into the recess 11a, because when the pitch is in the range of 200 nm to 800 nm, the second mask layer 12 can recognize the concavo-convex structure 11 and spread into the structure so that the curvature radius of an ideal droplet of the second mask layer 12 formed in the recess 11a is maximized. The term "ideal droplet" refers to a droplet of the second mask layer 12 that is assumed to be present in a recess 11a of the concavo-convex structure 11. An open area ratio 65% or greater is more preferred, because, in addition to the abovementioned effect, it is thereby possible to avoid a situation in which a droplet of the second mask layer 12 moves toward the top of a protrusion after the droplet has filled into a recess 11a, due to the action of a potential directed into the recess 11a from the top of a protrusion 11b of the concavo-convex structure 11. An open area of 70% or greater is desirable in order to even more significantly demonstrate the abovementioned effects. The open area is more preferably 75% or greater, and more preferably 80% or greater.

The area of the open parts of the holes is preferably greater than the area of the bottom parts of the holes, because the abovementioned effects can thereby be more significantly demonstrated. It is also preferred that the open chasms and the side faces of the recesses 11a be continuously and smoothly connected, because the abovementioned can thereby be even more significantly demonstrated.

The inorganic material constituting the second mask layer 12 preferably includes a material that changes form in the process of solvent evaporation after diluted coating, because the driving force of reducing the surface area of the material itself then acts at the same time so that the inorganic material more effectively fills into the recess 11a, and as a result, the lcv can be made small. A change in form may be an exothermic reaction or a change involving increased viscosity, for example. When a sol-gel material is included, for example, reaction occurs with airborne water vapor in the process of solvent evaporation, and the sol-gel material undergoes polycondensation. Since the energy of the sol-gel material is thereby destabilized, as a result of the action of a driving force towards receding from a solvent liquid surface (interface of solvent and air), which decreases in conjunction with solvent drying, the sol-gel material satisfactorily fills into the recesses, and the lcv described hereinafter decreases.

FIG. 37 is a schematic sectional view showing the steps of the method for manufacturing a fine-pattern-forming film pertaining to the present embodiment. Following the above mentioned steps (1-1) through (1-6), the second layered body II can be produced by performing a step (1-7) and a step (1-8). The steps described below are preferably performed in roll-to-roll processing.

Step (1-7) : a step for coating the first layered body I (layered body comprising the cover film B/second mask layer 12) with a diluted first mask layer material 120 (see FIG. 37A).

Step (1-8): a step for drying and removing the solvent, forming the first mask layer 13, and obtaining the second layered body II (see FIG. 37B).

By the steps (1-7) through (1-8) described above, a second layered body II comprised of the first mask layer 13, the second mask layer 12, and the cover film B comprising the support base material 110 and the cured layer 113 is obtained.

The coating method used in step (1-7) may be roller coating, bar coating, die coating, spray coating, air knife coating, flow coating, curtain coating, gravure coating, or the like. The first mask layer material may be diluted with a solvent and used, and may then be subjected to a drying step. A step for covering (placing together) the cover film and winding may be added after step (1-8).

In the second layered body II, the shape of the interface of the second mask layer 12 and the first mask layer 13 may be flat or curved. Curved shapes include a shape in which the second mask layer 12 bulges outward toward the first mask layer 13, a shape in which the first mask layer 13 bulges outward toward the second mask layer 12, or the like. Also included is a structure having one convex bulge from the first mask layer 13 side to the second mask layer 12 side and two convex bulges from the second mask layer 12 side to the first mask layer 13 side, or the like.

A fine mask pattern 16a having a high aspect ratio can be formed on the target object 20 through use of the second layered body II manufactured in the manner described above. The fine pattern 22 can thereby be formed on the surface of the target object 20. The methods for manufacturing the intermediate body 21, the fine mask structure body 16, and the fine pattern 22 using the second layered body II are as previously described, including in the first through fifth embodiments.

<Details of the fine-pattern-forming film>

The fine-pattern-forming film suitably used in the thermal nanoimprinting apparatus pertaining to the present

embodiment will next be described in detail. The fine-pattern-forming film is provided with a cover film provided with a nanoscale concavo-convex structure, a second mask layer provided in recesses of the concavo-convex structure, and a first mask layer provided so as to cover the concavo-convex structure and the second mask layer.

FIG. 38 is a schematic sectional view showing the fine-pattern-forming film pertaining to the present embodiment. The fine-pattern-forming film 1100 is not particularly limited insofar as the fine-pattern-forming film 1100 is a long film-shaped body in which a nanoscale concavo-convex structure 1102 is formed on one principal face of a cover film 1101, a second mask layer 1103 being provided in recesses of the concavo-convex structure 1102, and a first mask layer 1104 is provided so as to cover the second mask layer 1103 and the concavo-convex structure 1102. The fine-pattern-forming film 1100 described below, for example, may be used.

The correspondence to the fine-pattern-forming film 101 is as described below. The face laminated to the target object 104 by the rotating body 102 is the surface of the first mask layer 1104. The subject of peeling in the peeling part 206 is a cover film 1110 having the concavo-convex structure 1102, and the concavo-convex structure composed of the first mask layer 1104 and the second mask layer 1103 is transferred onto the target object 104.

In the nanoscale concavo-convex structure 1102 provided to the cover film 1101, singular (e.g., line-shaped) or multiple (e.g., dot-shaped) protrusions 1102a extending in a specific direction are provided a predetermined nanoscale interval apart from each other in the direction orthogonal to the specific direction. The protrusions protrude in the direction perpendicular to the principal face of the concavo-convex structure 1102 in a sectional view (in a section perpendicular to the orthogonal direction) along the thickness direction of the fine-pattern-forming film 1100. Recesses 1102b are formed between the protrusions 1102a. The protrusions 1102a and recessions 1102b constitute the concavo-convex structure 1102. The shape of the concavo-convex structure 1102 in the fine-pattern-forming film 1100 is not particularly limited, but may be a line-and-space structure in which a plurality of palisaded bodies are arranged, a dot structure in which a plurality of dots-shaped structures (protrusions, protuberances) are arranged, a hole structure in which a plurality of hole-shaped structures (recesses) are arranged, or the like. Examples of dot structures or hole structures include round cones, round columns, quadrangular pyramids, quadrangular columns, dual-ring-shaped structures, multiplex-ring-shaped structures and other structures.

When the performance of the first mask layer 1104 as an etching mask during etching of the target object is considered, the concavo-convex structure 1102 is preferably hole shaped. A hole shape is also preferred from the perspective of coating properties or durability of the concavo-convex structure 1102 (resistance to physical damage) during direct coating of the concavo-convex structure face of the concavo-convex structure 1102 with the second mask layer 1103.

Here, "pillar-shaped" means "a shape in which a plurality of columnar bodies (cone bodies) are arranged," and "hole-shaped" means "a shape in which a plurality of column-shaped (conical) holes are formed." In the concavo-convex structure 1102, the distance between protrusions 1102a is preferably equal to or more than 50 nm but equal to or less than 5000 nm, and the height of the protrusions 1102a is preferably equal to or more than 10 nm but equal to or less than 2000 nm. According to the application, the adjoining distance between protrusions 1102a (the interval between tops of protrusions 1102a) is preferably small, and the height of the protrusions 1102a (the height from the bottom of a recess 1102b to the top of a protrusion 1102a) is preferably large. The "protrusions 1102a" herein are regions that are higher than the average height of the concavo-convex structure 1102, and the "recesses 1102b" are regions that are lower than the average height of the concavo-convex structure 1102.

As shown in FIG. 39, with respect to a first direction D1 and a second direction D2 orthogonal to each other in a plane, an arrangement having both periodic and non-periodic properties may be adopted in which the protrusions 1102a (or recesses 1102b) are arranged at a pitch P in the first direction D1, the protrusions 1102a (or recesses 1102b) are arranged at a pitch S in the second direction D2, and there is low regularity in the phase difference $\alpha$ in the first direction D1 of the protrusions 1102a (or recesses 1102b) forming rows in the second direction D2. Since the pitch P and the pitch S can be designed, as appropriate, in accordance with the intended application, the pitch P and the pitch S may be equal, and the regularity of the phase difference $\alpha$ may be high.

In FIG. 39, the protrusions 1102a (or recesses 1102b) are depicted as being independent and having no overlap, but the protrusions 1102a (or recesses 1102b) arranged in the first direction D1 and/or the second direction D2 may overlap. The phase difference $\alpha$ is the distance (in the second direction D2) between line segments passing through the centers of protrusions 11b that are closest to each other in adjacent rows (in the first direction D1). More specifically, the phase difference $\alpha$ is the distance between a line segment in the second direction D2 passing through the center of a certain protrusion 1102a (or recess 1102b) of an $N^{th}$ row in the first direction D1 and a line segment in the second direction passing through the center of a certain protrusion 1102a (or recess 1102b) of the $(N+1)^{th}$ row at the closest distance from the protrusion 1102a (or recess 1102b), as shown in FIG. 39, for example.

For example, in the case of processing the surface of an LED sapphire substrate, GaN substrate, or Si substrate, a sapphire substrate, a GaN substrate, or a Si substrate is selected as the target object 20 (see FIG. 3A), and the concavo-convex structure shape of the concavo-convex structure 1102 is preferably a hole shape forming a regular arrangement on the nanoscale, in which the pitch is from 50 nm to 1000 nm and the height is from 50 nm to 1000 nm,

and which has significant periodic properties on the micro scale.

When the concavo-convex structure 1102 has a hole shape, for one hole (A) and the hole (B) most closely adjacent to the hole (A), the length of the shortest line segment connecting an open chasm part of the hole (A) and an open chasm part of the hole (B) is preferably sub-micron scale, because the placement precision of the second mask layer 1103 is thereby enhanced. In order to make the abovementioned effect more significant, it is particularly preferred that the length of the shortest line segment be 500 nm or less, more preferably 400 nm or less, and most preferably 300 nm or less. Within this range, the length of the shortest line segment is preferably 150 nm or less, more preferably 100 nm or less, and most preferably 0 nm. For the length of the shortest line segment to be 0 nm means that the open chasm parts of the hole (A) and the hole (B) partially overlap.

From the perspective of placement properties of the second mask layer 1103 in the recesses 1102b of the concavo-convex structure 1102 described hereinafter, the open area ratio of the concavo-convex structure 1102 is preferably 45% or greater. The open area ratio is preferably 50% or greater, more preferably 55% or greater, and more preferably 65% or greater. An open area ratio of 70% or greater is desirable. The open area ratio is more preferably 75% or greater, and more preferably 80% or greater.

The area of the open parts of the holes is preferably greater than the area of the bottom parts of the holes, because the abovementioned effects can thereby be more significantly demonstrated. It is also preferred that the open chasms and the side faces of the recesses be continuously and smoothly connected, because the abovementioned can thereby be even more significantly demonstrated.

The ratio of the area (Sh) of the recesses included in a unit area (Sc) on the concavo-convex structure 1102 in a plane parallel to the concavo-convex structure 1102 is the open area ratio. For example, in the case of a concavo-convex structure 1102 in which columnar recesses having an opening diameter (φ) of 430 nm, a pitch of 398 nm in the x-axis direction, a pitch of 460 nm in the y-axis direction, and a height (h) of 460 nm are in a hexagonal closest-packing arrangement, the ratio Sh/Sc is 0.79 (79%). Likewise, the value of (Sh/Sc) is 0.73 (73%) for a concavo-convex structure 1102 in which columnar recesses having an opening diameter (φ) of 180 nm, a pitch of 173 nm in the x-axis direction, a pitch of 200 nm in the y-axis direction, and a height (h) of 200 nm are in a hexagonal closest-packing arrangement, for example. Likewise, the value of (Sh/Sc) is 0.86 (86%) for a concavo-convex structure 1102 in which columnar recesses having an opening diameter (φ) of 680 nm, a pitch of 606 nm in the x-axis direction, a pitch of 700 nm in the y-axis direction, and a height (h) of 700 nm are in a hexagonal closest-packing arrangement, for example.

The aspect ratio indicated by the ratio (h/φ) of the height or depth (h) of the concavo-convex structure 1102 and the opening width of the recesses or the diameter (φ) of bottom parts of the protrusions is preferably in the range of 0.1 to 3.0. From the perspective of transfer accuracy, the aspect ratio is preferably 0.1 or greater, and more preferably 0.5 or greater. From the perspective of transfer accuracy of the second mask layer 1103, the aspect ratio is preferably no greater than 2.5.

The concavo-convex structure 1102 is separately provided on the cover film 1101 in the fine-pattern-forming film 1100, but the configuration is not particularly limited insofar as a nanoscale concavo-convex structure 1102 is provided on one principal face of the cover film 1101, and a concavo-convex structure may be formed by direct processing of the cover film 1101. However, from the perspective of continuously and efficiently obtaining a target object provided with a concavo-convex structure through use of the thermal nanoimprinting apparatus, a configuration in which the concavo-convex structure 1102 is separately provided on the cover film 1101 is preferred. In the description below, when the concavo-convex structure 1102 is separately provided on the cover film 1101, the cover film 1101 is referred to as a support base material.

The material of the concavo-convex structure 1102 separately provided on the support base material is not particularly limited, but from the perspective of manufacturing a cover film 1101 provided with a continuous and uniform nanoscale concavo-convex structure 1102, the material is preferably comprised of a fluorine-containing resin or a resin comprising polydimethylsiloxane (PDMS) such as silicone. Alternatively, the material is not particularly limited when a release layer is formed on the concavo-convex structure 1102, but the material is more preferably comprised of a fluorine-containing resin. The fluorine-containing resin is not particularly limited insofar as the fluorine-containing resin contains elemental fluorine and the water contact angle thereof is greater than 90 degrees. However, from the perspective of transfer accuracy during transfer of the second mask layer 1103 to the target object, the water contact angle is more preferably 95 degrees or greater, and more preferably 100 degrees or greater. A photocurable resin and a photopolymerization initiator are preferably included. The material is preferably comprised of a photocurable resin, a photopolymerization initiator, and a fluorine-based additive. The fluorine-based additive is not particularly limited, and surface improving agents and the like for imparting abrasion resistance, scratch resistance, fingerprint adhesion prevention, antifouling, leveling properties, water and oil repellency, and other properties may be used, but the molecule of the fluorine-containing additive is preferably provided with a photopolymerizable group.

A flexible material is preferred as the support base material used in the cover film 1101, and a thin-film glass, thin-film ceramic, thin-film metal, or other thin-film inorganic material, or a plastic or other organic material, for example, may be used. It is particularly preferred that the support base material include a sheet, film, thin film, textile, nonwoven

fabric, or the like having flexibility and excellent continuous production properties. Examples of flexible materials include polymethyl methacrylate resin, polycarbonate resin, polystyrene resin, cycloolefin resin (COP), crosslinked polyethylene resin, polyvinyl chloride resin, polyacrylate resin, polyphenylene ether resin, modified polyphenylene ether resin, polyetherimide resin, polyethersulfone resin, polysulfone resin, polyetherketone resin, and other amorphous thermoplastic resins; polyethylene terephthalate (PET) resin, polyethylene naphthalate resin, polyethylene resin, polypropylene resin, polybutylene terephthalate resin, aromatic polyester resin, polyacetal resin, polyamide resin, and other crystalline thermoplastic resins; and acrylic-based, epoxy-based, urethane-based, and other ultraviolet-(UV)-curable resins or thermosetting resins. An ultraviolet-curable resin or thermosetting resin, a glass or other inorganic substrate, a thermoplastic resin described above, and a triacetate resin may be combined or used singly to constitute the support base material. It is particularly preferred that the support base material be a film (reel-shaped) for the sake of enhancing laminating properties and continuously processing the target object 20.

Easy-adhesion coating, priming, corona treatment, plasma treatment, UV/ozone treatment, high-energy-ray irradiation, surface roughening, porosity-imparting treatment, and other treatments for chemical bonding with the concavo-convex structure 1102 or permeation and other physical bonding may be performed on one principal face of the cover film 1101 provided with the concavo-convex structure 1102 in order to enhance adhesion between the concavo-convex structure 1102 and the support base material of the cover film 1101.

(Fluorine-based additive)

The fluorine-containing urethane (meth)acrylate represented by Chemical Formula (1) below is cited as an example of a fluorine-containing (meth)acrylate as a fluorine-based additive provided with a photopolymerizable group in the molecule thereof, and the additive represented by Chemical Formula (1) below is preferably used, because the Es/Eb ratio described hereinafter can thereby be satisfied. "OPTOOL DAC (trademark)" manufactured by Daikin Industries, Ltd., for example, can be used as the urethane (meth)acrylate described above.

[Chemical Formula 1]

Chemical Formula (1)

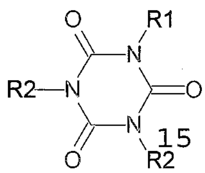

(In Chemical Formula (1), R1 represents Chemical Formula (2) below, and R2 represents Chemical Formula (3) below.)

[Chemical Formula 2]

Chemical Formula (2)

$$-(CH_2)_6-NH-\overset{O}{\overset{\|}{C}}-O-CH_2-CF_2-CF_2-(O-CF_2-CF_2-CF_2)_n-O-CF_2-CF_3$$

(In Chemical Formula (2), n is an integer of 1 to 6.)

[Chemical Formula 3]

Chemical Formula (3)

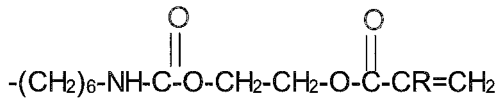

(In Chemical Formula (3), R represents H or $CH_3$.)

The fluorine concentration (Es) in a surface part of the concavo-convex structure 1102 is preferably made greater than the average fluorine concentration (Eb) in a resin layer constituting the concavo-convex structure 1102 formed on the cover film 1101. In this case, the surface of the concavo-convex structure 1102 has excellent release properties with respect to the first mask layer 1104 due to low free energy, and excellent release properties enabling repeated resin/resin transfer of nanometer-size relief shapes, and adhesion can be enhanced by maintaining high free energy near the base film.

The ratio (Es/Eb) of the average elemental fluorine concentration (Eb) in the resin constituting the concavo-convex structure 1102 and the elemental fluorine concentration (Es) in the surface part of the concavo-convex structure 1102 preferably satisfies $1 < Es/Eb \leq 30000$, because the abovementioned effects are thereby more significantly demonstrated. It is particularly preferred that the ratio (Es/Eb) be in the range $3 \leq Es/Eb \leq 1500$ or $10 \leq Es/Eb \leq 100$, because release properties are thereby further enhanced.

In the widest range ($1 < Es/Eb \leq 30000$) described above, when the range $20 \leq Es/Eb \leq 200$ is satisfied, since the elemental fluorine concentration (Es) in the surface part of the concavo-convex structure 1102 is sufficiently higher than the average fluorine concentration (Eb) in the concavo-convex structure 1102, and the free energy of the resin surface is effectively reduced, release properties with respect to the first mask layer resin or the second mask layer 1103 described hereinafter are enhanced.

The ratio (Es/Eb) is preferably in the range of $26 \leq Es/Eb \leq 189$, because the free energy of the surface of the concavo-convex structure 1102 can thereby be further reduced, and repeat transfer properties are thereby improved. It is furthermore preferred that (Es/Eb) be in the range of $30 \leq Es/Eb \leq 160$, more preferably $31 \leq Es/Eb \leq 155$, because the free energy of the concavo-convex structure surface is thereby reduced, the strength of the resin can be maintained, and the repeat transfer properties are further enhanced. The abovementioned effects can be even more significantly demonstrated when (Es/Eb) is in the range of $46 \leq Es/Eb$ 155.

A surface-side region of the concavo-convex structure 1102 is defined as a portion substantially from 1 to 10% inside in the thickness direction or from 2 nm to 20 nm inside in the thickness direction toward the reverse face side of the cover film 1101 from the exposed surface of the concavo-convex structure 1102, for example.

The abovementioned Es can be quantitatively determined by an XPS method. Since the X-ray penetration in XPS is as shallow as several nanometers, XPS is suitable for determining the Es value. Energy-dispersive X-ray spectroscopy using transmission electron microscopy (TEM-EDX) can also be used as another analysis method for computing (Es/Eb).

The abovementioned Eb can be calculated from a charge-in quantity. Alternatively, Eb can be measured using a gas chromatograph mass spectrometer (GC/MS). For example, the average elemental fluorine concentration can be identified by physically peeling the concavo-convex structure 1102 and performing gas chromatograph mass spectrometry. Meanwhile, the average elemental fluorine concentration (Eb) in the resin can be identified also by analyzing a physically peeled fragment of the concavo-convex structure 1102 by a flask combustion method and then performing ion chromatographic analysis.

The material constituting the concavo-convex structure is described below.

In the fine-pattern-forming film 1100, the second mask layer 1103 formed from a different material than the material constituting the concavo-convex structure 1102 is placed in the recesses 1102b of the concavo-convex structure 1102 of the cover film 1101, and the first mask layer 1104 is further provided so as to cover the concavo-convex structure 1102 and the second mask layer 1103. Such a second mask layer 1103 enhances the accuracy or ease of processing during processing of the target object 104 using the transferred and formed concavo-convex structure (concavo-convex structure comprised of the second mask layer 1103 and the first mask layer 1104) after the concavo-convex structure has been transferred to and formed on the target object 104. It also becomes possible to make the physical properties of top parts of the protrusions and the physical properties of the bottom parts of the protrusions different from each other in the concavo-convex structure provided on the target object 104, and to make application to a target object for extracting light to an optical device, a target object for a sensing application, or the like.

The terminology used to describe the placement of the second mask layer 1103 and the first mask layer 1104

of the fine-pattern-forming film 1100 will next be described.

The position (S) in FIG. 40 denotes the position of the tops of the protrusions 1102a of the concavo-convex structure 1102. When there is variation in the height of the concavo-convex structure 1102, the position (S) is the in-plane average position of the tops of the protrusions 1102a. The average is preferably that of ten or more points.

The position (Scc) in FIG. 40 denotes the position of the surface of the second mask layer 1103 formed in the recesses 1102b of the concavo-convex structure 1102 (the position of the interface of the second mask layer 1103 and the first mask layer 1104 shown in FIG. 38). When there is variation in the positions of the surfaces of second mask layers 1103a in the recesses 1102b, the position (Scc) denotes the in-plane average position of the surfaces of second mask layers 1103a in the recesses 1102b. The average is preferably that of ten or more points.

When the surface of the second mask layer 1103 in the recesses 1102b forms a curved face and the curved face is convex downward, the position (Scc) is determined by the location where the second mask layer 1103 has the smallest thickness. Specifically, even when the second mask layer 1103 partially adheres to inside walls of the recesses 1102b, the position (Scc) is determined by the lowest point of the second mask layer 1103. When the curved face is convex upward, the position (Scc) is determined by the location where the second mask layer 1103 has the greatest thickness.

The position (Scv) in FIG. 40 denotes the top face position of the second mask layer formed on the tops of the protrusions 1102a of the concavo-convex structure 1102 (the position of the interface of the second mask layer 1103 and the first mask layer 1104 shown in FIG. 38). When there is variation in the positions of top faces of second mask layers 1103b, the position (Scv) denotes the in-plane average position of the top faces of the second mask layers 1103b on the protrusions 1102a. The average is preferably that of ten or more points.

The distance lcc in FIG. 40 denotes the distance between the position (S) and the position (Scc). Specifically, the distance lcc denotes the value obtained by subtracting the thickness of the second mask layers 1103a in the recesses 1102b from the height h of the concavo-convex structure 1102 of the plurality of protrusions 1102a in the plane of the concavo-convex structure 1102. Consequently, when there is variation in the position (S) or the position (Scc) in the plane, the average value of the height h of the concavo-convex structure 1102 and/or the average value of the thickness of the second mask layers 1103a is used. From the perspective of fabricating the mask pattern after transferring the mask pattern to the target object 20, and obtaining a mask pattern (fine mask pattern) 16a having a high aspect ratio, the distance lcc is preferably in the range satisfying $lcc < 1.0h$.

From the perspective of dry-etching resistance and ease of transfer of the second mask layer 1103, $lcc \leq 0.9h$ is desired. More preferably, $lcc \leq 0.7h$, and even more preferably, $lcc \leq 0.6h$.

From the perspective of reducing variation of the lcc in the plane, the lcc is preferably in a range satisfying $0 < lcc$, and more preferably $0.02h \leq lcc$. A range satisfying $0.05h \leq lcc$ is more preferred, and $0.1h \leq lcc$ is particularly preferred.

Since the pressing force during laminating of the fine-pattern-forming film 1100 to the target object can be reduced by satisfying such a range for the lcc of the second mask layer 1103, the pressing step and the energy-ray irradiation step can be performed independently.

The distance lcv in FIG. 40 denotes the distance between the position (S) and the position (Scv). Specifically, the distance lcv denotes the in-plane thickness of the second mask layers 1103b on the protrusions 1102a of the concavo-convex structure 1102. Consequently, when there is in-plane variation of the position (S) or the position (Scv), the average value of the thickness of the second mask layers 1103b is used. From the perspective of width reduction of the second mask layers 1103b due to dry etching, the lcv preferably satisfies the relation $lcv \leq 0.05h$. Preferably, $lcv \leq 0.02h$, more preferably $lcv \leq 0.01h$, because the second mask layers 1103b having a film thickness of lcv are thereby more easily removed. Most preferably, $lcv = 0$, since there is then no need to remove the second mask layer having a film thickness of lcv by dry etching.

What is formed on the surface of the target object having the concavo-convex structure is the second mask layer 1103/first mask layer 1104, and therefore, the first mask layer 1104 and the second mask layer 1103 provided with the concavo-convex structure are formed on the target object. The material constituting the second mask layer 1103 preferably includes at least one metal element selected from the group consisting of Ti, Si, Zr, and Zn, and preferably includes a molecule provided with a photopolymerizable group, and a sol-gel material such as a metal alkoxide. For example, the material is preferably comprised of a silane coupling agent provided with a photopolymerizable group and a metal alkoxide having Ti or Zr as a metal species, a photopolymerization initiator, or the like.

The distance (lor) between the protrusion top position (S) of the concavo-convex structure 1102 and the exposed face of the first mask layer 1104 (or the face thereof in contact with the protective layer) satisfies the relationship $0.05 \leq lor/P \leq 5$ with the pitch (P) of the concavo-convex structure 1102. As described above, since the pitch is preferably from 50 nm to 1000 nm, the distance (lor) between the protrusion top position (S) of the concavo-convex structure 1102 and the exposed face of the first mask layer 1104 (or the face thereof in contact with the protective layer) is preferably equal to or more than 2.5 nm but equal to or less than 5000 nm. Particularly through use of the thermal nanoimprinting apparatus pertaining to the present embodiment, laminating can easily be performed on the target object 104, and the second mask layer 1103 and first mask layer 1104 can be transferred even in a state in which the distance (lor) is as

small as equal to or more than 5 nm but equal to or less than 1000 nm. Particularly from the perspective of enhancing laminating precision, laminating speed, peeling precision, and peeling speed, besides the apparatus specifications described above, the distance (lor) is preferably equal to or more than 5 nm but equal to or less than 1000 nm, and more preferably equal to or more than 10 nm but equal to or less than 800 nm. In the widest range (equal to or more than 2.5 nm but equal to or less than 5000 nm) mentioned above, from the perspective of the effect of the second mask layers 1103b placed on the tops of the protrusions 1102a of the concavo-convex structure 1102 on laminating properties of the fine-pattern-forming film 1100, a range of $lcv < lor \leq 1500$ nm is preferred, a range of $lcv + 100$ nm $\leq lor \leq 1000$ nm is more preferred, and a range of $lcv + 150$ nm $\leq lor \leq 1000$ nm is even more preferred. From the perspective of physical stability during dry etching, the thickness of the first mask layer 1104 is most preferably in the range of $lcv + 200$ nm $\leq lor \leq 700$ nm. Particularly, $lcv = 0$ is preferred, because adhesion (laminating) properties and processing properties of the target object are thereby enhanced. In this case, the thickness of the first mask layer 1104 (lor) when $lcv = 0$ becomes the distance between the position (S) and the position (Sb) of the exposed surface of the first mask layer 1104.

The ratio (Vo1/Vm1) of the etching rate (Vm1) of the second mask layer 1103 and the etching rate (Vo1) of the first mask layer 1104 by dry etching affects the fabrication accuracy during etching of the first mask layer 1104 using the second mask layer 1103 as a mask. Since a state of $Vo1/Vm1 > 1$ means that the second mask layer 1103 is less readily etched than the first mask layer 1104, the ratio Vo1/Vm1 is preferably as large as possible. From the perspective of coating properties of the second mask layer 1103, $Vo1/Vm1 \leq 150$ is preferred, and $Vo1/Vm1 \leq 100$ is more preferred. From the perspective of etching resistance, $3 \leq Vo1/Vm1$ is preferred, $10 \leq Vo1/Vm1$ is more preferred, and $15 \leq Vo1/Vm1$ is more preferred.

Satisfying the abovementioned range makes it possible to easily micro-fabricate a thick first mask layer 1104 by dry etching using the second mask layer 1103 as a mask. Even when there is a thickness distribution in the first mask layer 1104, since the etching rate of the second mask layer 1103 is less than the etching rate of the first mask layer 1104, the thickness distribution of the first mask layer 1104 can be absorbed. A mask pattern (fine mask pattern) 16a having a high aspect ratio comprising the first mask layer 1104 and the second mask layer 1103 micro-fabricated by dry etching can thereby be formed on the target object 20. The target object 20 can easily be dry etched through use of such a mask (second mask layer 1103 and first mask layer 1104) having a high aspect ratio.

The ratio ($Vo_{\perp}/Vo_{//}$) of the etching anisotropy (etching rate ($Vo_{//}$) in the transverse direction) and the etching rate ($Vo_{\perp}$) in the longitudinal direction during etching of the first mask layer 1104 preferably satisfies $Vo_{\perp}/Vo_{//} > 1$, and is more preferably as large as possible. According to the ratio of the etching rate of the first mask layer 1104 and the etching rate of the target object 20, $Vo_{\perp}/Vo_{//} \geq 2$ is preferred, $Vo_{\perp}/Vo_{//} \geq 3.5$ is more preferred, and $Vo_{\perp}/Vo_{//} \geq 10$ is more preferred. "Longitudinal direction" means the thickness direction of the first mask layer 1104, and "transverse direction" means the face direction of the first mask layer 1104.

In a region where the pitch is sub-micron or less, a large width must be maintained in the first mask layer 1104 in order to easily dry etch the target object 20. The abovementioned range is preferably satisfied, because it is thereby possible to maintain a large width (trunk thickness) in the first mask layer 1104 after dry etching.

The ratio (Vo2/Vi2) of the etching rate (Vi2) of the target object 20 and the etching rate (Vo2) of the first mask layer 1104 by dry etching is preferably as small as possible. When $Vo2/Vi2 < 1$, since the etching rate of the first mask layer 1104 is less than the etching rate of the target object 20, the target object 20 can easily be processed. From the perspective of etching precision and coating properties of the first mask layer 1104, $Vo2/Vi2 \leq 3$ is preferred, and $Vo2/Vi2 \leq 2.5$ is more preferred. Preferably, $Vo2/Vi2 \leq 2$, since the thickness of the first mask layer 1104 can thereby be reduced. Most preferably, $Vo2/Vi2 < 1$.

From the perspective of bonding properties with the target object 104, the first mask layer 1104 preferably includes a reactive diluent and a polymerization initiator, and particularly a binder resin, a reactive diluent, and a polymerization initiator. It is particularly preferred that the first mask layer 1104 include a photopolymerization initiator, a (meth)acrylate, and a binder resin including a site having a benzene skeleton in at least a side chain thereof.

The material of the target object 104 is not particularly limited and may be selected, as appropriate, according to application. Examples thereof include a quartz such as synthetic quartz or fused quartz; glasses such as non-alkali glass, low-alkali glass, and soda lime glass; and silicon wafers, nickel sheets, sapphire, diamond, SiC substrates, mica substrates, semiconductor substrates (nitride semiconductor substrates and the like), ZnO, and ITO. When a flexible fine-pattern-forming film is selected, a target object 20 having a curved outline (e.g., a lens shape, cylindrical shape, columnar shape, or spherical shape) may also be selected. Sapphire or Si, for example, may be selected in the case of improving the internal quantum efficiency and light extraction efficiency of an LED. A nitride semiconductor such as GaN may be selected for the purpose of improving light extraction efficiency. A widely known commercially available glass may also be selected for the purpose of imparting an antireflective function (transmittance-increasing function).

The target object 20 is flat-plate shaped or lens shaped, but a flat-plate shape is preferred from the perspective of enhancing laminating precision and laminating speed. A flat-plate-shaped target object may be a two-inch-diameter sapphire wafer, a four-inch-diameter sapphire wafer, a six-inch-diameter sapphire wafer, or the like, for example.

Among the materials for constituting the concavo-convex structure 1102, a curable resin composition that is a

mixture of non-fluorine-containing (meth)acrylate, fluorine-containing (meth)acrylate, and a photopolymerization initiator is preferably used as a photopolymerizable radical-polymerization-type resin. Through use of this curable resin composition, when the composition is cured in a state in which the composition is in contact with a hydrophobic interface or the like having low surface free energy, the elemental fluorine concentration (Es) in the surface part of the concavo-convex structure 1102 can be made greater than the average elemental fluorine concentration (Eb) in the resin constituting the concavo-convex structure 1102, and the average elemental fluorine concentration (Eb) in the resin can also be adjusted to a smaller value.

(A) (Meth) acrylate

The (meth) acrylate is not limited insofar as the (meth)acrylate is a polymerizable monomer other than the fluorine-containing (meth)acrylate of (B) described hereinafter, but monomers having an acryloyl group or a methacryloyl group, monomers having a vinyl group, and monomers having an allyl group are preferred, and monomers having an acryloyl group or a methacryloyl group are more preferred. These monomers are preferably non-fluorine-containing monomers. (Meth)acrylate means acrylate or methacrylate.

The polymerizable monomer is preferably a polyfunctional monomer provided with a plurality of polymerizable groups, and the number of polymerizable groups is preferably an integer of from 1 to 4, since excellent polymerizability is thereby obtained. When a mixture of two or more types of polymerizable monomers is used, the average number of polymerizable groups is preferably from 1 to 3. When a single monomer is used, the number of polymerizable groups in the monomer is preferably 3 or greater in order to increase the number of crosslinking points after polymerization and obtain physical stability (strength, heat resistance, and other properties) in the cured product. When the number of polymerizable groups in the monomer is 1 or 2, the monomer is preferably used jointly with a monomer having a different number of polymerizable groups.

The compounds listed below are cited as specific examples of (meth)acrylate monomers. Monomers having an acryloyl group or a methacryloyl group include (meth)acrylic acid and aromatic (meth)acrylates [phenoxyethyl acrylate, benzyl acrylate, and the like], hydrocarbon (meth)acrylates [stearyl acrylate, lauryl acrylate, 2-ethylhexyl acrylate, allyl acrylate, 1,3-butanediol diacrylate, 1,4-butanediol diacrylate, 1,6-hexanediol diacrylate, trimethylolpropane triacrylate, pentaerythritol triacrylate, dipentaerythritol hexa-acrylate, and the like], hydrocarbon (meth)acrylates containing an etheric oxygen atom [ethoxyethyl acrylate, methoxyethyl acrylate, glycidyl acrylate, tetrahydrofurfuryl acrylate, diethylene glycol diacrylate, neopentyl glycol diacrylate, polyoxyethylene glycol diacrylate , tripropylene glycol diacrylate, and the like] hydrocarbon (meth)acrylates including a functional group [2-hydroxyethyl acrylate, 2-hydroxypropyl acrylate, 4-hydroxybutyl vinyl ether, N,N-diethylaminoethyl acrylate, N,N-dimethylaminoethyl acrylate, N-vinylpyrrolidone, dimethylaminoethyl methacrylate, and the like], silicone-based acrylates, and the like. Other examples include EO-modified glycerol tri(meth)acrylate, ECH-modified glycerol tri(meth)acrylate, PO-modified glycerol tri(meth)acrylate, pentaerythritol triacrylate, EO-modified phosphoric acid triacrylate, trimethylolpropane tri(meth)acrylate, caprolactone-modified trimethylolpropane tri(meth)acrylate, PO-modified trimethylolpropane tri(meth)acrylate, tris(acryloxyethyl)isocyanurate, EO-modified trimethylolpropane tri(meth)acrylate, dipentaerythritol hexa(meth)acrylate, caprolactone-modified dipentaerythritol hexa(meth)acrylate, dipentaerythritol hydroxypenta(meth)acrylate, alkyl modified dipentaerythritol penta(meth)acrylate, dipentaerythritol poly(meth)acrylate, ditrimethylolpropane tetra(meth)acrylate, alkyl-modified dipentaerythritol tri(meth)acrylate, pentaerythritol ethoxytetra(meth)acrylate, pentaerythritol tetra(meth)acrylate, diethylene glycol monoethyl ether (meth)acrylate, dimethylol dicyclopentane di(meth)acrylate, di(meth)acrylated isocyanurate, 1,3-butylene glycol di(meth)acrylate, 1,4-butanediol di(meth)acrylate, EO-modified 1,6-hexanediol di(meth)acrylate, ECH-modified 1,6-hexanediol di(meth)acrylate, allyloxy polyethylene glycol acrylate, 1,9-nonanediol di(meth)acrylate, EO-modified bisphenol A di(meth)acrylate, PO-modified bisphenol A di(meth)acrylate, modified bisphenol A di(meth)acrylate, EO-modified bisphenol F di(meth)acrylate, ECH-modified hexahydrophthalic acid diacrylate, neopentyl glycol di(meth)acrylate, hydroxy pivalic acid neopentyl glycol di(meth)acrylate, EO modified neopentyl glycol diacrylate, PO-modified neopentyl glycol diacrylate, caprolactone-modified hydroxy pivalic acid ester neopentyl glycol, stearic acid-modified pentaerythritol di(meth)acrylate, ECH-modified propylene glycol di(meth)acrylate, ECH-modified phthalic acid di(meth)acrylate, poly(ethylene glycol-tetramethylene glycol) di(meth)acrylate, poly(propylene glycol-tetramethylene glycol) di(meth)acrylate, polypropylene glycol di(meth)acrylate, silicone di(meth)acrylate , tetraethylene glycol di(meth)acrylate, triethylene glycol di(meth)acrylate, polyester (di)acrylate, polyethylene glycol di(meth)acrylate, dimethylol tricyclodecane di(meth)acrylate, neopentyl glycol-modified trimethylolpropane di(meth)acrylate, dipropylene glycol di(meth)acrylate, tripropylene glycol di(meth)acrylate, triglycerol di(meth)acrylate, EO-modified tripropylene glycol di(meth)acrylate, divinyl ethylene urea, divinyl propylene urea, 2-ethyl-2-butylpropanediol acrylate, 2-ethylhexyl (meth) acrylate, 2-ethylhexylcarbitol (meth)acrylate, 2-hydroxyethyl (meth)acrylate, 2-hydroxypropyl (meth)acrylate, 2-hydroxybutyl (meth)acrylate, 2-methoxyethyl (meth)acrylate, 3-methoxybutyl (meth)acrylate, 4-hydroxybutyl (meth)acrylate, acrylic acid dimer, benzyl (meth)acrylate, butanediol mono(meth)acrylate, butoxyethyl (meth)acrylate, butyl (meth)acrylate, cetyl (meth)acrylate, EO-modified cresol (meth) acrylate, ethoxylated phenyl (meth)acrylate, ethyl (meth)acrylate,

dipropylene glycol (meth)acrylate, isoamyl (meth)acrylate, isobutyl (meth)acrylate, isooctyl (meth)acrylate, cyclohexyl (meth)acrylate, dicyclopentanyl (meth)acrylate, isobornyl (meth)acrylate, dicyclopentanyl oxyethyl (meth)acrylate, isomyristyl (meth)acrylate, lauryl (meth)acrylate, methoxy dipropylene glycol (meth)acrylate, methoxy polyethylene glycol (meth)acrylate, methoxy triethylene glycol (meth)acrylate, methyl (meth)acrylate, methoxy tripropylene glycol (meth)acrylate, neopentyl glycol benzoate (meth)acrylate, nonyl phenoxy polyethylene glycol (meth)acrylate, nonyl phenoxy polypropylene glycol (meth)acrylate, octyl (meth)acrylate, paracumylphenoxyethylene glycol (meth)acrylate, ECH-modified phenoxy acrylate, phenoxy diethylene glycol (meth)acrylate, phenoxy hexaethylene glycol (meth)acrylate, phenoxy tetraethylene glycol (meth)acrylate, phenoxyethyl (meth)acrylate, polyethylene glycol (meth)acrylate, polyethylene glycol-polypropylene glycol (meth)acrylate, polypropylene glycol (meth)acrylate, stearyl (meth)acrylate, EO-modified succinic acid (meth)acrylate, tert-butyl (meth)acrylate, tribromophenyl (meth)acrylate, EO-modified tribromophenyl (meth)acrylate, tridodecyl (meth)acrylate, isocyanuric acid EO-modified di- and triacrylate, ε-caprolactone-modified *tris*(acroxyethyl) isocyanurate, ditrimethylolpropane tetraacrylate, and the like. Examples of a monomer having an allyl group include p-isopropenylphenol, and examples of monomers having a vinyl group include styrene, α-methyl styrene, acrylonitrile, vinyl carbazole, and the like. "EO-modified" means "ethylene-oxide-modified," "ECH-modified" means "epichlorohydrin-modified," and "PO-modified" means "propylene-oxide-modified."

(B) Fluorine-containing (meth)acrylate

The fluorine-containing (meth)acrylate preferably has a polyfluoroalkylene chain and/or a perfluoro(polyoxyalkylene) chain and a polymerizable group, and a straight-chain perfluoroalkylene group or a perfluorooxyalkylene group which has a trifluoromethyl group in a side chain thereof and in which an etheric oxygen atom is inserted between a carbon atom and a carbon atom is more preferred. A straight-chain polyfluoroalkylene chain and/or a straight-chain perfluoro(polyoxyalkylene) chain having a trifluoromethyl group in a side chain or terminal end of the molecular structure thereof is particularly preferred.

The polyfluoroalkylene chain is preferably a carbon number of from 2 to 24 polyfluoroalkylene group. The polyfluoroalkylene group may also have a functional group.

The perfluoro(polyoxyalkylene) chain preferably comprises one or more species of perfluoro(oxyalkylene) units selected from the group consisting of ($CF_2CF_2O$) units, ($CF_2CF(CF_3)O$) units, ($CF_2CF_2CF_2O$) units, and ($CF_2O$) units, and more preferably comprises ($CF_2CF_2O$) units, ($CF_2CF$ ($CF_3$)O) units, or ($CF_2CF_2CF_2O$) units. Since a fluorine-containing polymer has excellent physical properties (heat resistance, acid resistance, and the like), it is particularly preferred that the perfluoro(polyoxyalkylene) chain comprise ($CF_2CF_2O$) units. Since a fluorine-containing polymer has high release properties and hardness, the number of perfluoro(oxyalkylene) units is preferably an integer of from 2 to 200, and more preferably an integer of from 2 to 50.

The polymerizable group is preferably a vinyl group, an allyl group, an acryloyl group, a methacryloyl group, an epoxy group, a dioctacene group, a cyano group, an isocyanate group or a hydrolyzable silyl group represented by the formula-$(CH_2)aSi(M1)_{3-b}(M2)_b$, and an acryloyl group or a methacryloyl group is more preferred. Here, M1 is a substituent which is converted to a hydroxyl group by hydrolysis. Examples of such a substituent include, a halogen atom, an alkoxy group, an acyloxy group, and the like. The halogen atom is preferably a chlorine atom. A methoxy group or an ethoxy group is preferred as the alkoxy group, and a methoxy group is more preferred. An alkoxy group is preferred as M1, and a methoxy group is more preferred. In the formula, M2 is a monovalent hydrocarbon group. Examples of M2 include an alkyl group substituted with one or more aryl groups, an alkenyl group, an alkynyl group, a cycloalkyl group, an aryl group, and the like, and an alkyl group or an alkenyl group is preferred. When M2 is an alkyl group, a carbon number of from 1 to 4 alkyl group is preferred, and a methyl group or an ethyl group is more preferred. When M2 is an alkenyl group, a carbon number of from 2 to 4 alkenyl group is preferred, and a vinyl group or an allyl group is more preferred. In the formula, a is an integer of from 1 to 3, preferably 3, and b is 0 or an integer of from 1 to 3, and is preferably 0. The hydrolyzable silyl group is preferably $(CH_3O)_3SiCH_2$-, $(CH_3CH_2O)_3SiCH_2$-, $(CH_3O)_3Si(CH_2)_3$-, or $(CH_3CH_2O)_3Si(CH_2)_3$-.

The number of polymerizable groups is preferably an integer of from 1 to 4, more preferably an integer of from 1 to 3, since excellent polymerizability is thereby obtained. When two or more compounds are used, the average number of polymerizable groups is preferably from 1 to 3.

When the fluorine-containing (meth)acrylate has a functional group, excellent bonding properties with a transparent substrate are obtained. The functional group may be a carboxyl group, a sulfonic acid group, a functional group having an ester bond, a functional group having an amide bond, a hydroxyl group, an amino group, a cyano group, a urethane group, an isocyanate group, a functional group having an isocyanuric acid derivative, or the like. It is particularly preferred that at least one of a carboxyl group, a urethane group, and a functional group having an isocyanuric acid derivative be included. An isocyanuric acid derivative encompasses derivatives having an isocyanuric acid skeleton and having a structure in which at least one hydrogen atom bonded to a nitrogen atom is substituted by another group. A fluoro(meth)acrylate, a fluorodiene, or the like may be used as the fluorine-containing (meth)acrylate. The compounds

listed below are cited as specific examples of the fluorine-containing (meth)acrylate.

Examples of fluoro(meth)acrylates include fluoro (meth) acrylates such as $CH_2=CHCOO(CH_2)_2(CF_2)_{10}F$, $CH_2=CHCOO(CH_2)_2(CF_2)_8F$, $CH_2=CHCOO(CH_2)_2(CF_2)_6F$, $CH_2=C(CH_3)COO(CH_2)_2(CF_2)_{10}F$, $CH_2=C(CH_3)COO(CH_2)_2(CF_2)_8F$, $CH_2=C(CH_3)COO(CH_2)_2(CF_2)_6F$, $CH_2=CHCOOCH_2(CF_2)_6F$, $CH_2=C(CH_3)COOCH_2(CF_2)_6F$, $CH_2=CHCOOCH_2(CF_2)_7F$, $CH_2=C(CH_3)COOCH_2(CF_2)_7F$, $CH_2=CHCOOCH_2CF_2CF_2H$, $CH_2=CHCOOCH_2(CF_2CF_2)_2H$, $CH_2=CHCOOCH_2(CF_2CF_2)_4H$, $CH_2=C(CH_3)COOCH_2(CF_2CF_2)H$, $CH_2=C(CH_3)COOCH_2(CF_2CF_2)_2H$, $CH_2=C(CH_3)COOCH_2(CF_2CF_2)_4H$, $CH_2=CHCOOCH_2CF_2OCF_2CF_2OCF_3$, $CH_2=CHCOOCH_2CF_2O(CF_2CF_2O)_3CF_3$, $CH_2=C(CH_3)COOCH_2CF_2OCF_2CF_2OCF_3$, $CH_2=C(CH_3)COOCH_2CF_2O(CF_2CF_2O)_3CF_3$, $CH_2=CHCOOCH_2CF(CF_3)OCF_2CF(CF_3)O(CF_2)_3F$, $CH_2=CHCOOCH_2CF(CF_3)O(CF_2CF(CF_3)O)_2(CF_2)_3F$, $CH_2=C(CH_3)COOCH_2CF(CF_3)OCF_2CF(CF_3)O(CF_2)_3F$, $CH_2=C(CH_3)COOCH_2CF(CF_3)O(CF_2CF(CF_3)O)_2(CF_2)_3F$ , $CH_2=CFCOOCH_2CH(OH)CH_2(CF_2)_6CF(CF_3)_2$, $CH_2=CFCOOCH_2CH(CH_2OH)CH_2(CF_2)_6CF(CF_3)_2$, $CH_2=CFCOOCH_2CH(OH)CH_2(CF_2)_{10}F$, $CH_2=CFCOOCH_2CH(OH)CH_2(CF_2)_{10}F$, $CH_2=CHCOOCH_2CH_2(CF_2CF_2)_3CH_2CH_2OCOCH=CH_2$, $CH_2=C(CH_3)COOCH_2CH_2(CF_2CF_2)_3CH_2CH_2OCOC(CH_3)=CH_2$, $CH_2=CHCOOCH_2CyFCH_2OCOCH=CH_2$, and $CH_2=C(CH_3)COOCH_2CyFCH_2OCOC(CH_3)=CH_2$ (where CyF represents a perfluoro(1,4-cyclohexylene) group).

Examples of fluorodienes include fluorodienes such as $CF_2=CFCF_2CF=CF_2$, $CF_2=CFOCF_2CF=CF_2$, $CF_2=CFOCF_2CF_2CF=CF_2$, $CF_2=CFOCF(CF_3)CF_2CF=CF_2$, $CF_2=CFOCF_2CF(CF_3)CF=CF_2$, $CF_2=CFOCF_2OCF=CF_2$, $CF_2=CFOCF_2CF(CF_3)OCF_2CF=CF_2$, $CF_2=CFCF_2C(OH)(CF_3)CH_2CH=CH_2$, $CF_2=CFCF_2C(OH)(CF_3)CH=CH_2$, $CF_2=CFCF_2C(CF_3)(OCH_2OCH_3)CH_2CH=CH_2$, and $CF_2=CFCH_2C(C(CF_3)_2OH)(CF_3)CH_2CH=CH_2$.

(Fluorine-containing (meth)acrylate)

The fluorine-containing (meth)acrylate used in the present invention is preferably a fluorine-containing urethane (meth)acrylate represented by Chemical Formula (1) above, because the elemental fluorine concentration (Es) in the surface part of the concavo-convex structure can thereby be effectively increased in a state in which the average elemental fluorine concentration (Eb) in the resin is reduced, and adhesion and release properties with respect to the target object can be even more effectively realized. "OPTOOL DAC" manufactured by Daikin Industries, Ltd., for example, can be used as such a urethane (meth)acrylate.

A single species of fluorine-containing (meth)acrylate may be used independently, or two or more species thereof may be jointly used. The fluorine-containing (meth)acrylate may also be used jointly with a surface improving agent for imparting abrasion resistance, scratch resistance, fingerprint adhesion prevention, antifouling, leveling properties, water and oil repellency, and other properties. Examples of surface-improving agents include "FTERGENT" (e.g., M Series: FTERGENT 251, FTERGENT 215M, FTERGENT 250, FTX-245M, and FTX-290M; S Series: FTX-207S, FTX-211S, FTX-220S, and FTX-230S; F Series: FTX-209F, FTX-213F, FTERGENT 222F, FTX-233F, and FTERGENT 245F; G Series: FTERGENT 208G, FTX-218G, FTX-230G, and FTS-240G; oligomer series: FTERGENT 730FM and FTERGENT 730LM; FTERGENT P Series: FTERGENT 710FL, FTX-710HL, etc.) manufactured by Neos Corporation; "MEGAFAC" (e.g., F-114, F-410, F-493, F-494, F-443, F-444, F-445, F-470, F-471, F-474, F-475, F-477, F-479, F-480SF, F-482, F-483, F-489 , F-172D, F-178K, F-178RM, MCF-350SF, etc.) manufactured by DIC Corporation; "OPTOOL™" (e.g., DSX, DAC, and AES), "FTONE™" (e.g., AT-100), "ZEFFLE™" (e.g. , , GH-701), "UNIDYNE™, " "DAIFREE™, " and "OPTOACE™, " manufactured by Daikin Industries Ltd.; "Novec EGC-1720," manufactured by Sumitomo 3M Ltd.; "FLUOROSURF," manufactured by Fluoro Technology Co., Ltd.; and the like.

The fluorine-containing (meth)acrylate preferably has a molecular weight Mw of from 50 to 50000, and from the perspective of compatibility, the molecular weight Mw is preferably from 50 to 5000, and more preferably from 100 to 5000. When a low-compatibility high molecular weight is used, a dilution solvent may be used. In the dilution solvent, the boiling point of the solvent alone is preferably from 40°C to 180°C, more preferably from 60°C to 180°C, and more preferably from 60°C to 140°C. Two or more types of diluents may be used.

The solvent content should at least be an amount that disperses in the curable resin composition, and preferably ranges from exceeded zero parts by weight to 50 parts by weight with respect to 100 parts by weight of the curable composition. In order to remove as much of the residual solvent as possible after drying, the solvent content preferably ranges from exceeded zero parts by weight to 10 parts by weight.

When a solvent is contained in order to enhance leveling properties, the solvent content is preferably equal to or more than 0.1 parts by weight but equal to or less than 40 parts by weight with respect to 100 parts by weight of the (meth)acrylate. The solvent content is more preferably equal to or more than 0.5 parts by weight but equal to or less than 20 parts by weight, more preferably equal to or more than 1 part by weight but equal to or less than 15 parts by weight, because the curing properties of a photopolymerizable mixture can thereby be maintained. When a solvent is contained in order to reduce the film thickness of the photopolymerizable mixture, the solvent content is preferably equal to or more than 300 parts by weight but equal to or less than 10000 parts by weight, more preferably equal to or more

than 300 parts by weight but equal to or less 1000 parts by weight with respect to 100 parts by weight of the (meth)acrylate, because it is thereby possible to maintain solution stability in the drying step after coating.

(C) Photopolymerization initiator

The photopolymerization initiator brings about radical reaction or ion reaction by light, and a photopolymerization initiator that brings about radical reaction is preferred. The photopolymerization initiators listed below are cited as examples of the photopolymerization initiator.

Acetophenone-based photopolymerization initiators include acetophenone, p-tert-butyltrichloroacetophenone, chloroacetophenone, 2,2-diethoxyacetophenone, hydroxyacetophenone, 2,2-dimethoxy-2'-phenylacetophenone, 2-amino-acetophenone, dialkyl aminoacetophenone and the like. Benzoin-based photopolymerization initiators include benzyl, benzoin, benzoin methyl ether, benzoin ethyl ether, benzoin isopropyl ether, benzoin isobutyl ether, 1-hydroxycyclohexyl phenyl ketone, 2-hydroxy-2-methyl-1-phenyl-2-methylpropane-1-one, 1-(4-isopropylphenyl)-2-hydroxy-2-methylpropane-1-one, benzyl dimethyl ketal, and the like. Benzophenone-based photopolymerization initiators include benzophenone, benzoylbenzoic acid, benzoyl methyl benzoate, methyl-o-benzoylbenzoate, 4-phenylbenzophenone, hydroxybenzophenone, hydroxypropyl benzophenone, acryl benzophenone, 4,4-bis(dimethylamino)benzophenone, perfluoroalkyl benzophenone, and the like. Thioxanthone-based photopolymerization initiators include thioxanthone, 2-chlorothioxanthone, 2-methylthioxanthone, diethyl thioxanthone, dimethyl thioxanthone, and the like. Anthraquinone-based photopolymerization initiators include 2-methyl anthraquinone, 2-ethyl anthraquinone, 2-tert-butyl anthraquinone, 1-chloroanthraquinone, and 2-amylanthraquinone. Ketal-based photopolymerization initiators include acetophenone dimethyl ketal and benzyl dimethyl ketal. Other photopolymerization initiators include $\alpha$-acyl oxime ester, benzyl-(o-ethoxycarbonyl)-$\alpha$-monoxime, acyl phosphine oxide, glyoxy ester, 3-ketocoumarin, 2-ethyl anthraquinone, camphorquinone, tetramethyl thiuram sulfide, azobisisobutyronitrile, benzoyl peroxide, dialkyl peroxide, tert-butylperoxy pivalate, and the like. Photopolymerization initiators having a fluorine atom include perfluoro tert-butyl peroxide, perfluoro benzoyl peroxide, and the like. Publicly known, commonly used photopolymerization initiators may be used singly or in combinations of two or more species thereof.

The photopolymerizable mixture may include a photosensitizer. Specific examples of the photosensitizer include publicly known, commonly used photosensitizers such as n-butylamine, di-n-butylamine, tri-n-butyl phosphine, allylthiourea, s-benzylisothiuronium-p-toluene sulfinate, triethylamine, diethylaminoethyl methacrylate, triethylene tetramine, 4,4-bis(dialkylamino)benzophenone, N,N-dimethylamino benzoic acid ethyl ester, N,N-dimethylamino benzoic acid isoamyl ester, pentyl-4-dimethylamino benzoate, triethylamine, triethanolamine, and other amines. These photopolymerization initiators may be used singly or in combinations of two or more species thereof.

Examples of commercially available initiators include "Irgacure (registered trademark)" (e.g., Irgacure 651, 184, 500, 2959, 127, 754, 907, 369, 379, 379EG, 819, 1800, 784, 026E01, and O26E02) or "Darocur (registered trademark)" (e.g., Darocur 1173, MBF, TPO, 4265) manufactured by BASF Japan Ltd., and the like.

One species of photopolymerization initiator may be used singly, or two or more types thereof may be jointly used. When two or more types are jointly used, the photopolymerization initiators are selected from the perspective of dispersion properties of the fluorine-containing (meth)acrylate and curability of the photopolymerizable mixture inside and on the surface part of the concavo-convex structure. For example, an $\alpha$-hydroxyketone-based photopolymerization initiator and an $\alpha$-aminoketone-based photopolymerization initiator may be jointly used. The combination of photopolymerization initiators when two types thereof are used may be two types of "Irgacure" or a combination of "Irgacure" and "Darocur" manufactured by BASF Japan Ltd., and examples of combinations include Darocur 1173 and Irgacure 819, Irgacure 379 and Irgacure 127, Irgacure 819 and Irgacure 127, Irgacure 250 and Irgacure 127, Irgacure 184 and Irgacure 369, Irgacure 184 and Irgacure 379EG, Irgacure 184 and Irgacure 907, Irgacure 127 and Irgacure 379EG, Irgacure 819 and Irgacure 184, and Darocur TPO and Irgacure 184.

(Second mask layer)

An inorganic precursor, inorganic condensation product, metal oxide filler, metal oxide microparticles, or the like which can be diluted in a solvent can be used for the material of the second mask layer 1103. From the perspective of transfer accuracy during transfer of a mask to the target object 20 on which a mask is to be formed using the fine-pattern-forming film 1100, it is particularly preferred that the second mask layer 1103 include one or both of a polymerizable group capable of photopolymerization and a polymerizable group capable of thermal polymerization. The second mask layer 1103 also preferably includes a metal element from the perspective of dry etching resistance. The second mask layer 1103 preferably also includes metal oxide microparticles, since the target object 20 can thereby be more easily processed during dry etching.

The dilution solvent is not particularly limited, but the boiling point of the solvent alone is preferably from 40°C to 200°C, more preferably from 60°C to 180°C, and more preferably from 60°C to 160°C. Two or more types of diluents

may be used.

The concentration of the inorganic material diluted with a solvent is not particularly limited insofar as this concentration is such that the solid content of the film coating a unit surface area is equal to or less than the volume of gaps (recesses 1102b) in the concavo-convex structure 1102 present on the unit surface area (or under the unit surface area).

The photopolymerizable group included in the second mask layer 1103 may be an acryloyl group, a methacryloyl group, an acryloxy group, a methacryloxy group, an acryl group, a methacryl group, a vinyl group, an epoxy group, an allyl group, an oxetanyl group, or another group.

The metal element included in the second mask layer 1103 is preferably at least one species selected from the group consisting of titanium (Ti), zirconium (Zr), chromium (Cr), zinc (Zn), tin (Sn), boron (B), indium (In), aluminum (Al), and silicon (Si). Titanium (Ti), zirconium (Zr), chromium (Cr), and silicon (Si) are particularly preferred.

The material for forming the second mask layer 1103 preferably includes a sol-gel material. By inclusion of a sol-gel material, not only does a second mask layer 1103 having good dry etching resistance more easily fill into the concavo-convex structure 1102 (recesses 1102b), but it is possible to increase the ratio ($Vr_{\perp}/Vr_{//}$) of the dry etching rate ($Vr_{\perp}$) in the longitudinal direction and the dry etching rate ($Vr_{//}$) in the transverse direction during dry etching of the first mask layer 1104. A metal alkoxide having a single metal species may be used alone or metal alkoxides having different metal species may be jointly used as the sol-gel material, but the sol-gel material preferably contains at least two types of metal alkoxides which are a metal alkoxide having a metal species M1 (where M1 is at least one metal element selected from the group consisting of Ti, Zr, Zn, Sn, B, In, and Al) and a metal alkoxide having the metal species Si. Alternatively, a hybrid of these sol-gel materials and a publicly known polymerizable resin may be used as the inorganic material.

From the perspective of suppressing physical damage during dry etching, it is preferred that the inorganic material have minimal phase separation after curing either by both condensation and photopolymerization or any one of condensation and photopolymerization. Phase separation herein can be confirmed by contrast in transmission electron microscopy (TEM). From the perspective of transfer properties of the second mask layer 1103, the phase separation size by TEM contrast is preferably 20 nm or less. From the perspective of physical durability and dry etching resistance, the phase separation size is preferably 15 nm or less, and more preferably 10 nm or less. From the perspective of suppressing phase separation, the sol-gel material preferably includes a silane coupling agent provided with a photopolymerizable group.

From the perspective of dry etching resistance in the second mask layer 1103, the sol-gel material preferably includes at least two types of metal alkoxides having different metal species. Examples of combinations of metal species for the two types of metal alkoxides having different metal species include such combinations as Si and Ti, Si and Zr, and Si and Ta. From the perspective of dry etching resistance, the ratio CM1/CSi of the molar concentration (CSi) of the metal alkoxide having Si as the metal species and the molar concentration(CM1) of the metal alkoxide having a metal species M1 other than Si is preferably from 0.2 to 15. From the perspective of stability during coating and drying, CM1/CSi is preferably from 0.5 to 15. From the perspective of physical strength, CM1/CSi is more preferably from 5 to 8.

From the perspective of transfer accuracy and dry etching resistance of the second mask layer 1103, the second mask layer 1103 is preferably a hybrid including an inorganic segment and an organic segment. The hybrid may be a combination of inorganic microparticles and a photopolymerizable (or thermally polymerizable) resin, an inorganic precursor and a photopolymerizable (or thermally polymerizable) resin, a molecule in which an organic polymer and an inorganic segment are covalently bonded, or the like, for example. For a sol-gel material to be used as an inorganic precursor means that besides a sol-gel material including a silane coupling agent, a photopolymerizable resin is also included. In the case of a hybrid, a metal alkoxide, a silane coupling agent provided with a photopolymerizable group, a radical-polymerizing resin, and the like may be mixed therein. Silicone may be added to these components in order to further increase transfer accuracy. Preliminary condensation of sol-gel material components may be performed in advance to enhance dry etching resistance. From the perspective of dry etching resistance, the mixture ratio of the metal alkoxide including a silane coupling agent and the photopolymerizable resin is preferably in the range of from 3:7 to 7:3, and more preferably from 3.5:6.5 to 6.5:3.5. Insofar as the resin used in the hybrid is photopolymerizable, the resin is not particularly limited, and may be a radical-polymerization-type resin or a cationic-polymerization-type resin.

Except for the fluorine-containing (meth)acrylate, the photopolymerizable radical-polymerization-type resins cited above for constituting the concavo-convex structure are preferred for use as the photopolymerizable radical-polymerization-type resin for constituting the second mask layer 1103.

A photopolymerizable cationic-polymerization-type resin for constituting the second mask layer 1103 is a composition that includes at least a cation-curable monomer and a photoacid generator. The cation-curable monomer in a cation-curable resin composition is a compound from which a cured material is obtained by UV irradiation, heating, or another curing process, for example, in the presence of a cationic polymerization initiator. Cation-curable monomers include epoxy compounds, oxetane compounds, and vinyl ether compounds, and epoxy compounds include alicyclic epoxy compounds and glycidyl ethers. Among these compounds, since alicyclic epoxy compounds enhance the polymerization initiation rate and oxetane compounds enhance the polymerization rate, these compounds are preferred for use. Glycidyl ethers reduce the viscosity of the curable resin composition and enhance coating properties, and are therefore preferred for use. More preferred is the joint use of an alicyclic epoxy compound and an oxetane compound, and even more preferred is the joint use of an alicyclic epoxy compound and an oxetane compound in a weight ratio range of from 99:1 to 51:49.

Specific examples of cation-curable monomers are cited below. Examples of alicyclic epoxy compounds include 3',4' - epoxycyclohexane carboxylic acid-3,4-epoxycyclohexyl methyl, 3',4'-epoxy-6'-methylcyclohexane carboxylic acid-3,4-epoxy-6'-cyclohexyl methyl, vinylcyclohexene monoxide oxide 1,2-epoxy-4-vinyl cyclohexane, and 2-(3,4-epoxycyclohexyl)ethyltrimethoxysilane.

Examples of glycidyl ethers include bisphenol A glycidyl ether, bisphenol F glycidyl ether, hydrogenated bisphenol A glycidyl ether, hydrogenated bisphenol F glycidyl ether, 1,4-butanediol glycidyl ether, 1,6-hexanediol glycidyl ether, trimethylolpropane triglycidyl ether, glycidyl methacrylate, 3-glycidyloxypropyl trimethoxysilane, 3-glycidyloxypropyl ethyldiethoxysilane, 3-glycidyloxypropyl triethoxysilane, and the like.

Examples of oxetane compounds include 3-ethyl-3-(phenoxymethyl) oxetane, di[1-ethyl(3-oxetanyl)]methyl ether, 3-ethyl-3-allyloxymethyl oxetane, 3-ethyl-3-(2-ethylhexyloxymethyl) oxetane, 3-ethyl-3-{[3-(triethoxysilyl) propoxy]methyl} oxetane, and the like.

Vinyl ethers include 2-hydroxybutyl vinyl ether, diethylene glycol monomethyl ether, 2-hydroxybutyl vinyl ether, 4-hydroxybutyl vinyl ether, triethylene glycol divinyl ether, cyclohexanedimethanol divinyl ether, 1,4-butanediol divinyl ether, and the like.

The photoacid generator is not particularly limited insofar as the photoacid generator generates a photoacid by light irradiation. Examples thereof include aromatic onium salts such as sulfonium salt and iodonium salt. Examples of photoacid generators include, sulfonium hexafluoroantimonate, benzyltriphenylphosphonium hexafluorophosphate, benzylpyridinium hexafluorophosphate, diphenyliodonium hexafluorophosphate, triphenylsulfonium hexafluorophosphate, benzoin tosylate, Adekaoptomer sp-170 (manufactured by ADEKA CORPORATION), Adekaoptomer sp-172 (manufactured by ADEKA CORPORATION), WPAG-145 (manufactured by Wako Pure Chemical Industries, Ltd.), WPAG-170 (manufactured by Wako Pure Chemical Industries, Ltd.), WPAG-199 (manufactured by Wako Pure Chemical Industries, Ltd.), WPAG-281 (manufactured by Wako Pure Chemical Industries, Ltd.), WPAG-336 (manufactured by Wako Pure Chemical Industries, Ltd.), WPAG-367 (manufactured by Wako Pure Chemical Industries, Ltd.), CPI-100P (manufactured by San-Apro Ltd.), CPI-101A (manufactured by San-Apro Ltd.), CPI-200K (manufactured by San-Apro Ltd.), CPI-210S (manufactured by San-Apro Ltd.), DTS-102 (manufactured by Midori Kagaku Co., Ltd.), TPS-TF (manufactured by Toyo Gosei Co., Ltd.), and DTBPI-PFBS (manufactured by Toyo Gosei Co. Ltd.).

When wetting properties are poor during direct coating of the concavo-convex structure face of the concavo-convex structure by the diluted inorganic material, a surfactant or a leveling agent may be added to the inorganic material. This component may be a publicly known, commercially available product, but a photopolymerizable group is preferably provided in the same molecule thereof. From the perspective of coating properties, the added concentration is preferably 40 parts or more by weight, more preferably 60 parts or more by weight, with respect to 100 parts by weight of the inorganic material. From the perspective of dry etching resistance, the added concentration is preferably 500 parts or less by weight, more preferably 300 parts or less by weight, and more preferably 150 parts or less by weight with respect to 100 parts by weight of the inorganic material.

Meanwhile, from the perspective of enhancing the transfer accuracy between the inorganic material and the first mask layer 1104, when a surfactant or a leveling agent is added, the added concentration thereof is preferably 20 parts or less by weight, more preferably 15 parts or less by weight, and more preferably 10 parts or less by weight with respect to 100 parts by weight of the inorganic material. Particularly from the perspective of compatibility, the surfactant or leveling agent preferably includes at least a carboxyl group, a urethane group, or a functional group having an isocyanuric acid derivative. An isocyanuric acid derivative encompasses derivatives having an isocyanuric acid skeleton and having a structure in which at least one hydrogen atom bonded to a nitrogen atom is substituted by another group. OPTOOL DAC, manufactured by Daikin Industries, Ltd., is cited as an example of a product that satisfies these conditions. Additives are preferably mixed with a mask agent in a solvent-dissolved state.

(First mask layer)

After the fine-pattern-forming film 1100 has been laminated and bonded via the first mask layer 1104 to the target object 20 as the processing object, the second mask layer 1103 can easily be transferred onto the target object 20 by curing the first mask layer 1104 and then peeling the cover film. Here, the first mask layer 1104 used when the fine-pattern-forming film 1 is used, and the first mask layer 1104 of the fine-pattern-forming film have the same characteristics and are comprised of the same materials.

The first mask layer 1104 is not particularly limited insofar as the first mask layer 1104 satisfies the selection ratio described above. In particular, the first mask layer 1104 is preferably cured by energy ray irradiation. The photopolymerizable radical-polymerization-type resins for constituting the concavo-convex structure cited above other than the fluorine-containing (meth)acrylate, the photopolymerizable cationic-polymerization-type resins cited above for constituting the second mask layer 1103, other publicly known, commercially available photopolymerizable or thermally polymerizable resins, and resins that are partially crosslinked and can be thermocompression bonded may be used as the material for constituting the first mask layer 1104.

From the perspective of transfer accuracy, the second mask layer 1103 and the first mask layer 1104 are preferably chemically bonded. Therefore, when the second mask layer 1103 includes a photopolymerizable group, the first mask layer 1104 also preferably includes a photopolymerizable group, and when the second mask layer 1103 includes a thermally polymerizable group, the first mask layer 1104 also preferably includes a thermally polymerizable group. Since a chemical bond is generated by condensation with the sol-gel material in the second mask layer 1103, the first mask layer 1104 may also include a sol-gel material. Photopolymerization methods include radical and cationic methods, but from the perspective of curing speed and dry etching resistance, radical polymerization alone or a hybrid of radical and cationic polymerization is preferred. In the case of a hybrid, a radical-polymerization-type resin and a cationic-polymerization-type resin are preferably mixed in a weight ratio of from 3:7 to 7:3, and more preferably from 3.5:6.5 to 6.5:3.5.

From the perspective of physical stability and handling of the first mask layer 1104 during dry etching, the glass transition temperature Tg of the cured first mask layer 1104 is preferably from 30°C to 300°C, and more preferably from 60°C to 250°C.

From the perspective of adhesion between the first mask layer 1104 and the target object 20, and between the first mask layer 1104 and the second mask layer 1103, the contraction rate of the first mask layer 1104 by a specific gravity method is preferably 5% or less.

From the perspective of handling of the fine-pattern-forming film 1100 during laminating of the fine-pattern-forming film to the target object 20 using the layered body comprising the concavo-convex structure 1102, the second mask layer 1103, and the first mask layer 1104, the first mask layer 1104 is preferably a thermocompression-bondable resin. In this case, the layered body can be produced and the cover film 1101 placed thereon for take-up and recovery. A roll thereof can be fed and easily laminated by thermocompression bonding to the desired target object 20. The significance of using such a method is that through use of the fine-pattern-forming film 1100, there is no need for a specialized apparatus or the technical expertise involved in loading or peeling transfer materials for nanoimprinting (transfer).

A resin that can be compression bonded at 200°C or below is preferred, and a resin that can be compression bonded at 150°C or below is more preferred as the thermocompression-bondable resin. The thermocompression-bondable resin is layered on the concavo-convex structure 1102 and the second mask layer 1103, and a layered body comprised of the concavo-convex structure 1102, the second mask layer 1103, and the first mask layer 1104 is obtained, for example. From the perspective of adhesion to the second mask layer 1103, the thermocompression-bondable resin more preferably includes a photosensitive resin. It is particularly preferred that a binder polymer, a photopolymerizable monomer, and a photopolymerization initiator be included. From the perspective of thermocompression bonding and transfer accuracy, the ratio of the binder polymer and the photopolymerizable monomer is preferably 9:1 to 1:9, more preferably 7:3 to 3:7, and most preferably 6:4 to 4:6. From the perspective of dry etching resistance, the binder polymer preferably includes a portion represented by Chemical Formula (4).

[Chemical Formula 4]

Chemical Formula (4)

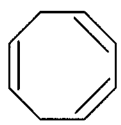

The present invention is not limited to the embodiments described above and can be implemented with various modifications. Sizes, shapes, and other characteristics shown in the accompanying drawings are also not limited to the embodiments described above, and can be modified, as appropriate, in ranges whereby the effects of the present invention are demonstrated.

INDUSTRIAL APPLICABILITY

The present invention as described above has the effect of providing a thermal nanoimprinting apparatus whereby it is possible to improve the film thickness distribution of a first mask layer during transfer of a concavo-convex structure formed on the surface of a cover film to a target object via the first mask layer, transfer accuracy can be enhanced, and efficient transfer is possible without the need for excessively large equipment. The present invention is useful particularly as a concavo-convex structure fabrication technique in manufacturing of a base material for enhancing light extraction efficiency, a base material for enhancing internal quantum efficiency, or a base material for enhancing light extraction efficiency and internal quantum efficiency relating to an LED.

## Claims

1. A transfer method for transferring a first mask layer (13) and a second mask layer (12) on a target object (20) using a fine-pattern-forming film provided with a cover film (10) having a nanoscale concavo-convex structure (11) formed on one surface thereof, a second mask layer provided in a recess of said concavo-convex structure, and a first mask layer provided so as to cover said concavo-convex structure and said second mask layer;
said transfer method including, at least in the stated order:

   a pressing step for pressing a surface of said fine-pattern-forming film on which said first mask layer is provided toward a surface of said target object;
   an energy-ray irradiation step for irradiating energy rays to said first mask layer; and
   a release step for removing said cover film from said second mask layer and said first mask layer;
   said pressing step and said energy-ray irradiation step each being performed independently.

2. The transfer method according to claim 1, wherein said energy-ray irradiation step is performed in a state in which a pressing force in said pressing step is released.

3. The transfer method according to claim 1 or 2, wherein said pressing step is performed in a state in which at least one of said target object and said fine-pattern-forming film is heated.

4. The transfer method according to claim 3, wherein a rotating body, at least a surface layer of which is comprised of an elastic body, is used in said pressing step.

5. The transfer method according to any of claims 1 through 4, wherein the distance (Icc) between the top position (S) of a protrusion of a surface of said concavo-convex structure of said cover film and the surface position (Scc) of said second mask layer filled into a recess of said concavo-convex structure satisfies Formula (1) below, and the distance (Icv) between the top position (S) of said protrusion and the top position (Scv) of said second mask layer formed on said protrusion satisfies Formula (2) below.

$$(1):\quad 0 < lcc < 1.0h$$

$$(2):\quad 0 \leq lcv \leq 0{,}05h,$$

   wherein h is the height of said concavo-convex structure, represented by the distance between said top position (S) of said protrusion and a bottom position of said recess.

6. The transfer method according to claim 5, wherein the distance (lor) between said top position (Scv) of said second mask layer and an exposed surface position (Sb) of said first mask layer in said fine-pattern-forming film satisfies Formula (3) below.

$$(3):\quad 0 \leq lor \leq 1500\ \text{nm}$$

7. A thermal nanoimprinting apparatus for transferring a first mask layer and a second mask layer onto a target object

by the transfer method according to any of claims 1 through 6;
said thermal nanoimprinting apparatus **characterized in that**:

a laminating part (201) is provided for laminating together a fine-pattern-forming film and said target object in a state in which a surface on which said first mask layer is formed is brought to face one surface of said target object;
said laminating part is provided with a pressing part (100) for applying a pressing force essentially in a line to said fine-pattern-forming film or said target object, the pressing part being provided with a rotating body (30, 33, 102) for contacting said fine-pattern-forming film or said target object essentially in a line; and
at least a surface layer (35) of said rotating body is comprised of an elastic body having a glass transition temperature of 100 °C or below.

**8.** The thermal nanoimprinting apparatus according to claim 7, wherein said rotating body is a laminating roller having a substantially true-circular cross-section.

**9.** The thermal nanoimprinting apparatus according to claim 7 or 8, further comprising a peeling part (206) for releasing said cover film from said target object and said fine-pattern-forming film laminated together by said laminating part and obtaining said target object, to a surface of which the first mask layer and the second mask layer have been transferred.

**10.** The thermal nanoimprinting apparatus according to claim 7 or 8, wherein:

said fine-pattern-forming film is a carrier film;
said thermal nanoimprinting apparatus further comprises a feeding roller (202) for winding off said carrier film, a take-up roller (203) for winding said carrier film wound off from said feeding roller, heating means for heating said target object when said carrier film and said target object are laminated together in said laminating part, and a peeling part (206) for peeling said cover film from said laminated carrier film and target object, the peeling part being provided downstream from said laminating part in the conveying direction of said carrier film and upstream from said take-up roller in the conveying direction of said carrier film; and
said laminating part is laterally installed in the width direction of said carrier film conveyed by said feeding roller and said take-up roller.

**11.** The thermal nanoimprinting apparatus according to claim 10, further comprising an energy-ray irradiation part (610) for irradiating energy rays to said carrier film, the energy-ray irradiation part being provided downstream from said laminating part in the conveying direction of said carrier film and upstream from said peeling part in the conveying direction of said carrier film.

**12.** The thermal nanoimprinting apparatus according to claim 10 or 11, wherein the conveying direction of said carrier film changes in said peeling part.

**13.** The thermal nanoimprinting apparatus according to any of claims 10 through 12, wherein said peeling part is comprised of a peeling roller (604) having a substantially true-circular cross-section, and holding means for detachably fixing said target object.

**14.** The thermal nanoimprinting apparatus according to any of claims 10 through 13, further comprising a target object holding part (205) for holding said target object at least during laminating of said carrier film and said target object by said laminating part.

**15.** The thermal nanoimprinting apparatus according to any of claims 10 through 14, wherein said target object is supported by said carrier film and moves in conjunction with conveyance of said carrier film between said laminating part and said peeling part.

**16.** The thermal nanoimprinting apparatus according to claim 7 or 8, wherein
said fine-pattern-forming film is a carrier film;
said thermal nanoimprinting apparatus further comprises a feeding roller for winding off said carrier film, a take-up roller for winding said carrier film wound off from said feeding roller, heating means for heating said target object when said carrier film and said target object are laminated together in said laminating part, and a cutting part (501) provided downstream from said laminating part in the conveying direction of said carrier film and upstream from

said take-up roller in the conveying direction of said carrier film;
said laminating part is laterally installed in the width direction of said carrier film conveyed by said feeding roller and said take-up roller; and
said carrier film laminated to said target object is partially cut in said cutting part to a size equal to or greater than an outline of said target object.

**17.** The thermal nanoimprinting apparatus according to claim 16, further comprising a separation part (503) for separating said target object laminated to said carrier film from said carrier film, the separation part being provided downstream from said cutting part in the conveying direction of said carrier film and upstream from said take-up roller in the conveying direction of said carrier film;
said separation part being comprised of a separating roller or separating edge for changing the conveying direction of said conveyed carrier film and a separating target object holding part for holding at least a surface of said target object on an opposite side thereof of said carrier film,
said carrier film being laminated to said target object.

**18.** The thermal nanoimprinting apparatus according to claim 16 or 17, further comprising a target object holding part for holding said target object at least during laminating of said carrier film and said target object by said laminating part.

**19.** The thermal nanoimprinting apparatus according to claim 17 or 18, wherein said target object is supported by said carrier film, and moves in conjunction with conveyance of said carrier film between said laminating part and said separating roller or said separating edge.

**20.** The thermal nanoimprinting apparatus according to any of claims 14, 15, 18, and 19, wherein in a step for laminating together said carrier film and said target object in said laminating part,
said target object is fixed and held by said target object holding part,
said first mask layer of said carrier film is then laminated by a laminating roller to said target object beginning from one edge part of said target object, and
fixing and retention of said target object by said target object holding part are released before said laminating roller finishes passing an other-edge part of said target object.

**21.** The thermal nanoimprinting apparatus according to claim 20, wherein said target object holding part fixes and holds said target object by suction chucking.

## Patentansprüche

**1.** Übertragungsverfahren zum Übertragen einer ersten Maskenschicht (13) und einer zweiten Maskenschicht (12) auf ein Zielobjekt (20) unter Verwendung eines feine Strukturen ausbildenden Films, der mit einem Deckfilm (10) mit einer nanoskaligen konkav-konvexen Struktur (11), die auf einer seiner Oberflächen ausgebildet ist, versehen ist, sich eine zweite Maskenschicht in einer Ausnehmung der konkav-konvexen Struktur befindet und eine erste Maskenschicht so angeordnet ist, dass sie die konkav-konvexe Struktur und die zweite Maskenschicht bedeckt;
wobei das Übertragungsverfahren wenigstens in der angegebenen Reihenfolge umfasst:

> einen Pressschritt zum Pressen einer Fläche des feine Strukturen ausbildenden Films, auf dem sich die erste Maskenschicht befindet, auf eine Fläche des Zielobjekts;
> einen Energiestrahlen-Bestrahlungsschritt zum Bestrahlen der ersten Maskenschicht mit Energiestrahlen; und
> einen Ablöseschritt zum Entfernen des Deckfilms von der zweiten Maskenschicht und der ersten Maskenschicht;
> wobei der Pressschritt und der Energiestrahlen-Bestrahlungsschritt jeweils unabhängig voneinander durchgeführt werden.

**2.** Übertragungsverfahren gemäß Anspruch 1, wobei der Energiestrahlen-Bestrahlungsschritt in einem Zustand durchgeführt wird, in dem die Presskraft in dem Pressschritt weggenommen ist.

**3.** Übertragungsverfahren gemäß Anspruch 1 oder 2, wobei der Pressschritt in einem Zustand durchgeführt wird, in dem das Zielobjekt und/oder der feine Strukturen ausbildende Film erhitzt werden.

**4.** Übertragungsverfahren gemäß Anspruch 3, wobei in dem Pressschritt ein rotierender Körper verwendet wird, von dem wenigstens eine Oberflächenschicht aus einem elastischen Körper besteht.

**5.** Übertragungsverfahren gemäß einem der Ansprüche 1 bis 4, wobei der Abstand (Icc) zwischen der oberen Position (S) eines Vorsprungs auf einer Fläche der konkav-konvexen Struktur des Deckfilms und der Oberflächenposition (Scc) der zweiten Maskenschicht, die in eine Ausnehmung der konkav-konvexen Struktur gefüllt ist, der folgenden Formel (1) genügt und der Abstand (Icv) zwischen der oberen Position (S) des Vorsprungs und der oberen Position (Scv) der auf dem Vorsprung gebildeten zweiten Maskenschicht der folgenden Formel (2) genügt:

$$(1): \quad 0 < lcc < 1{,}0h$$

$$(2) \quad 0 \leq lcv \leq 0{,}05h,$$

wobei h die Höhe der konkav-konvexen Struktur ist, die durch den Abstand zwischen der oberen Position (S) des Vorsprungs und der unteren Position der Ausnehmung repräsentiert wird.

**6.** Übertragungsverfahren gemäß Anspruch 5, wobei der Abstand (lor) zwischen der oberen Position (Scv) der zweiten Maskenschicht und einer exponierten Oberflächenposition (Sb) der ersten Maskenschicht in dem feine Strukturen ausbildenden Film der folgenden Formel (3) genügt:

$$(3) \quad 0 \leq lor \leq 1500 \text{ nm}.$$

**7.** Thermische Nanoprägevorrichtung zum Übertragen einer ersten Maskenschicht und einer zweiten Maskenschicht auf ein Zielobjekt nach dem Übertragungsverfahren gemäß einem der Ansprüche 1 bis 6;
wobei die thermische Nanoprägevorrichtung **dadurch gekennzeichnet ist, dass**:

ein Laminierungsteil (201) bereitgestellt wird, um einen feine Strukturen ausbildenden Film und das Zielobjekt in einem Zustand, in dem eine Fläche, auf der die erste Maskenschicht gebildet wird, so angeordnet wird, dass sie einer Fläche des Zielobjekts zugewandt ist, zusammen zu laminieren;
der Laminierungsteil mit einem Pressteil (100) versehen ist, um eine Presskraft im Wesentlichen in einer Linie auf den feine Strukturen ausbildenden Film oder das Zielobjekt auszuüben, wobei der Pressteil mit einem rotierenden Körper (30, 33, 102) versehen ist, um den feine Strukturen ausbildenden Film oder das Zielobjekt im Wesentlichen in einer Linie zu kontaktieren; und
wenigstens eine Oberflächenschicht (35) des rotierenden Körpers aus einem elastischen Körper mit einer Glasübergangstemperatur von 100 °C oder darunter besteht.

**8.** Thermische Nanoprägevorrichtung gemäß Anspruch 7, wobei der rotierende Körper eine Laminierwalze mit einem im Wesentlichen exakt kreisförmigen Querschnitt ist.

**9.** Thermische Nanoprägevorrichtung gemäß Anspruch 7 oder 8, weiterhin umfassend ein Schälteil (206) zum Ablösen des Deckfilms von dem Zielobjekt und dem feine Strukturen ausbildenden Film, die durch den Laminierungsteil zusammen laminiert sind, und Gewinnen des Zielobjekts, auf dessen Fläche die erste Maskenschicht und die zweite Maskenschicht übertragen wurden.

**10.** Thermische Nanoprägevorrichtung gemäß Anspruch 7 oder 8, wobei:

der feine Strukturen ausbildende Film ein Trägerfilm ist;
die thermische Nanoprägevorrichtung weiterhin eine Zufuhrrolle (202) zum Abwickeln des Trägerfilms, eine Aufnahmerolle (203) zum Aufwickeln des von der Zufuhrrolle abgewickelten Trägerfilms, Heizeinrichtungen zum Erhitzen des Zielobjekts, wenn der Trägerfilm und das Zielobjekt in dem Laminierungsteil zusammen laminiert werden, und einen Schälteil (206) zum Abschälen des Deckfilms von dem laminierten Trägerfilm und Zielobjekt umfasst, wobei der Schälteil dem Laminierungsteil in der Transportrichtung des Trägerfilms nachgeschaltet ist und der Aufnahmerolle in der Transportrichtung des Trägerfilms vorgeschaltet ist; und
der Laminierungsteil in der Breitenrichtung des durch die Zufuhrrolle und die Aufnahmerolle transportierten Trägerfilms seitlich installiert ist.

**11.** Thermische Nanoprägevorrichtung gemäß Anspruch 10, weiterhin umfassend einen Energiestrahlen-Bestrahlungsteil (610) zum Bestrahlen des Trägerfilms mit Energiestrahlen, wobei der Energiestrahlen-Bestrahlungsteil dem Laminierungsteil in der Transportrichtung des Trägerfilms nachgeschaltet ist und dem Schälteil in der Transportrichtung des Trägerfilms vorgeschaltet ist.

**12.** Thermische Nanoprägevorrichtung gemäß Anspruch 10 oder 11, wobei sich die Transportrichtung des Trägerfilms in dem Schälteil ändert.

**13.** Thermische Nanoprägevorrichtung gemäß einem der Ansprüche 10 bis 12, wobei der Schälteil aus einer Schälrolle (604) mit einem im Wesentlichen exakt kreisförmigen Querschnitt und Halteeinrichtungen zum lösbaren Fixieren des Zielobjekts besteht.

**14.** Thermische Nanoprägevorrichtung gemäß einem der Ansprüche 10 bis 13, weiterhin umfassend ein Zielobjekt-Halteteil (205) zum Halten des Zielobjekts wenigstens während der Laminierung des Trägerfilms und des Zielobjekts durch den Laminierungsteil.

**15.** Thermische Nanoprägevorrichtung gemäß einem der Ansprüche 10 bis 14, wobei das Zielobjekt durch den Trägerfilm unterstützt wird und sich in Verbindung mit dem Transport des Trägerfilms zwischen dem Laminierungsteil und dem Schälteil bewegt.

**16.** Thermische Nanoprägevorrichtung gemäß Anspruch 7 oder 8, wobei
der feine Strukturen ausbildende Film ein Trägerfilm ist;
die thermische Nanoprägevorrichtung weiterhin eine Zufuhrrolle zum Abwickeln des Trägerfilms, eine Aufnahmerolle zum Aufwickeln des von der Zufuhrrolle abgewickelten Trägerfilms, Heizeinrichtungen zum Erhitzen des Zielobjekts, wenn der Trägerfilm und das Zielobjekt in dem Laminierungsteil zusammen laminiert werden, und einen Schneideteil (501), der dem Laminierungsteil in der Transportrichtung des Trägerfilms nachgeschaltet ist und der Aufnahmerolle in der Transportrichtung des Trägerfilms vorgeschaltet ist;
der Laminierungsteil in der Breitenrichtung des durch die Zufuhrrolle und die Aufnahmerolle transportierten Trägerfilms seitlich installiert ist; und
der auf das Zielobjekt laminierte Trägerfilm in dem Schneideteil partiell auf eine Größe geschnitten wird, die größer oder gleich einer Silhouette des Zielobjekts ist.

**17.** Thermische Nanoprägevorrichtung gemäß Anspruch 16, weiterhin umfassend ein Trennteil (503) zum Abtrennen des auf den Trägerfilm laminierten Zielobjekts von dem Trägerfilm, wobei das Trennteil dem Schneideteil in der Transportrichtung des Trägerfilms nachgeschaltet ist und der Aufnahmerolle in der Transportrichtung des Trägerfilms vorgeschaltet ist;
der Trennteil aus einer Trennrolle oder Trennkante zum Ändern der Transportrichtung des transportierten Trägerfilms und einem Trennzielobjekthalteteil zum Halten wenigstens einer Fläche des Zielobjekts auf einer entgegengesetzten Seite davon des Trägerfilms besteht, wobei der Trägerfilm auf das Zielobjekt laminiert ist.

**18.** Thermische Nanoprägevorrichtung gemäß Anspruch 16 oder 17, weiterhin umfassend ein Zielobjekthalteteil zum Halten des Zielobjekts wenigstens während des Laminierens des Trägerfilms und des Zielobjekts durch den Laminierungsteil.

**19.** Thermische Nanoprägevorrichtung gemäß Anspruch 17 oder 18, wobei das Zielobjekt von dem Trägerfilm unterstützt wird und sich in Verbindung mit dem Transport des Trägerfilms zwischen dem Laminierungsteil und der Trennrolle oder Trennkante bewegt.

**20.** Thermische Nanoprägevorrichtung gemäß einem der Ansprüche 14, 15, 18 und 19, wobei in einem Schritt zum Zusammenlaminieren des Trägerfilms und des Zielobjekts in dem Laminierungsteil
das Zielobjekt durch den Zielobjekthalteteil fixiert und gehalten wird,
wobei die erste Maskenschicht des Trägerfilms dann durch eine Laminierungswalze beginnend an einem Randteil des Zielobjekts auf das Zielobjekt laminiert wird und
das Fixieren und Zurückhalten des Zielobjekts durch den Zielobjekthalteteil gelöst wird, bevor die Laminierungswalze das Passieren eines anderen Kantenteils des Zielobjekts beendet.

**21.** Thermische Nanoprägevorrichtung gemäß Anspruch 20, wobei der Zielobjekthalteteil das Zielobjekt durch Saugeinspannung fixiert und hält.

## Revendications

1. Procédé de transfert pour transférer une première couche de masque (13) et une seconde couche de masque (12) sur un objet cible (20) en utilisant un film formateur de motif fin muni d'un film de couverture (10) ayant une structure concavo-convexe à échelle nanométrique (11) formé sur une surface de celui-ci, une seconde couche de masque agencée dans un évidement de ladite structure concavo-convexe, et une première couche de masque agencée pour couvrir ladite structure concavo-convexe et ladite seconde couche de masque ;
ledit procédé de transfert incluant, au moins dans l'ordre établi :

   une étape de pressage pour presser une surface dudit film formateur de motif fin sur laquelle ladite première couche de masque est agencée en direction d'une surface dudit objet cible ;
   une étape d'irradiation de rayons d'énergie pour irradier des rayons d'énergie vers ladite première couche de masque ; et
   une étape de libération pour retirer ledit film de couverture de ladite seconde couche de masque et de ladite première couche de masque ;
   ladite étape de pressage et ladite étape d'irradiation de rayons d'énergie étant chacune effectuée indépendamment.

2. Procédé de transfert selon la revendication 1, dans lequel ladite étape d'irradiation de rayons d'énergie est effectuée dans un état dans lequel une force de pressage lors de ladite étape de pressage est relâchée.

3. Procédé de transfert selon la revendication 1 ou 2, dans lequel ladite étape de pressage est effectuée dans un état dans lequel au moins l'un parmi ledit objet cible et ledit film formateur de motif fin est chauffé.

4. Procédé de transfert selon la revendication 3, dans lequel un corps rotatif, dont au moins une couche de surface est constituée d'un corps élastique, est utilisé lors de ladite étape de pressage.

5. Procédé de transfert selon l'une quelconque des revendications 1 à 4, dans lequel la distance (lcc) entre la position supérieure (S) d'une saillie d'une surface de ladite structure concavo-convexe dudit film de couverture et la position de surface (Scc) de ladite seconde couche de masque remplie dans un évidement de ladite structure concavo-convexe satisfait à la Formule (1) ci-dessous, et la distance (lcv) entre la position supérieure (S) de ladite saillie et la position supérieure (Scv) de ladite seconde couche de masque formée sur ladite saillie satisfait à la Formule (2) ci-dessous,

$$(1) : 0 < \mathrm{lcc} < 1{,}0\mathrm{h}$$

$$(2) : 0 \leq \mathrm{lcv} \leq 0{,}05\mathrm{h}$$

dans lequel h est la hauteur de ladite structure concavo-convexe, représentée par la distance entre ladite position supérieure (S) de ladite saillie et une position inférieure dudit évidement.

6. Procédé de transfert selon la revendication 5, dans lequel la distance (lor) entre ladite position supérieure (Scv) de ladite seconde couche de masque et une position de surface exposée (Sb) de ladite première couche de masque dans ledit film formateur de motif fin satisfait à la Formule (3) ci-dessous,

$$(3) : 0 \leq \mathrm{lor} \leq 1500\ \mathrm{nm}.$$

7. Appareil de nanoimpression thermique pour transférer une première couche de masque et une seconde couche de masque sur un objet cible par le procédé de transfert selon l'une quelconque des revendications 1 à 6 ;
ledit appareil de nanoimpression thermique étant **caractérisé en ce que** :

   une partie de stratification (201) est prévue pour stratifier ensemble un film formateur de motif fin et ledit objet cible dans un état dans lequel une surface sur laquelle est formée ladite première couche de masque est amenée à faire face à une surface dudit objet cible ;

ladite partie de stratification est munie d'une partie de pressage (100) pour appliquer une force de pressage essentiellement selon une ligne vers ledit film formateur de motif fin ou ledit objet cible, la partie de pressage étant munie d'un corps rotatif (30, 33, 102) pour venir au contact dudit film formateur de motif fin ou dudit objet cible essentiellement selon une ligne ; et
au moins une couche de surface (35) dudit corps rotatif est constituée d'un corps élastique ayant une température de transition vitreuse de 100 °C ou moins.

**8.** Appareil de nanoimpression thermique selon la revendication 7, dans lequel ledit corps rotatif est un rouleau de stratification ayant une section transversale en forme sensiblement de cercle vrai.

**9.** Appareil de nanoimpression thermique selon la revendication 7 ou 8, comprenant en outre une partie de pelage (206) pour retirer ledit film de couverture à partir dudit objet cible et dudit film formateur de motif fin stratifiés ensemble par ladite partie de stratification et obtenir ledit objet cible, sur une surface duquel la première couche de masque et la seconde couche de masque ont été transférées.

**10.** Appareil de nanoimpression thermique selon la revendication 7 ou 8, dans lequel :

ledit film formateur de motif fin est un film support ;
ledit appareil de nanoimpression thermique comprend en outre un rouleau d'alimentation (202) pour dérouler ledit film support, un rouleau d'enroulement (203) pour enrouler ledit film support déroulé dudit rouleau d'alimentation, des moyens de chauffage pour chauffer ledit objet cible lorsque ledit film support et ledit objet cible sont stratifiés ensemble dans ladite partie de stratification, et une partie de pelage (206) pour peler ledit film de couverture à partir desdits film support et objet cible stratifiés, la partie de pelage étant agencée en aval de ladite partie de stratification dans la direction de transport dudit film support et en amont dudit rouleau d'enroulement dans la direction de transport dudit film support ; et
ladite partie de stratification est installée latéralement dans la direction de largeur dudit film support transporté par ledit rouleau d'alimentation et ledit rouleau d'enroulement.

**11.** Appareil de nanoimpression thermique selon la revendication 10, comprenant en outre une partie d'irradiation de rayons d'énergie (610) pour irradier des rayons d'énergie vers ledit film support, la partie d'irradiation des rayons d'énergie étant agencée en aval de ladite partie de stratification dans la direction de transport dudit film support et en amont de ladite partie de pelage dans la direction de transport dudit film support.

**12.** Appareil de nanoimpression thermique selon la revendication 10 ou 11, dans lequel la direction de transport dudit film support change dans ladite partie de pelage.

**13.** Appareil de nanoimpression thermique selon l'une quelconque des revendications 10 à 12, dans lequel ladite partie de pelage est composée d'un rouleau de pelage (604) ayant une section transversale en forme sensiblement de cercle véritable, et des moyens de maintien pour fixer de manière détachable ledit objet cible.

**14.** Appareil de nanoimpression thermique selon l'une quelconque des revendications 10 à 13, comprenant en outre une partie de maintien d'objet cible (205) pour maintenir ledit objet cible au moins pendant la stratification dudit film support et dudit objet cible par ladite partie de stratification.

**15.** Appareil de nanoimpression thermique selon l'une quelconque des revendications 10 à 14, dans lequel ledit objet cible est supporté par ledit film support et se déplace conjointement avec le transport dudit film support entre ladite partie de stratification et ladite partie de pelage.

**16.** Appareil de nanoimpression thermique selon la revendication 7 ou 8, dans lequel
ledit film formateur de motif fin est un film support ;
ledit appareil de nanoimpression thermique comprend en outre un rouleau d'alimentation pour dérouler ledit film support, un rouleau d'enroulement pour enrouler ledit film support déroulé dudit rouleau d'alimentation, des moyens de chauffage pour chauffer ledit objet cible lorsque ledit film support et ledit objet cible sont stratifiés ensemble dans ladite partie de stratification, et une partie de découpe (501) agencée en aval de ladite partie de stratification dans la direction de transport dudit film support et en amont dudit rouleau d'enroulement dans la direction de transport dudit film support ;
ladite partie de stratification est installée latéralement dans la direction de largeur dudit film support transporté par ledit rouleau d'alimentation et ledit rouleau d'enroulement ; et

ledit film support stratifié sur ledit objet cible est découpé partiellement dans ladite partie de découpe à une taille égale ou supérieure à un contour dudit objet cible.

**17.** Appareil de nanoimpression thermique selon la revendication 16,
comprenant en outre une partie de séparation (503) pour séparer ledit objet cible stratifié sur ledit film support à partir dudit film support, la partie de séparation étant agencée en aval de ladite partie de découpe dans la direction de transport dudit film support et en amont dudit rouleau d'enroulement dans la direction de transport dudit film support ;
ladite partie de séparation étant composée d'un rouleau de séparation ou d'un bord de séparation pour changer la direction de transport dudit film support transporté et d'une partie de maintien d'objet cible pour maintenir au moins une surface dudit objet cible sur un côté opposé de celui-ci dudit film support,
ledit film support étant stratifié sur ledit objet cible.

**18.** Appareil de nanoimpression thermique selon la revendication 16 ou 17, comprenant en outre une partie de maintien d'objet cible pour maintenir ledit objet cible au moins pendant la stratification dudit film support et dudit objet cible par ladite partie de stratification.

**19.** Appareil de nanoimpression thermique selon la revendication 17 ou 18, dans lequel ledit objet cible est supporté par ledit film support, et se déplace conjointement avec le transport dudit film support entre ladite partie de stratification et ledit rouleau de séparation ou ledit bord de séparation.

**20.** Appareil de nanoimpression thermique selon l'une quelconque des revendications 14, 15, 18 et 19, dans lequel,
lors d'une étape de stratification ensemble dudit film support et dudit objet cible dans ladite partie de stratification, ledit objet cible est fixé et maintenu par ladite partie de maintien d'objet cible,
ladite première couche de masque dudit film support est ensuite stratifiée par un rouleau de stratification sur ledit objet cible en commençant à partir d'une partie de bord dudit objet cible, et
la fixation et le maintien dudit objet cible par ladite partie de maintien d'objet cible sont relâchées avant que ledit rouleau de stratification ait fini de faire passer une partie d'un autre bord dudit objet cible.

**21.** Appareil de nanoimpression thermique selon la revendication 20, dans lequel ladite partie de maintien d'objet cible fixe et maintient ledit objet cible par aspiration.

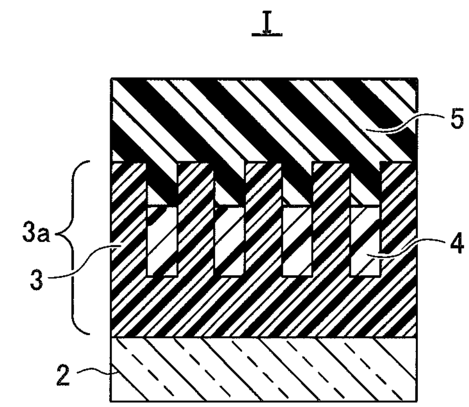


FIG.1

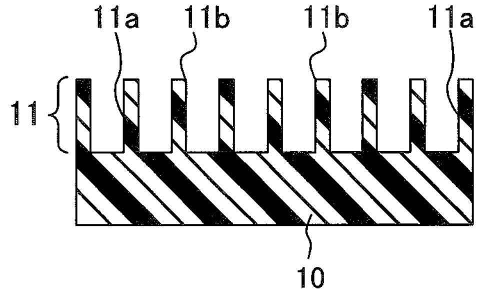


FIG.2A

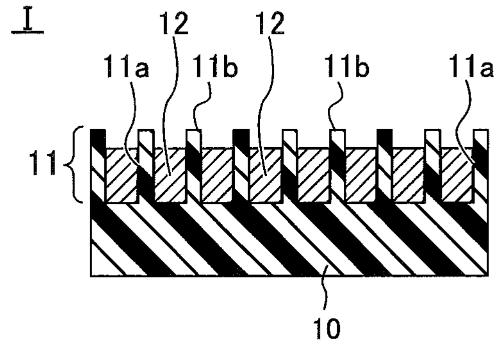


FIG.2B

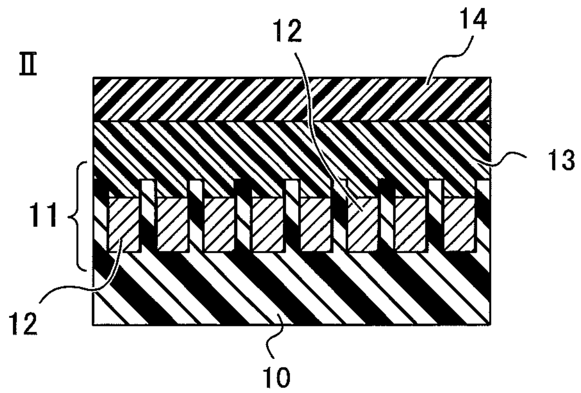


FIG.2C

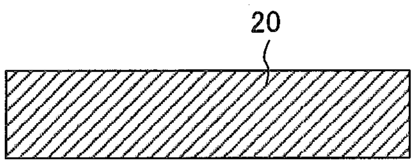


FIG.3A

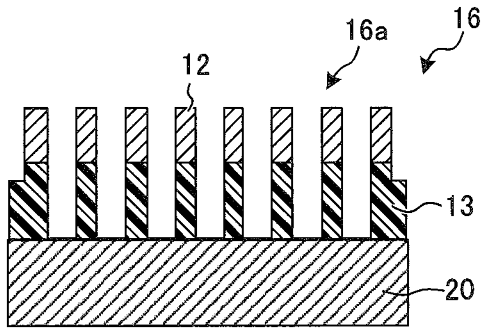


FIG.3D

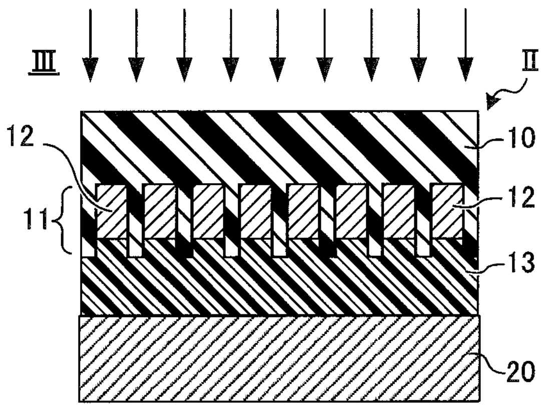


FIG.3B

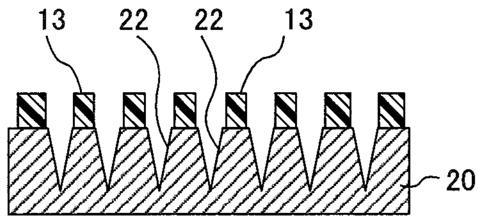


FIG.3E

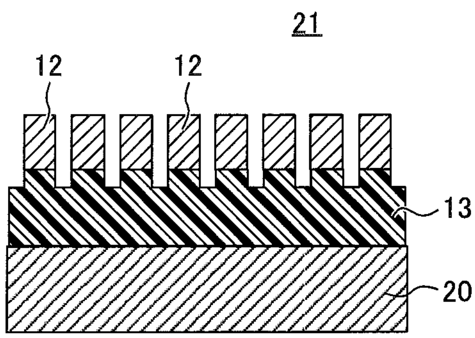


FIG.3C

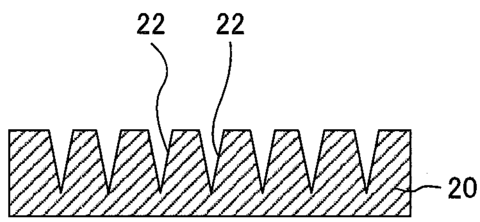


FIG.3F

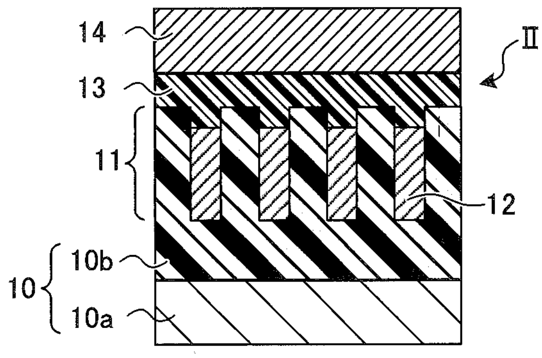


FIG.4A

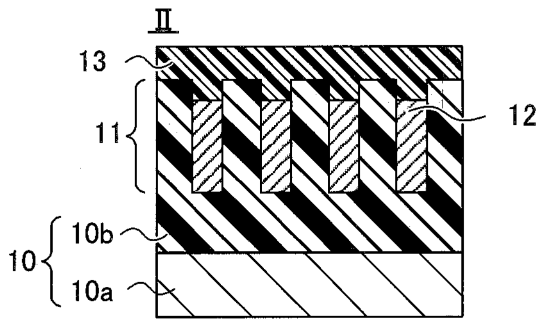


FIG.4B

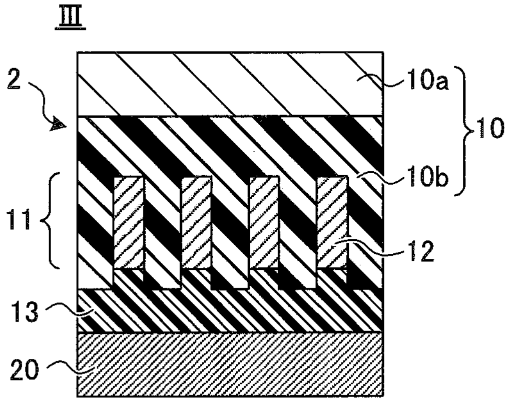


FIG.5A

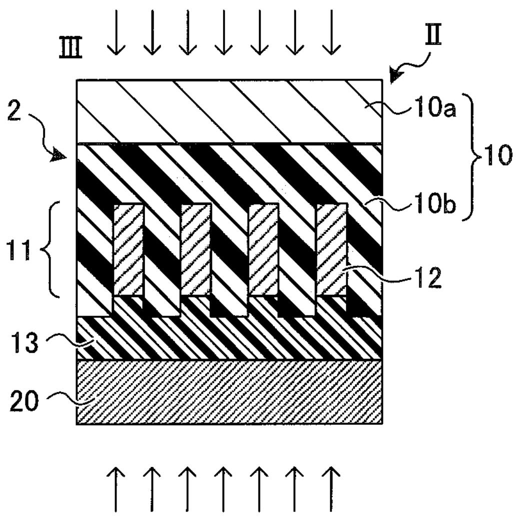


FIG.5B

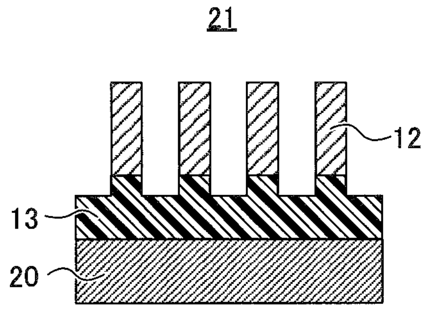


FIG.5C

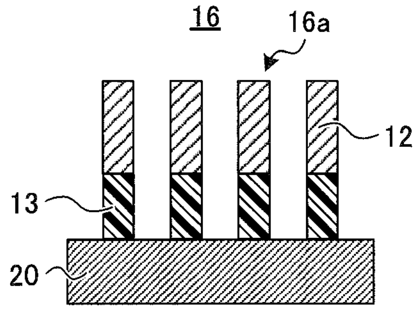


FIG.5D

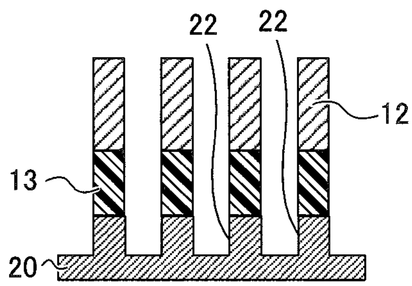


FIG.5E

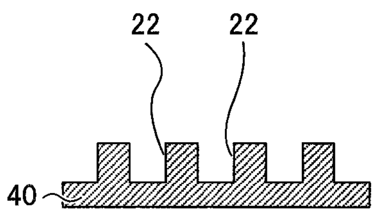


FIG.5F

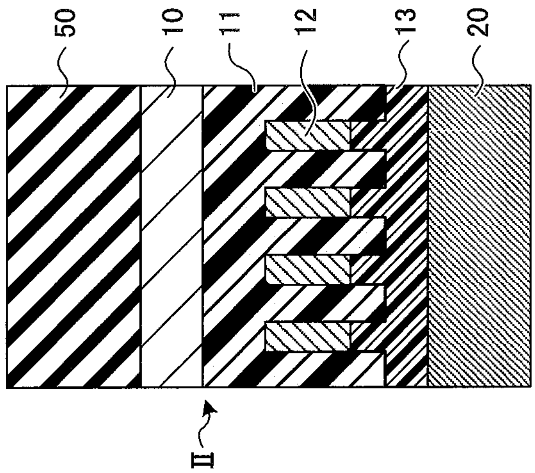


FIG.6A

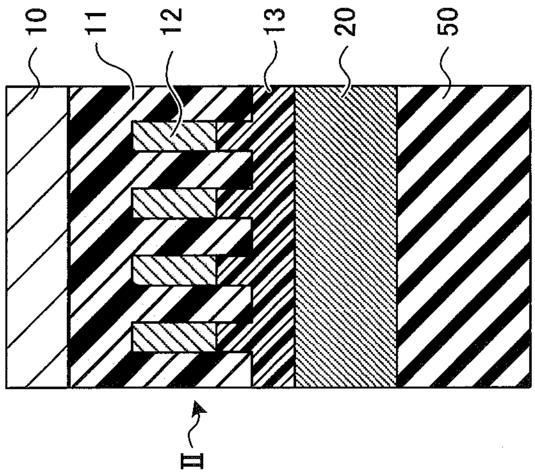


FIG.6B

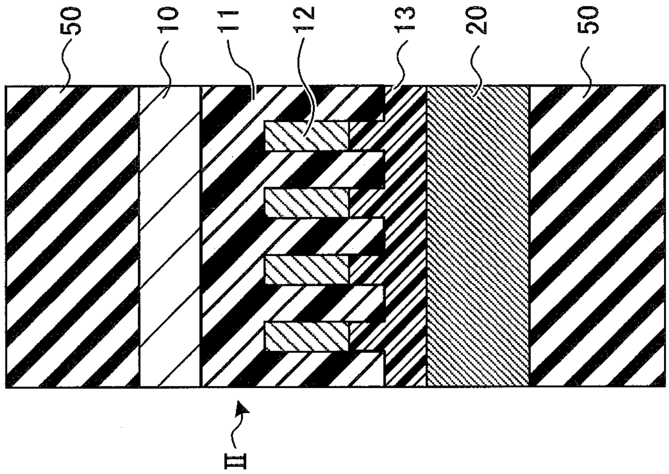


FIG.6C

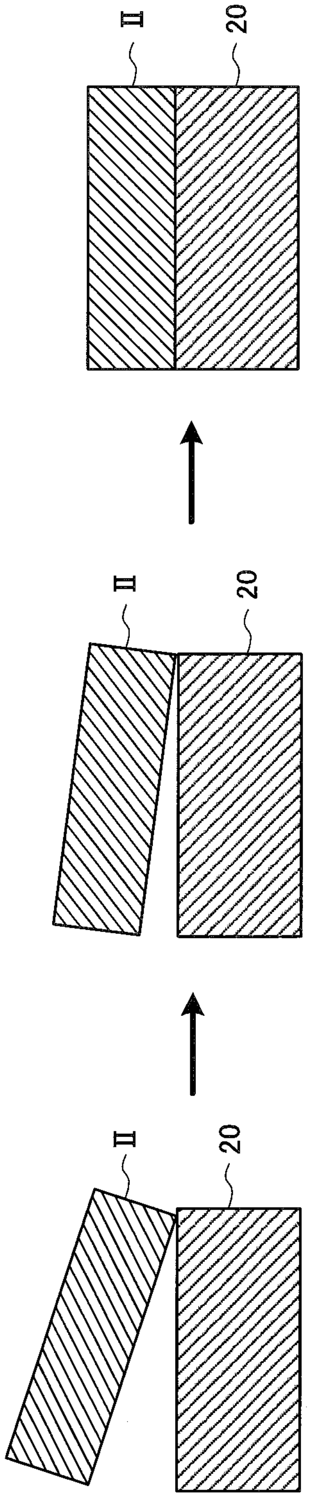


FIG.7A

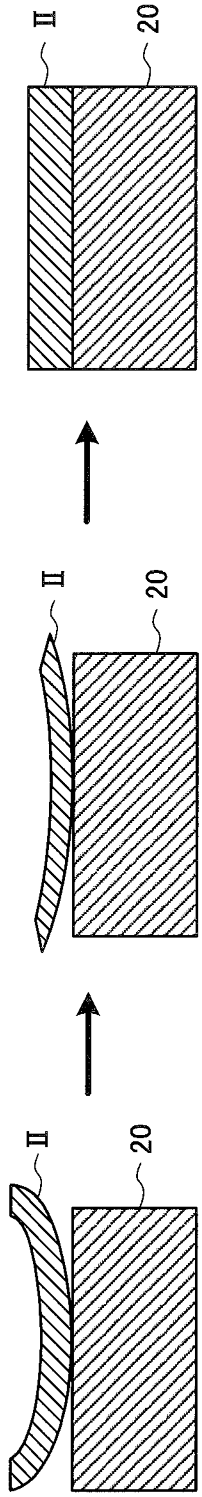


FIG.7B

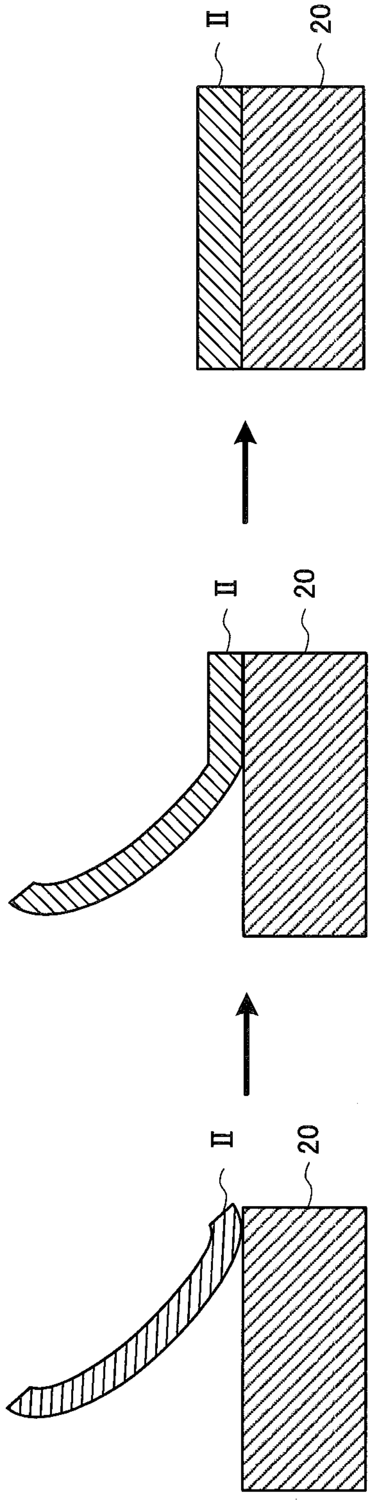


FIG.7C

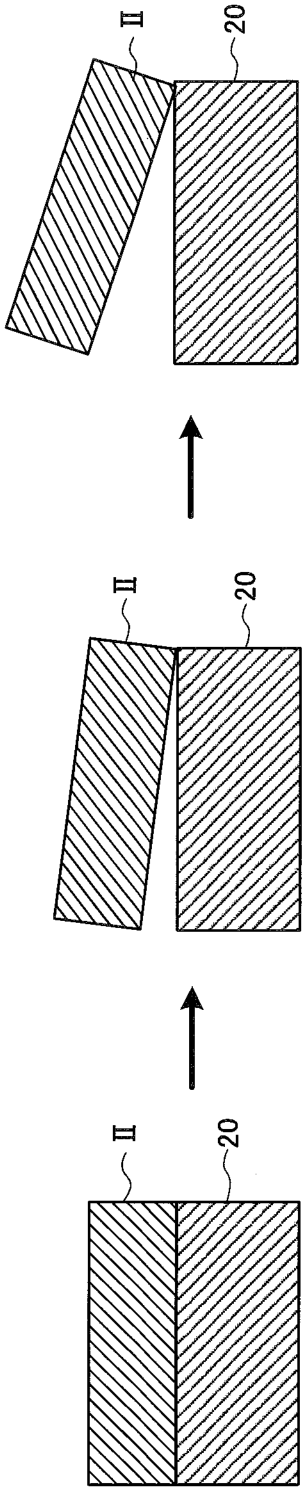


FIG.8A

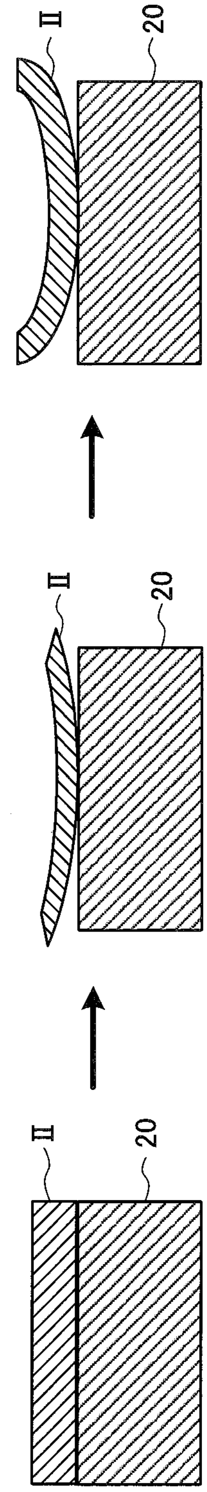


FIG.8B

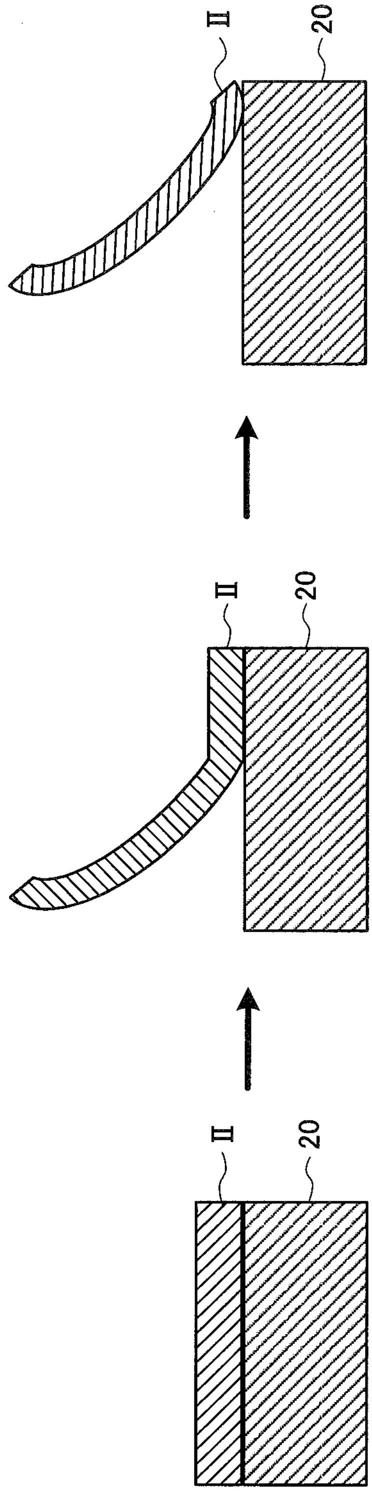


FIG.8C

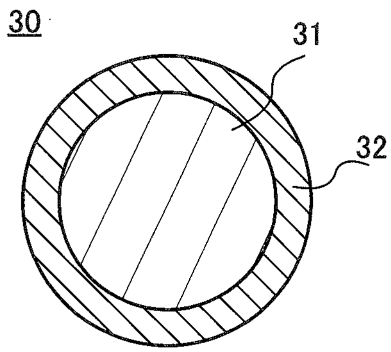


FIG.9A

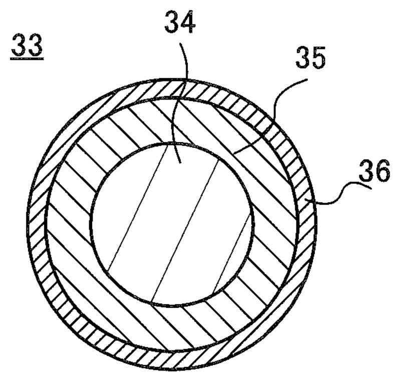


FIG.9B

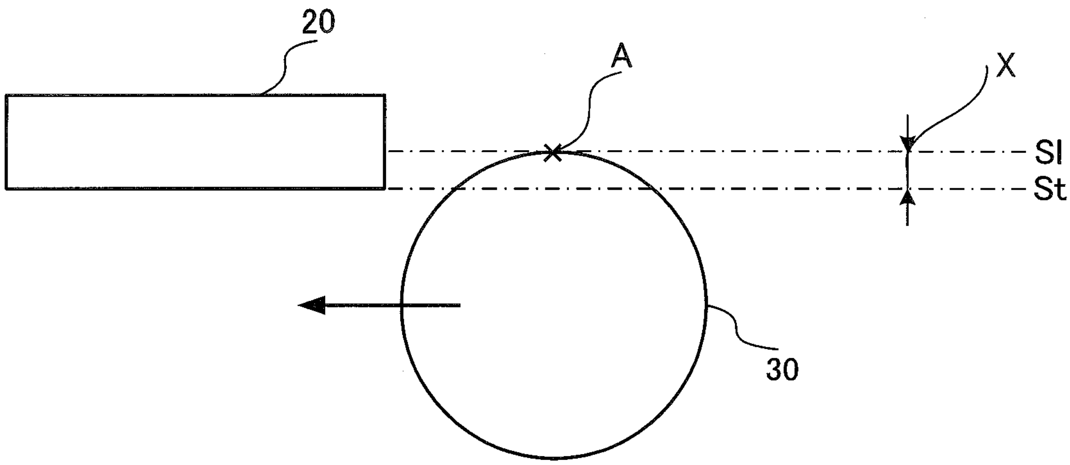


FIG.10

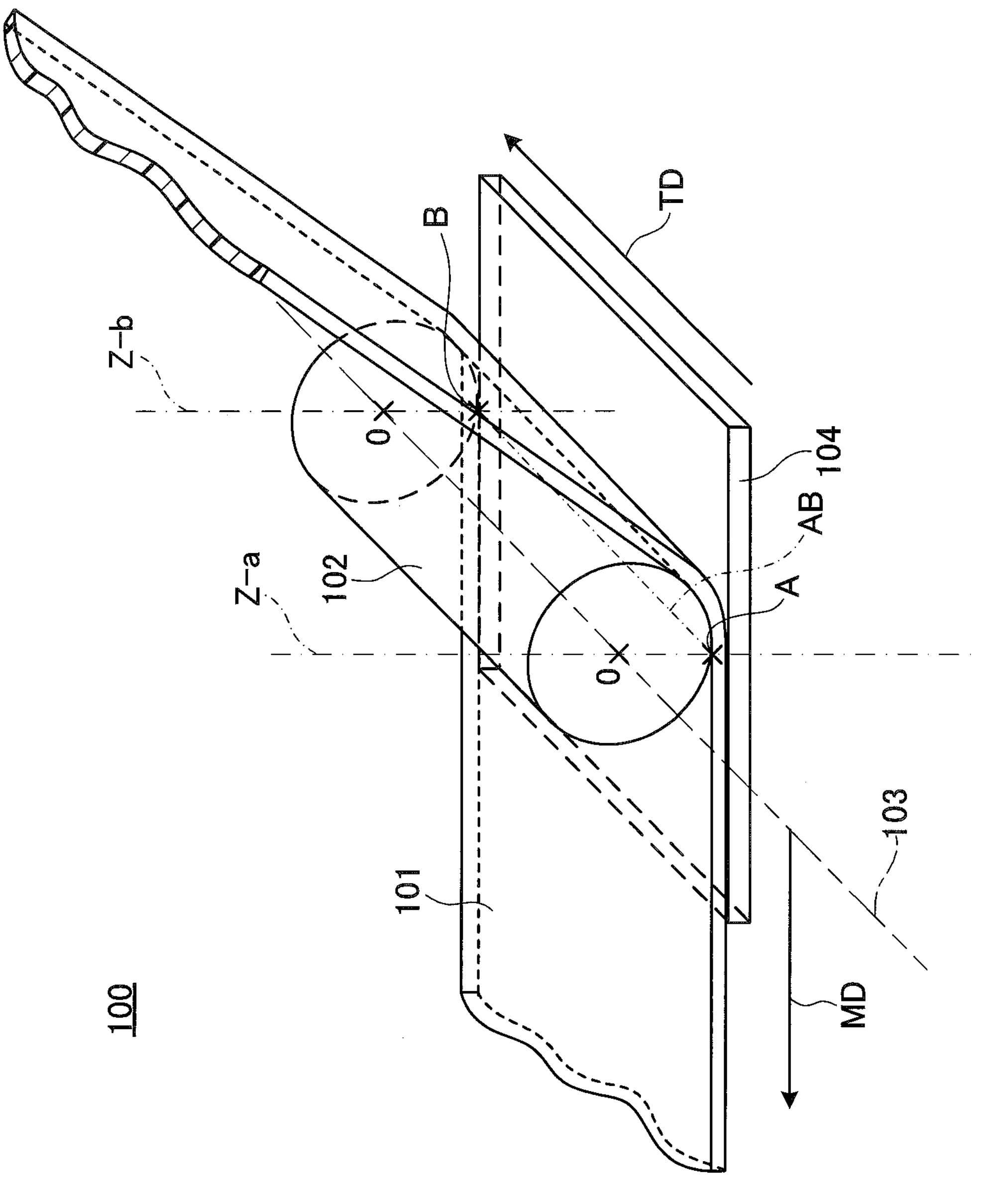


FIG.11

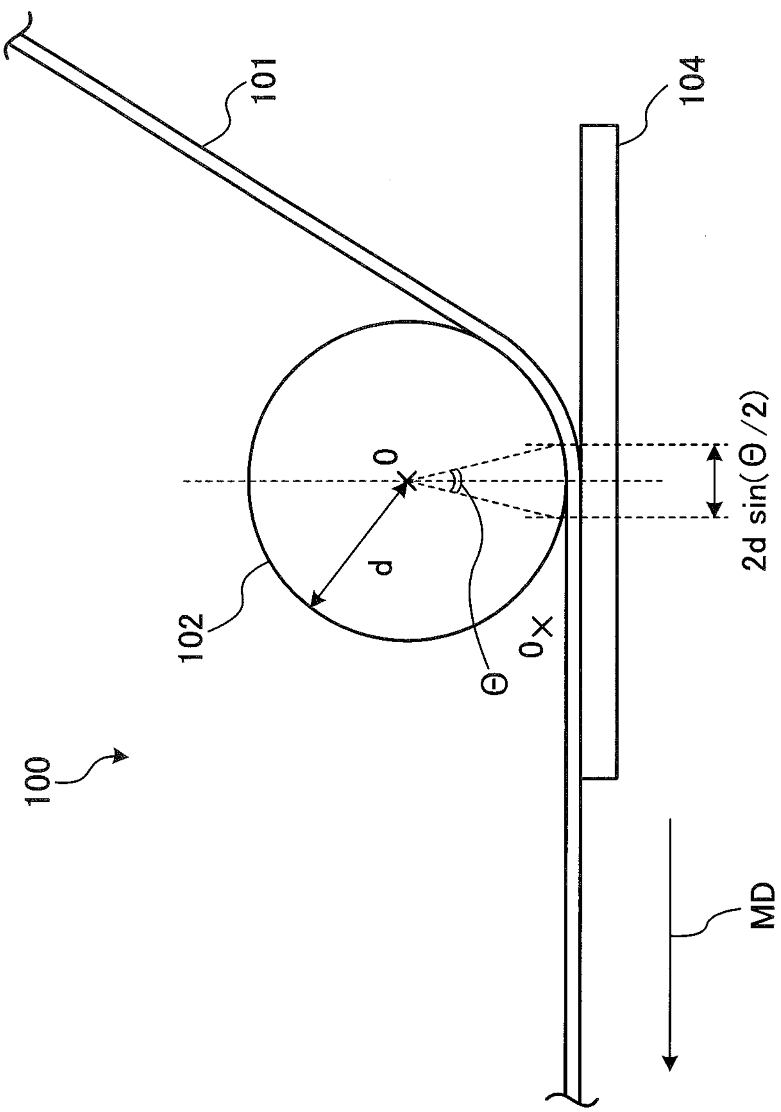


FIG.12

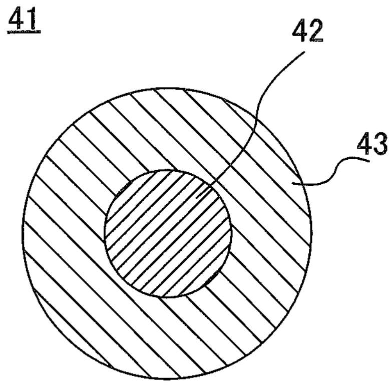


FIG.13A

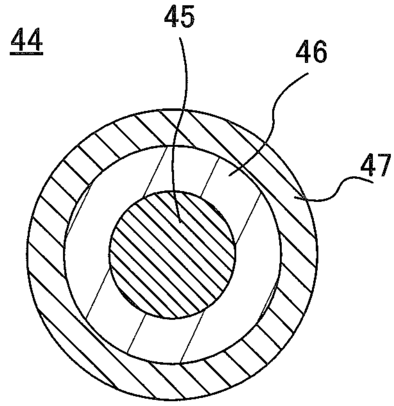


FIG.13B

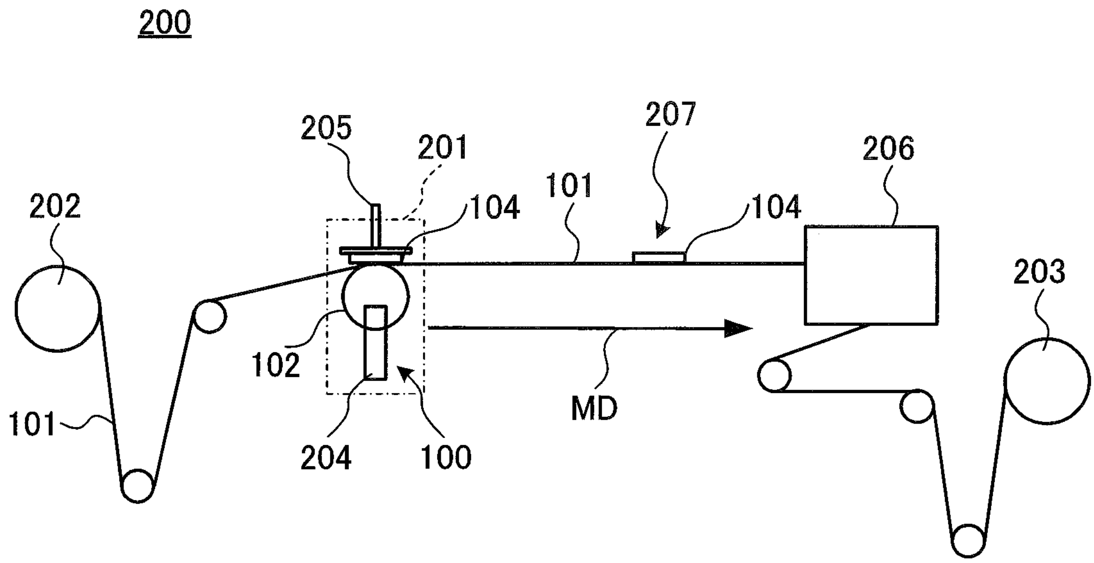


FIG.14

FIG.15A

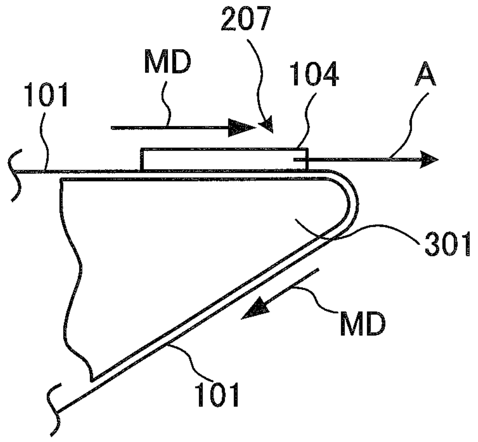


FIG.15B

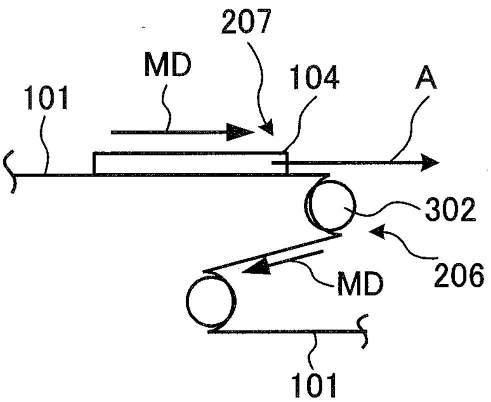


FIG.16A

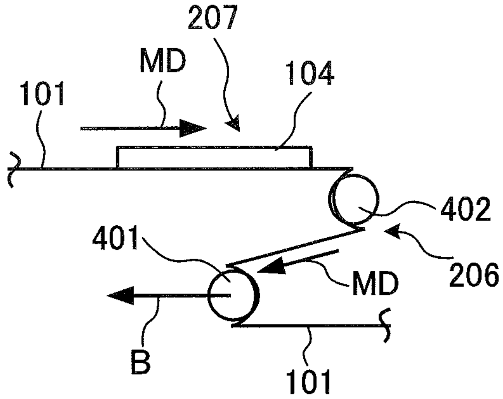


FIG.16B

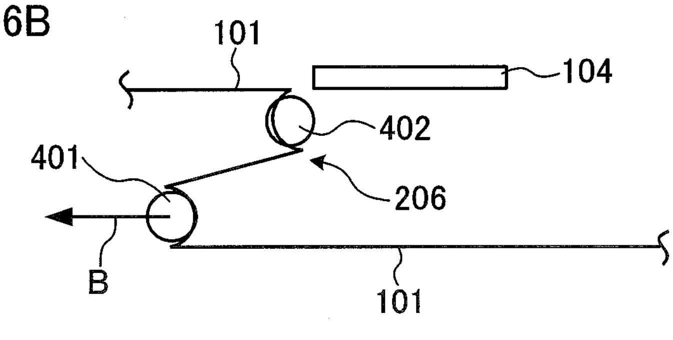

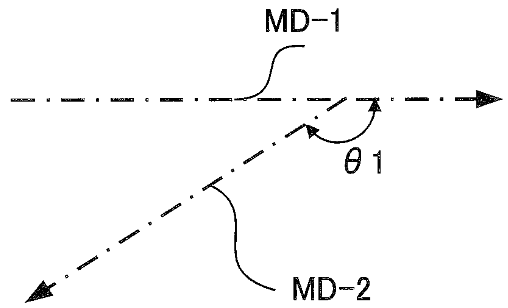


FIG.17

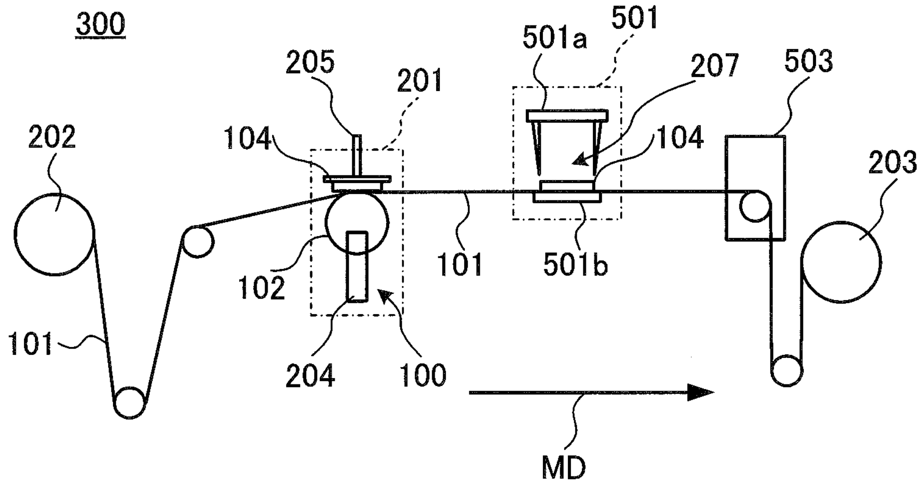


FIG.18

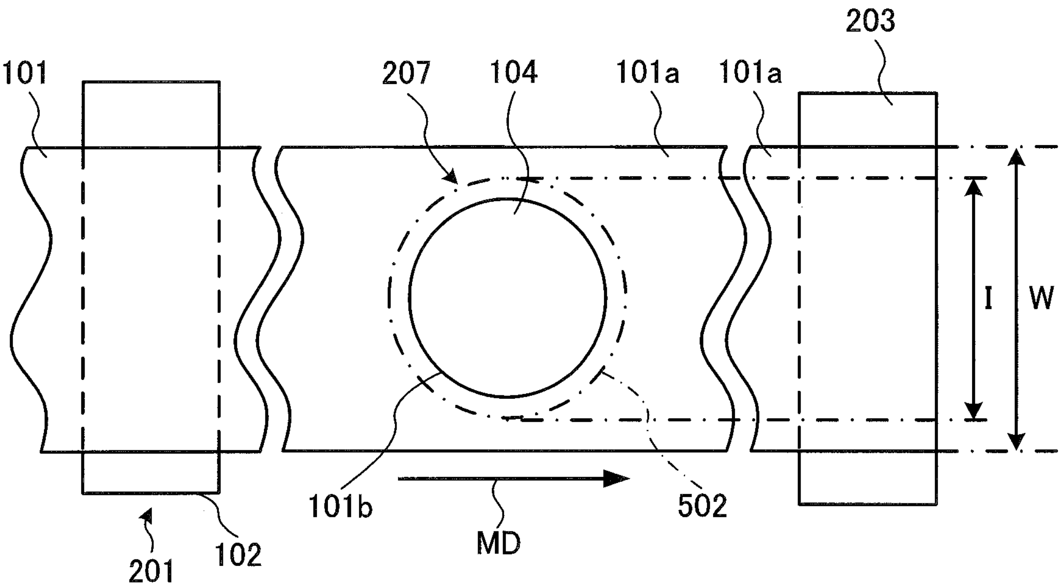


FIG.19

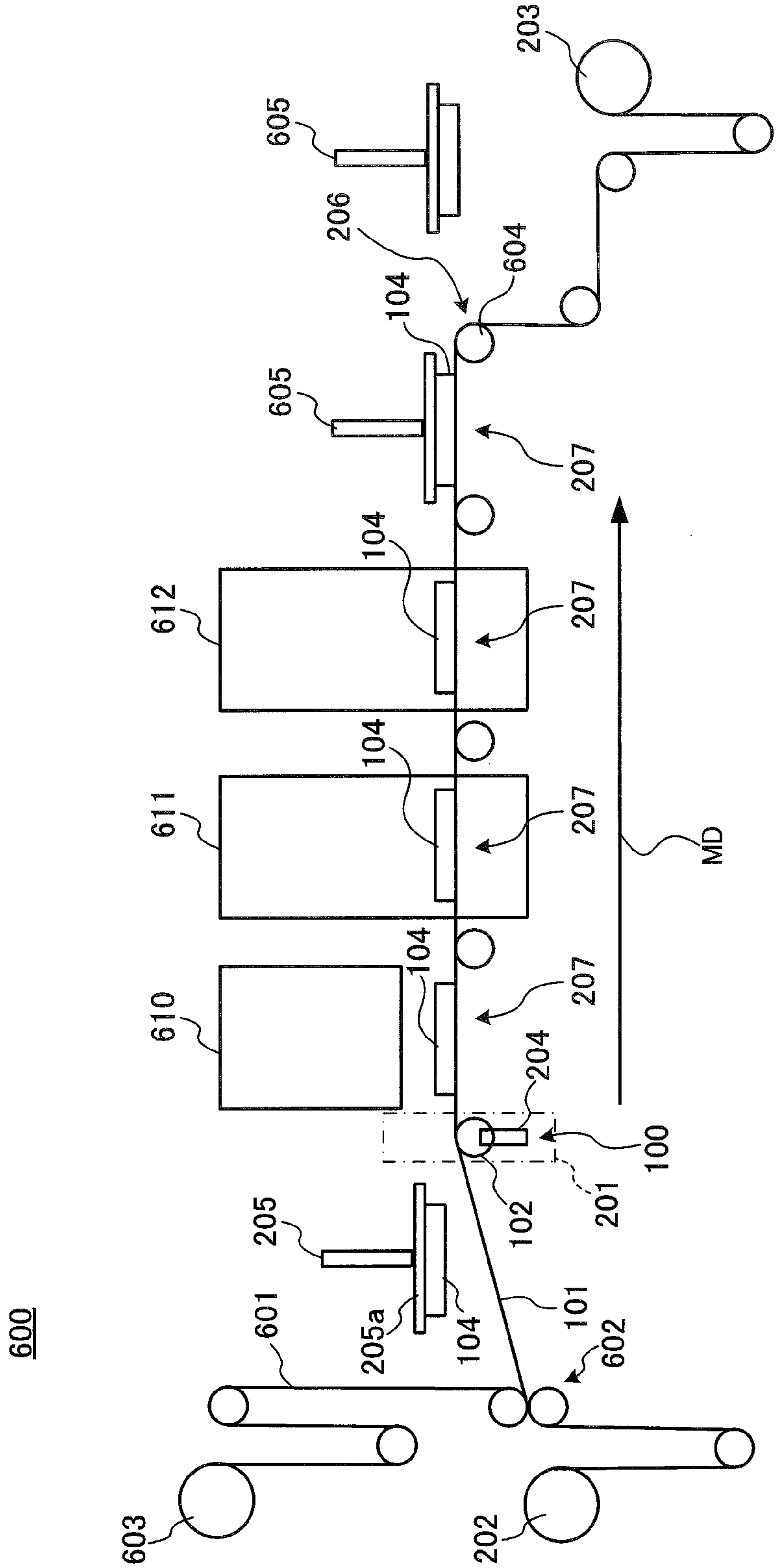
600
603
601
202
602
205a
104
205
101
102
201
100
204
610
104
207
611
104
207
612
104
207
MD
605
104
207
206
604
605
203

FIG.20

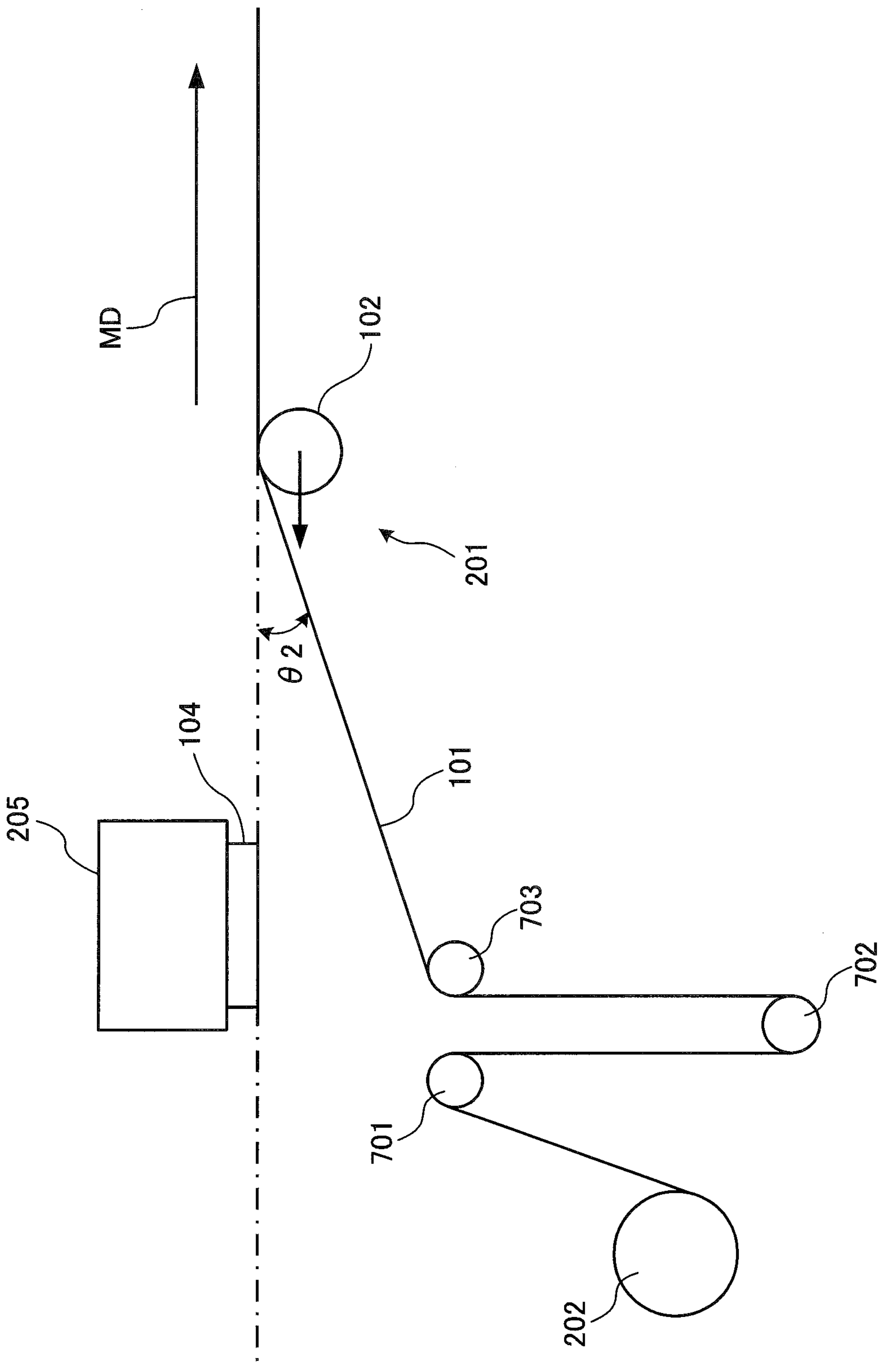


FIG.21

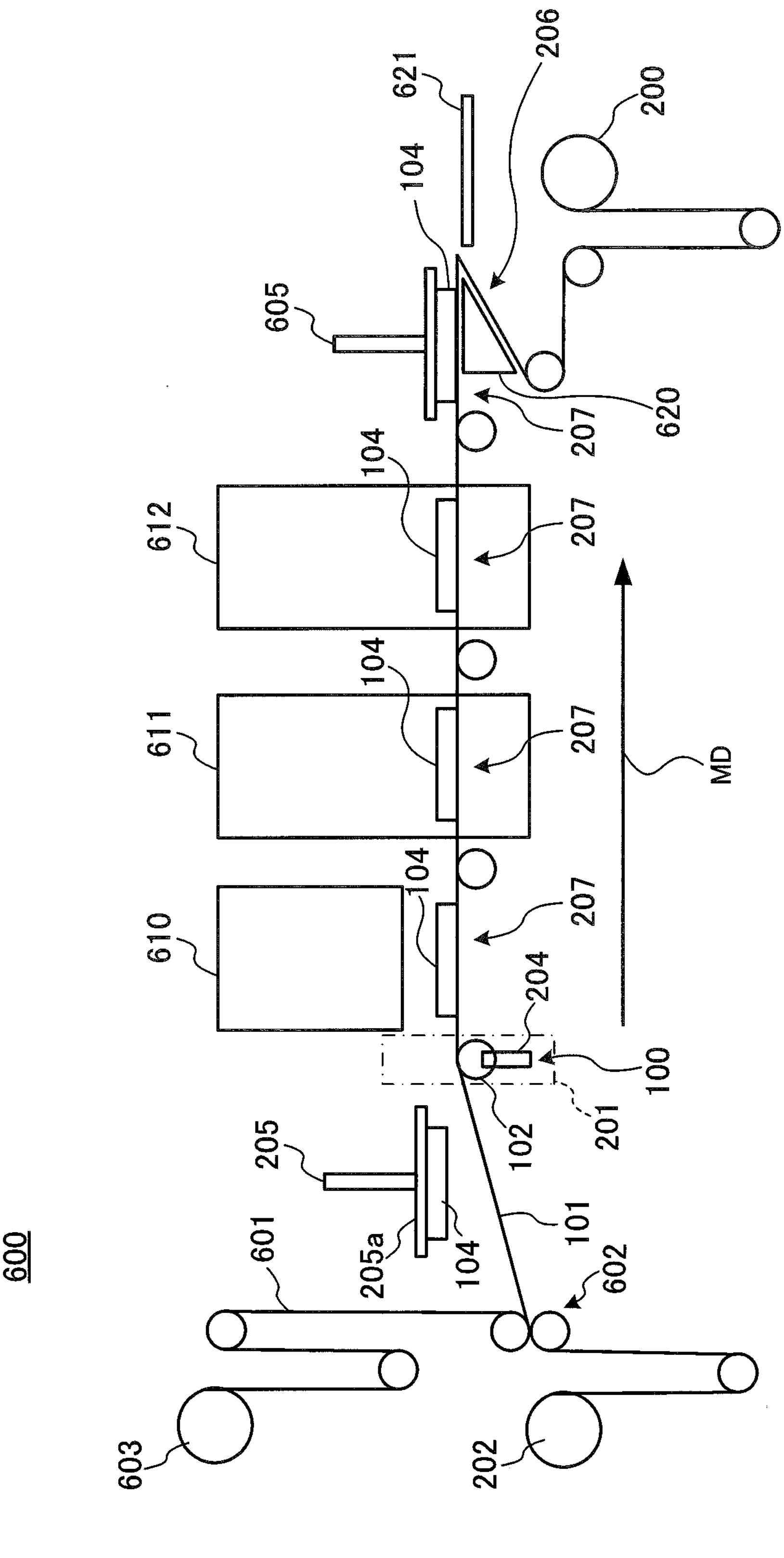
600
601
602
603
202
205
205a
104
101
102
201
100
204
207
610
104
207
611
104
207
612
104
MD
605
104
207
620
206
621
200

FIG.22

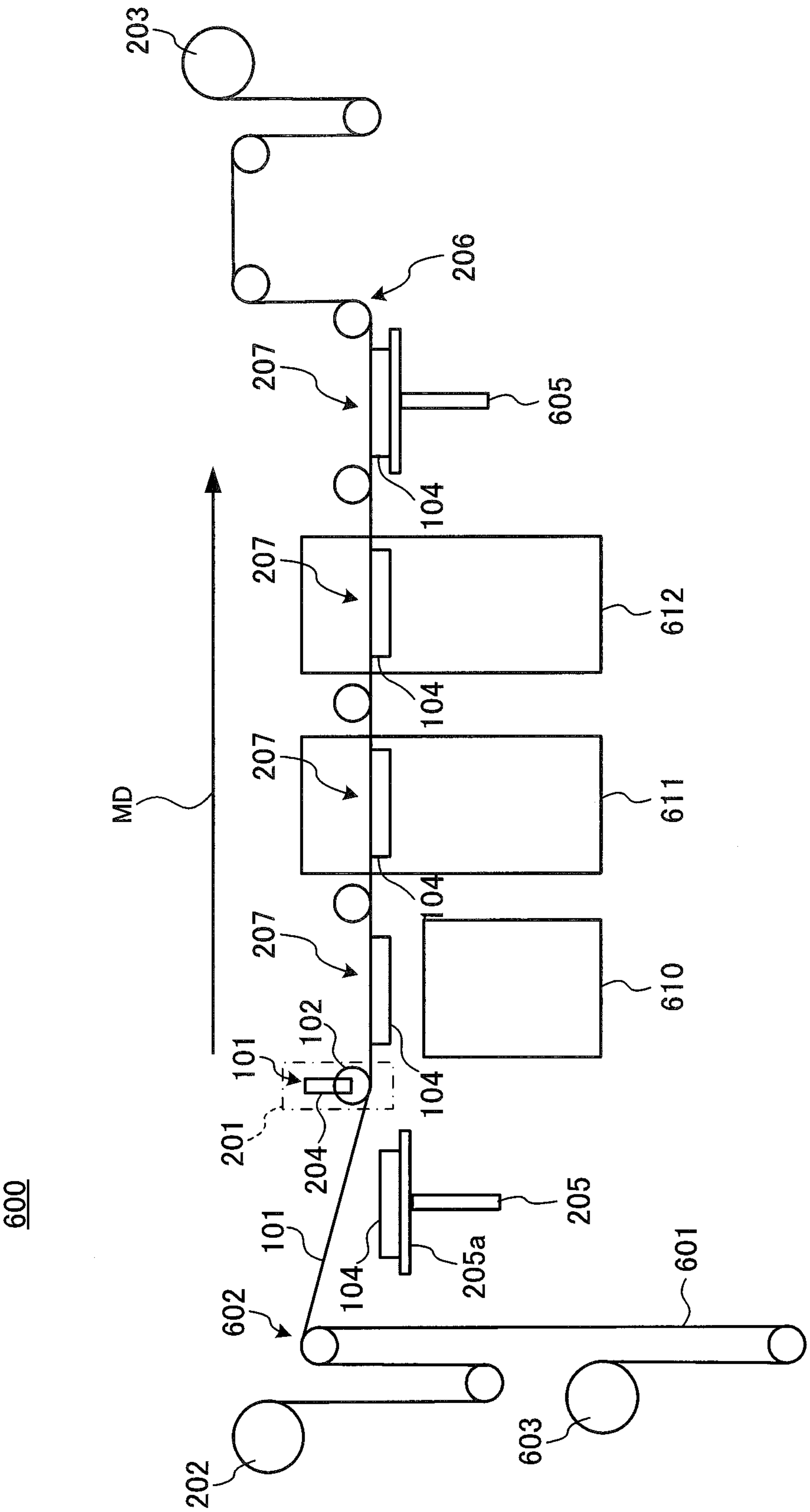
600
203
206
207
605
104
612
611
610
MD
101
102
201
204
205
205a
601
602
202
603

FIG.23

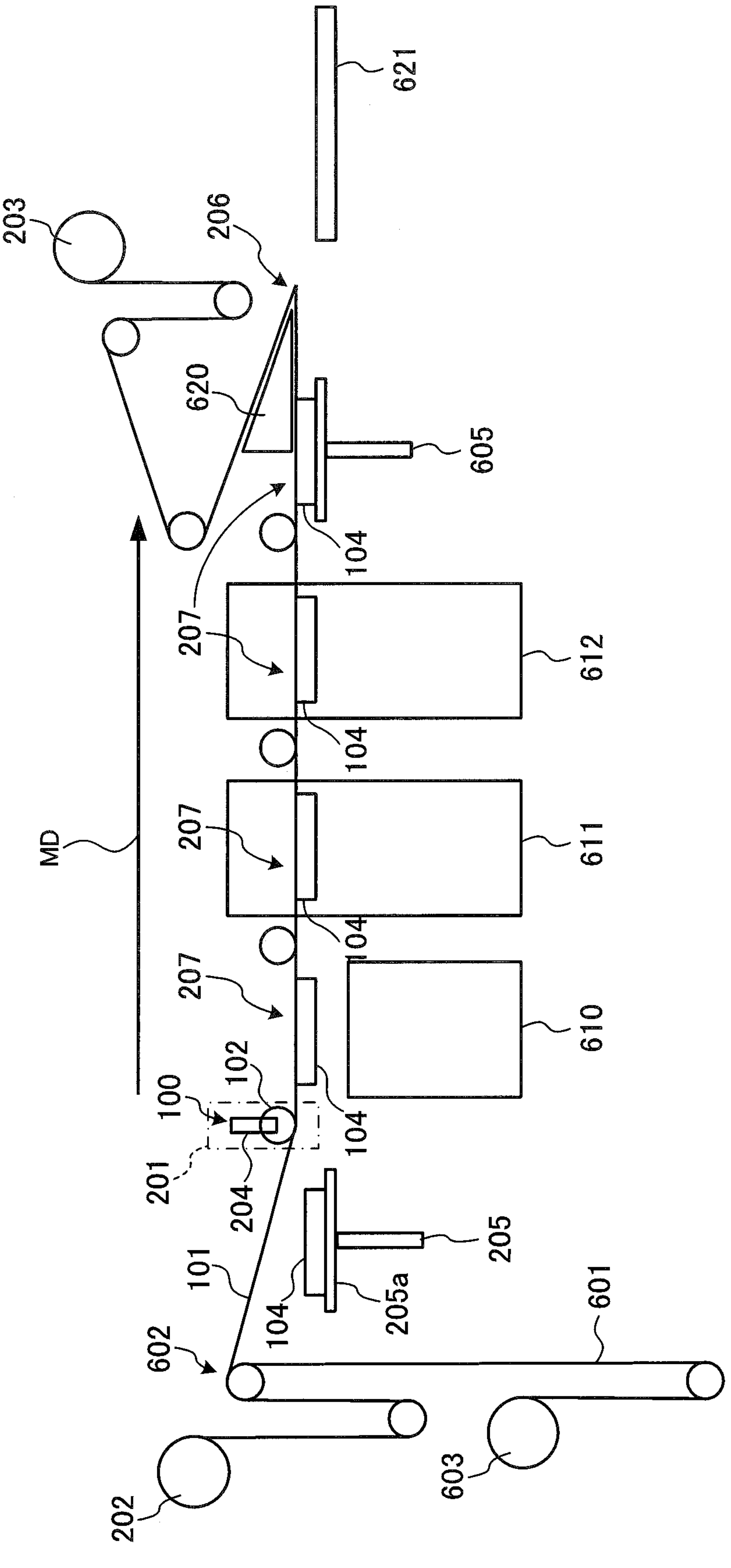
621
203
206
620
605
104
MD
207
612
104
207
611
104
207
610
100
102
104
201
204
205
101
205a
104
601
602
603
202

FIG.24

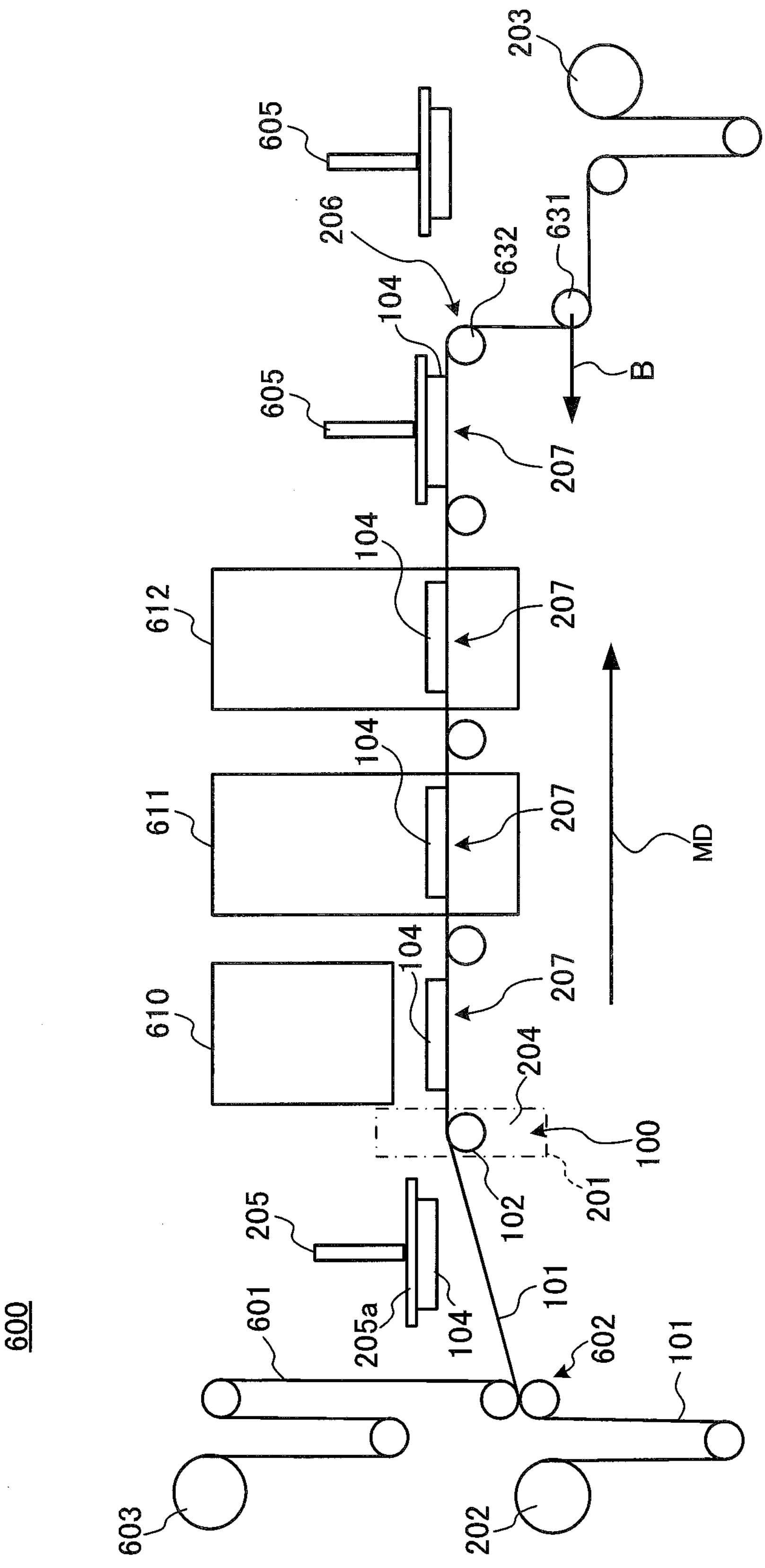
600
603
601
202
602
101
205a
104
205
102
201
100
204
610
207
611
612
104
MD
605
206
632
631
B
203

FIG.25

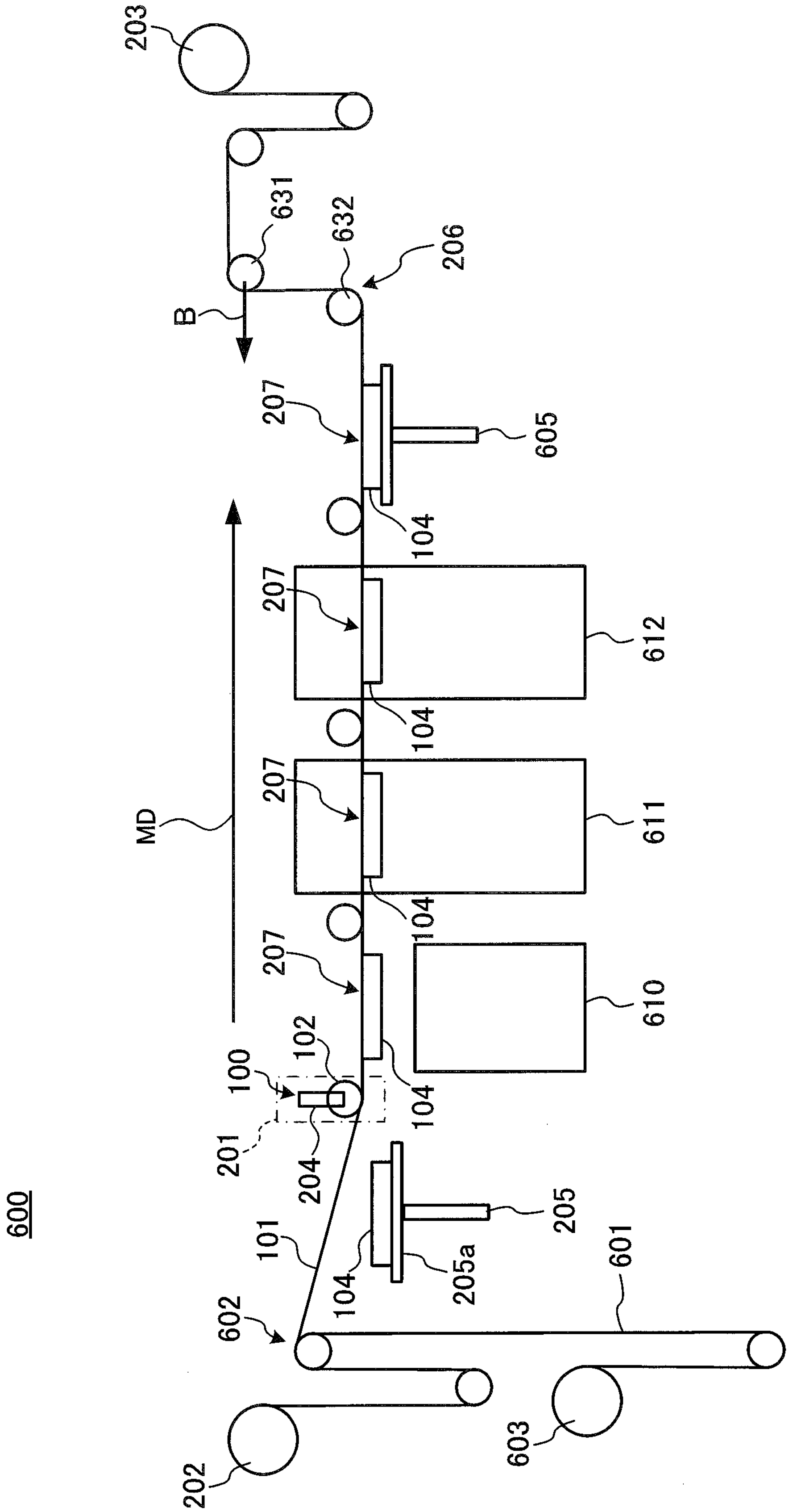
600
203
631
632
206
B
207
605
104
MD
612
611
610
100
102
201
204
101
205
205a
601
602
603
202

FIG.26

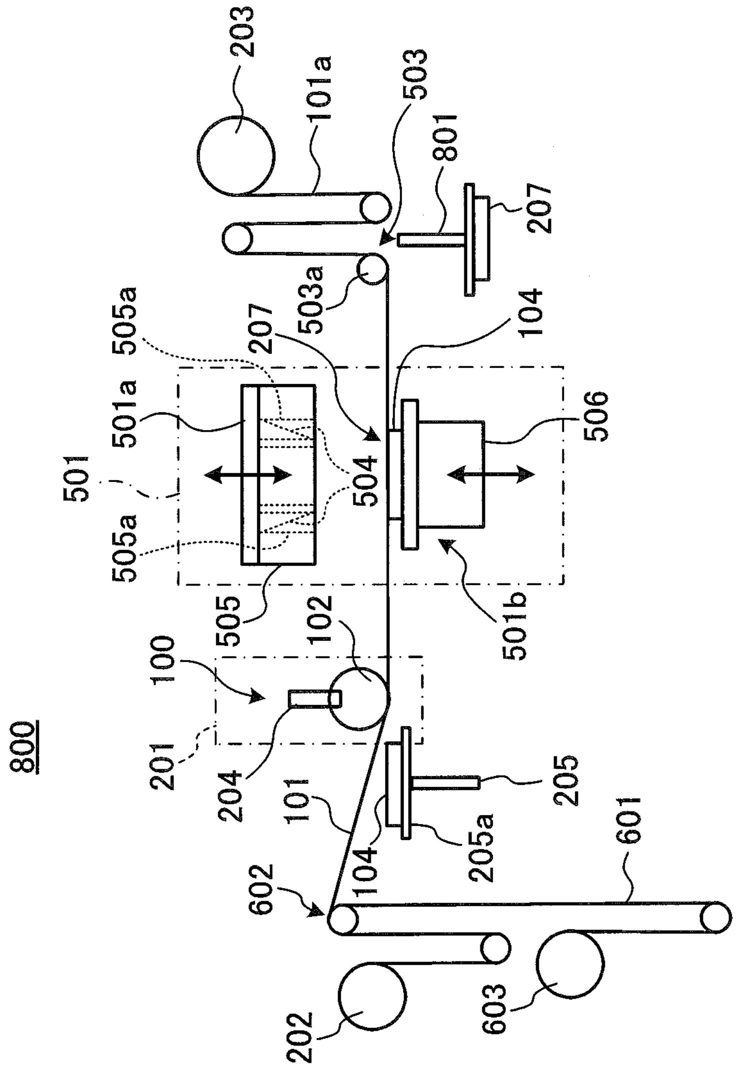
800
203
101a
503
801
207
503a
505a
501a
501
505a
207
104
506
504
505
501b
100
102
201
204
205
101
104
205a
601
602
202
603

FIG.27

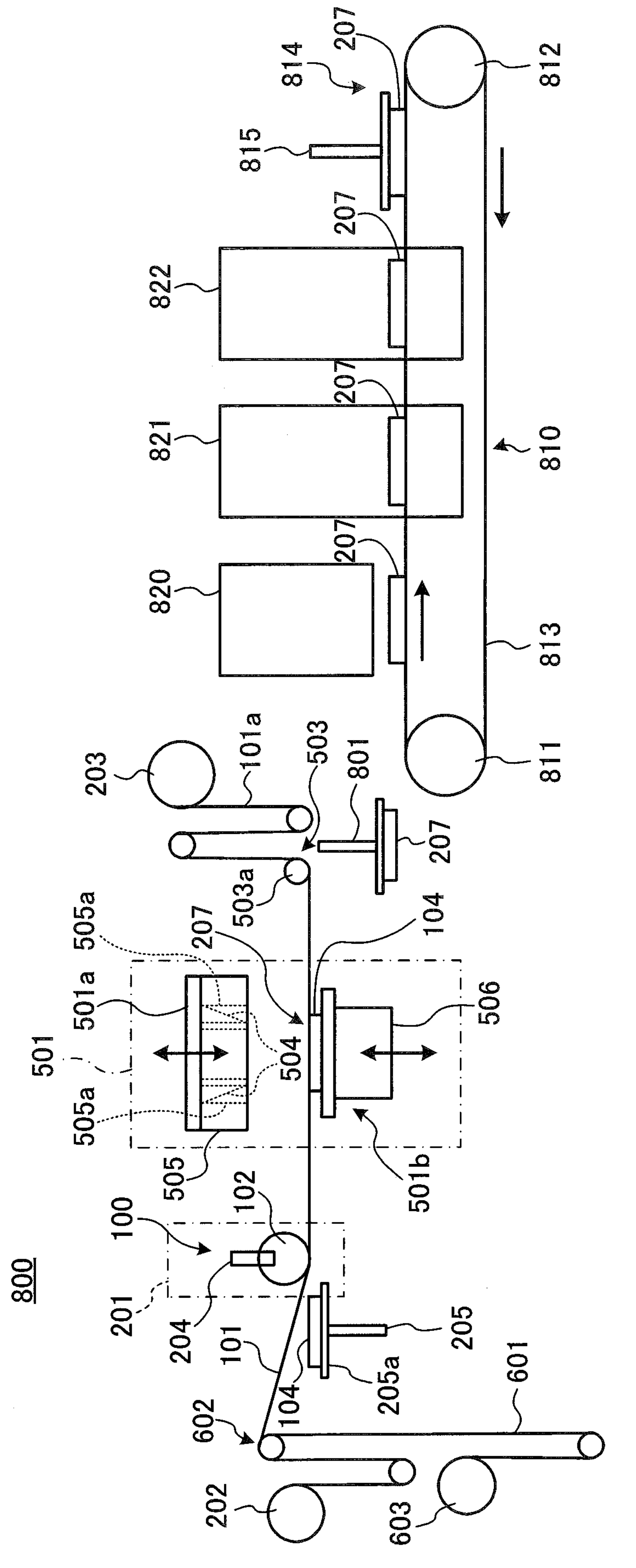
800
100
102
201
204
101
104
205
205a
601
602
202
603
505
505a
501
501a
505a
504
207
104
506
501b
503a
503
801
207
203
101a
811
813
810
820
207
821
207
822
207
815
814
207
812

FIG.28

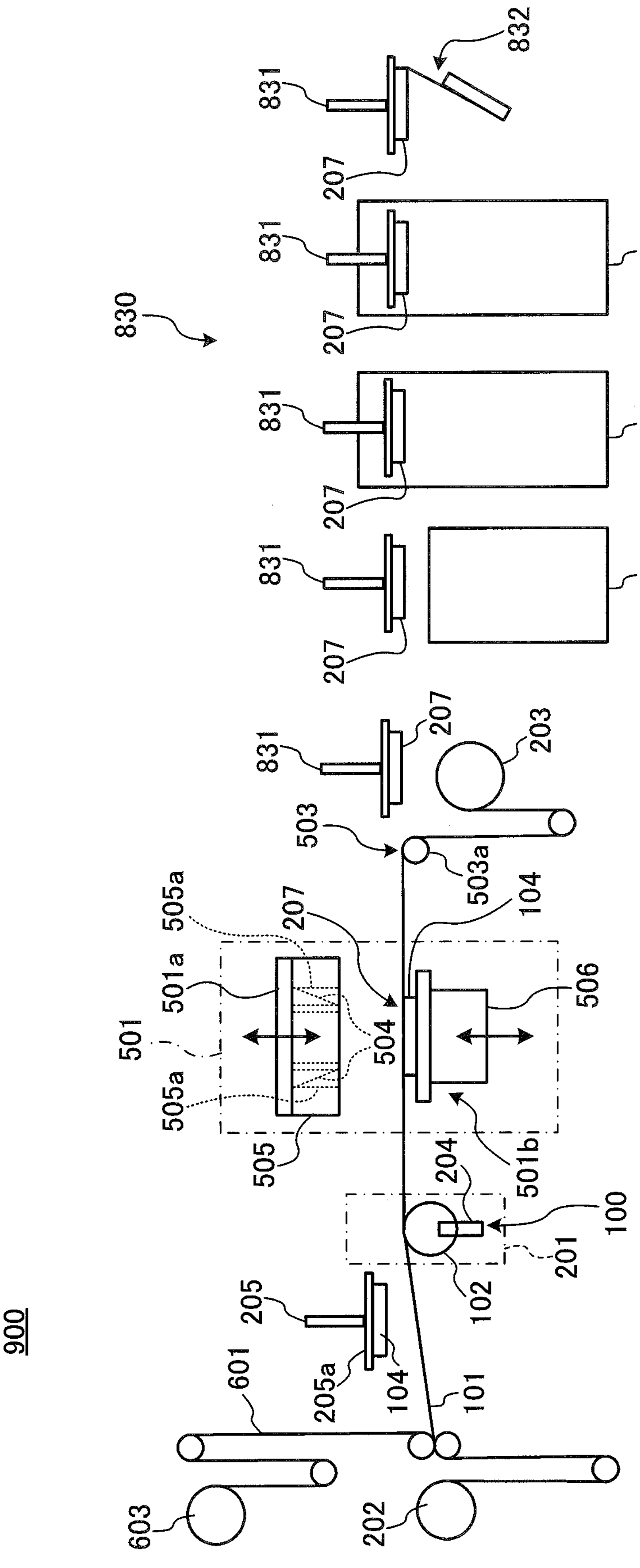
900
830
831
832
207
820
821
822
203
503
503a
104
505a
501a
501
504
505
506
501b
204
100
201
102
205
205a
601
101
603
202

FIG.29

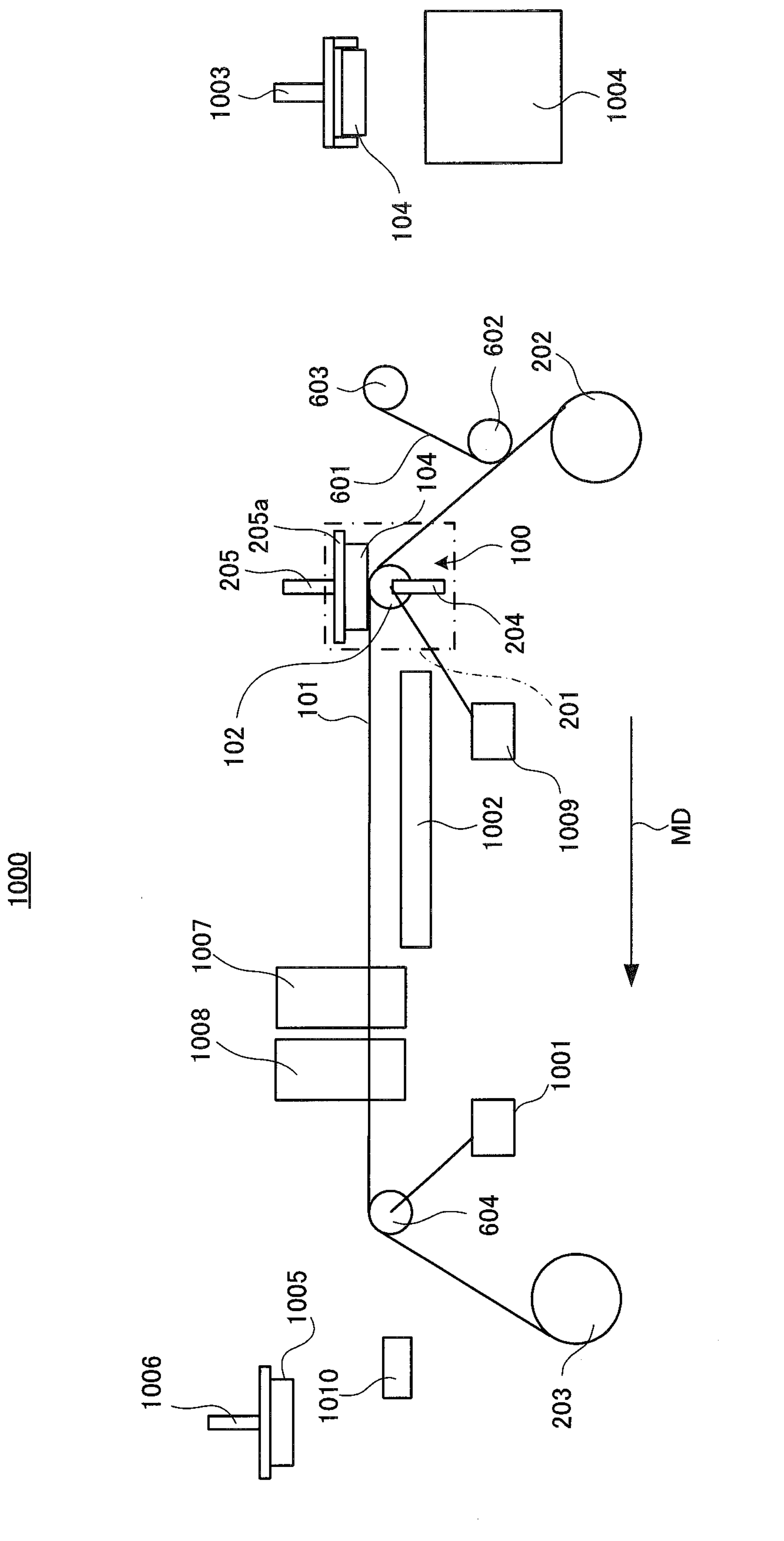
1000
1003
104
1004
603
602
202
601
104
205a
205
100
204
102
101
201
1002
1009
MD
1007
1008
1001
604
1005
1006
1010
203

FIG.30

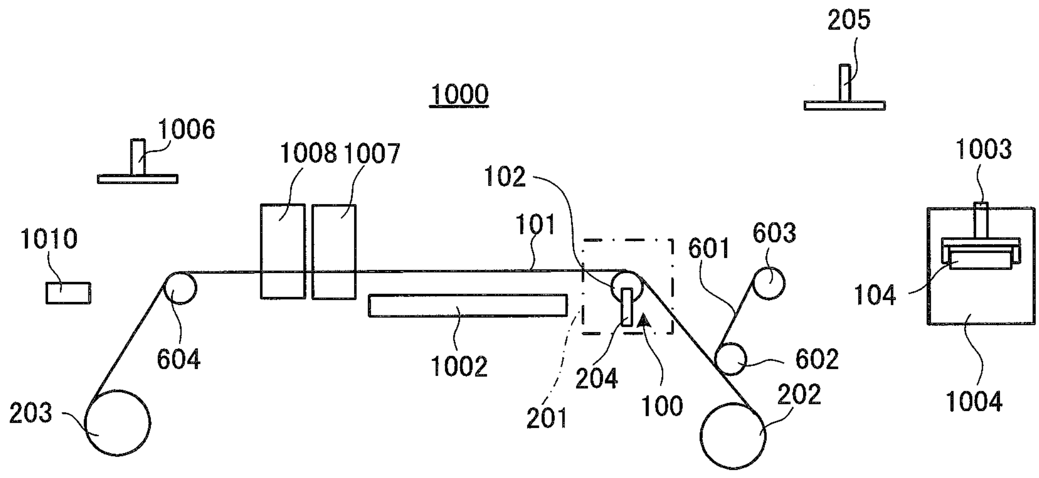


FIG.31A

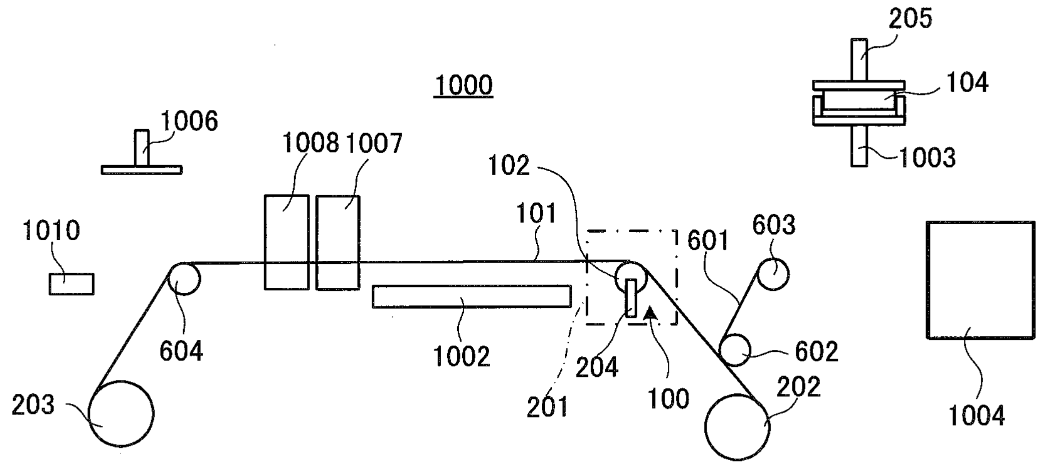


FIG.31B

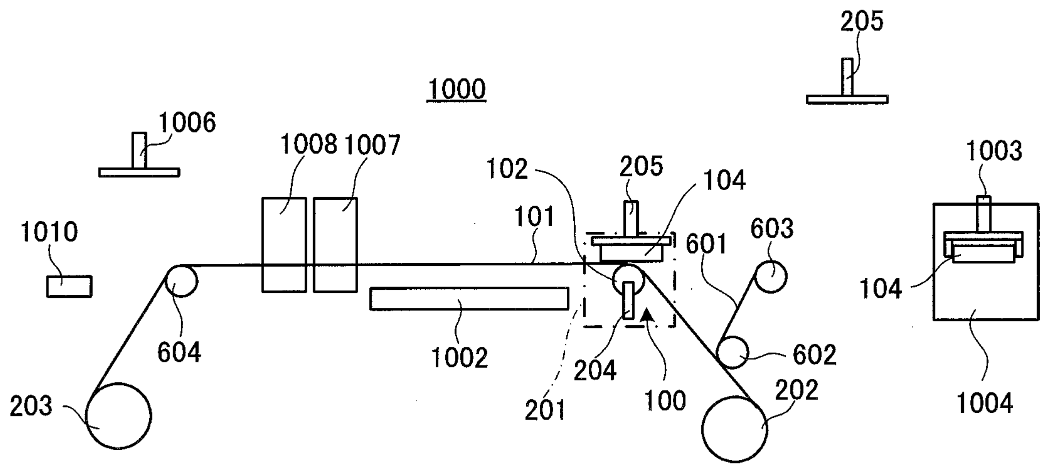


FIG.31C

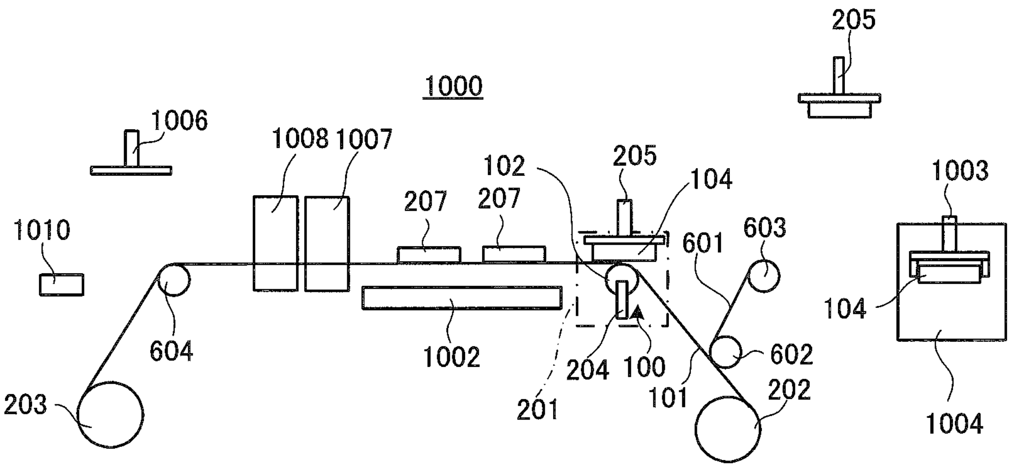


FIG.32A

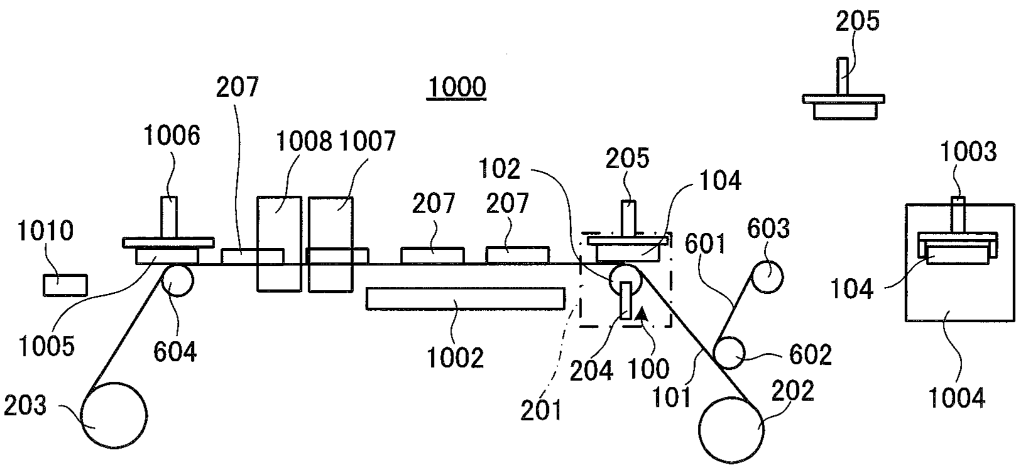


FIG.32B

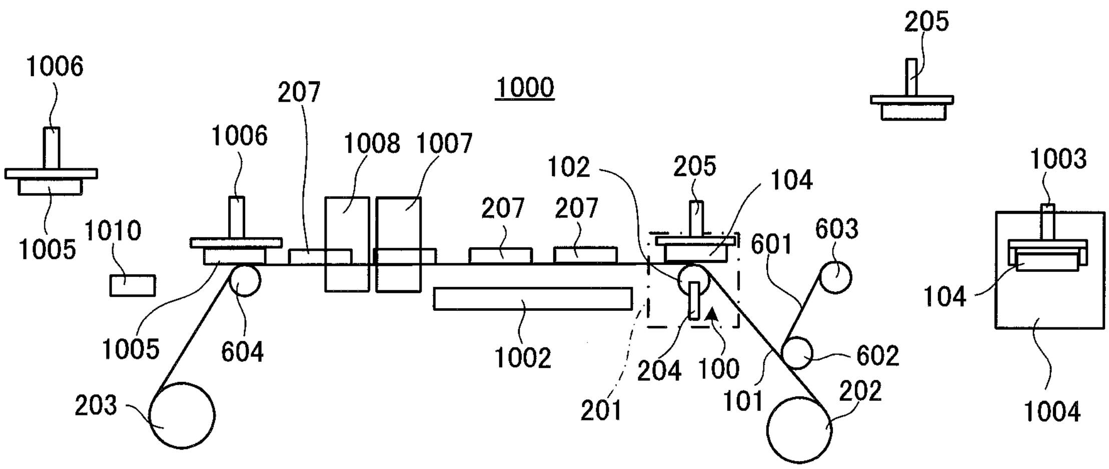


FIG.32C

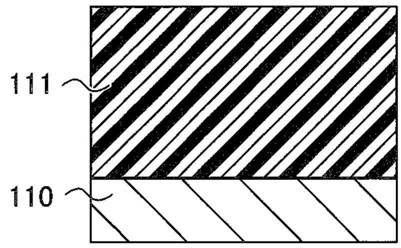


FIG.33A

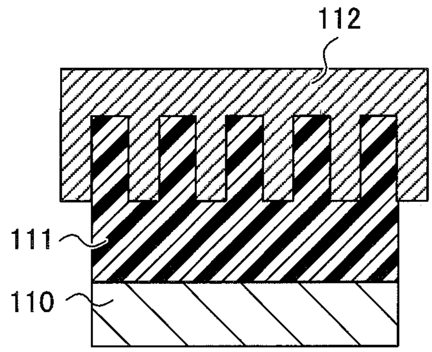


FIG.33B

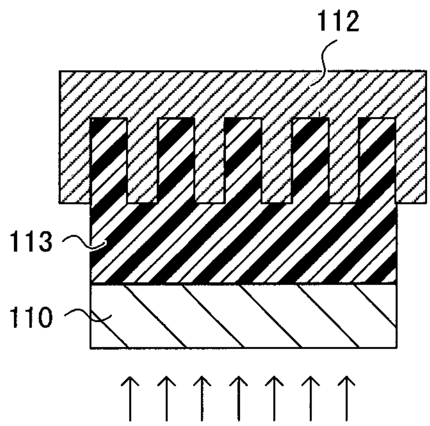


FIG.33C

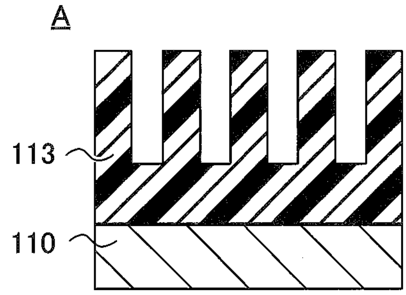


FIG.33D

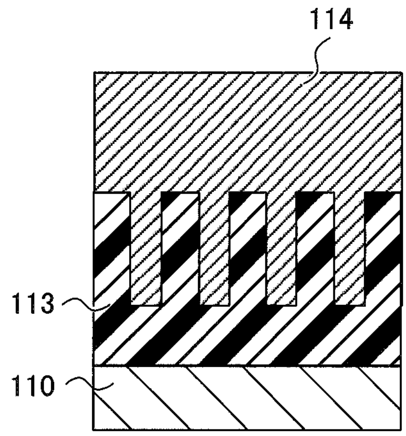


FIG.33E

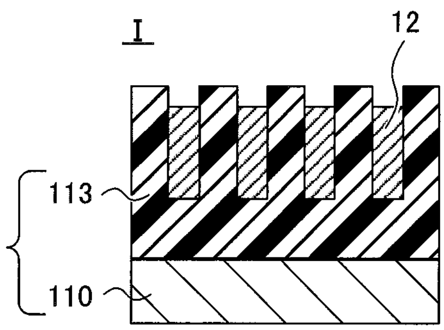


FIG.33F

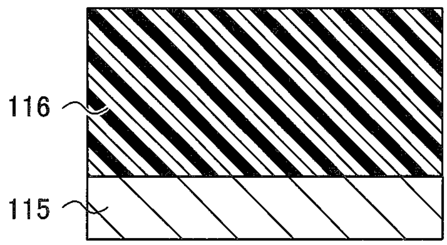


FIG.34A

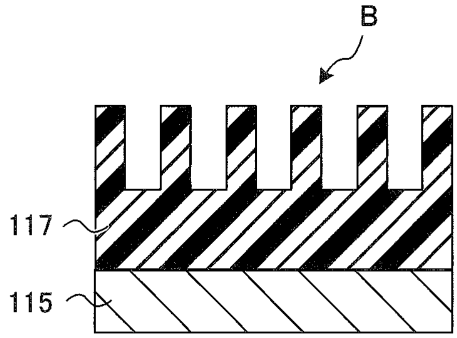


FIG.34D

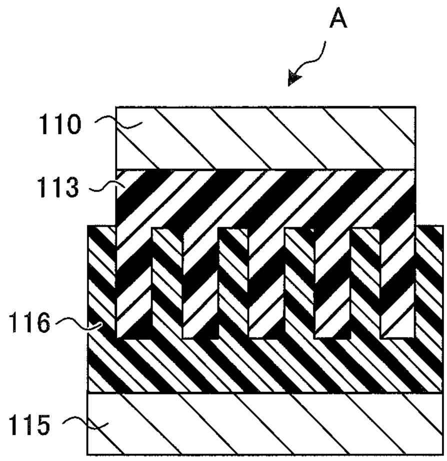


FIG.34B

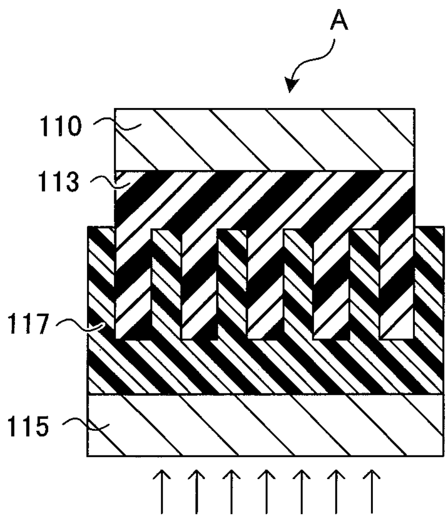


FIG.34C

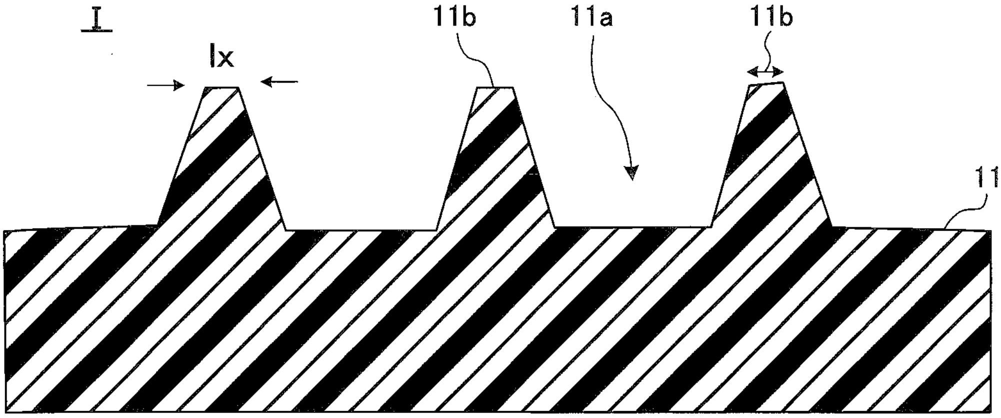


FIG.35A

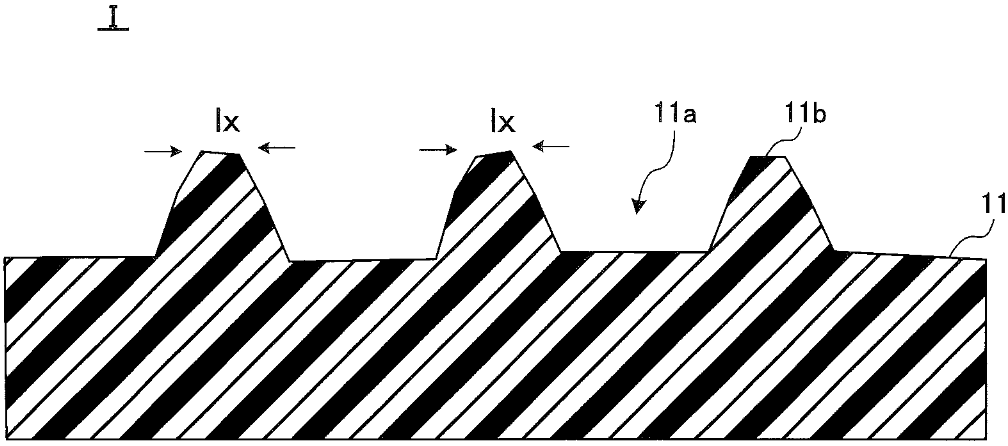


FIG.35B

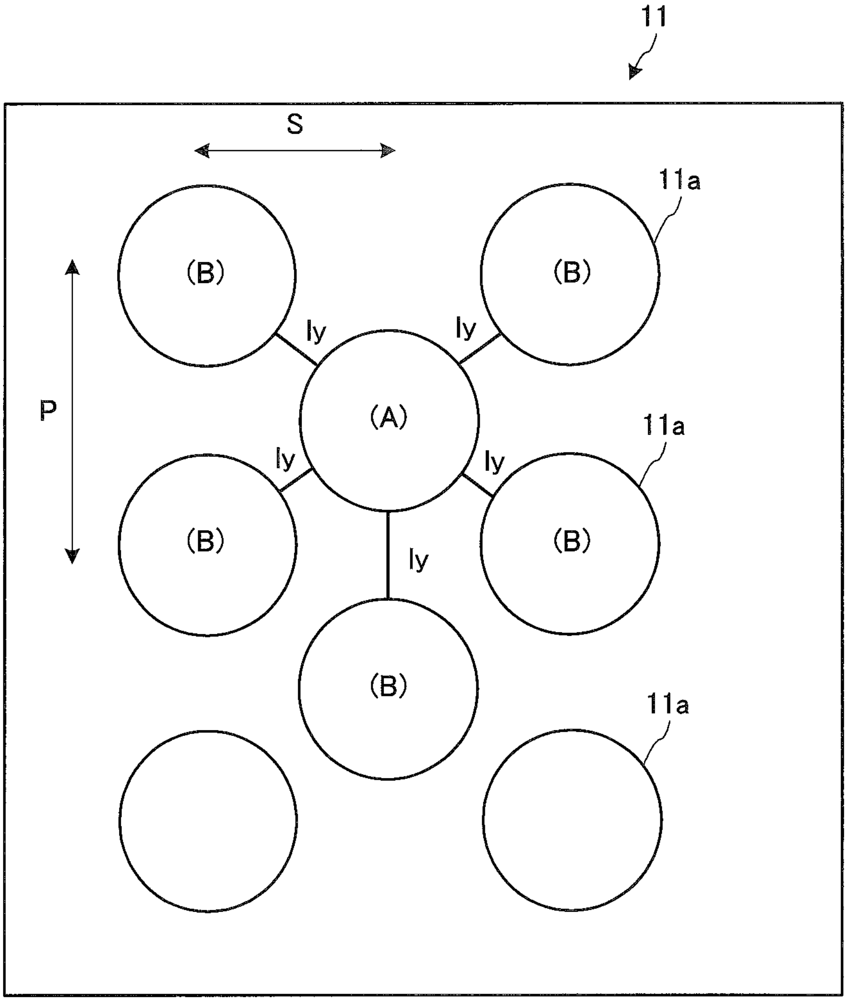


FIG.36

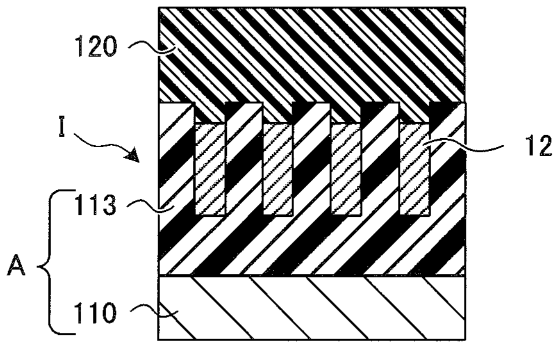


FIG.37A

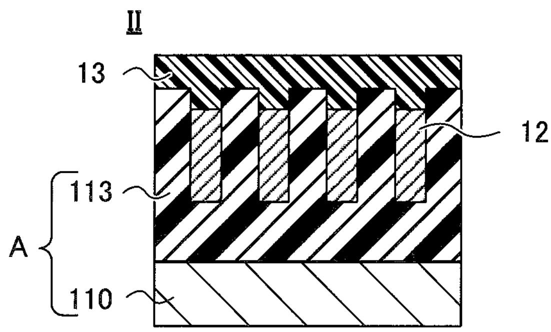


FIG.37B

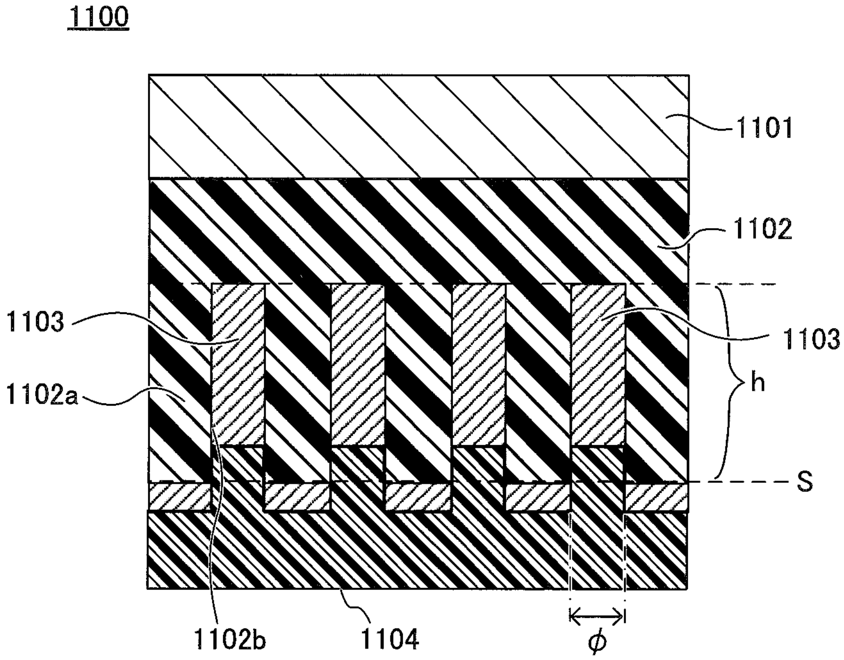
1100
1101
1102
1103
1103
1102a
h
S
1102b
1104
φ

FIG.38

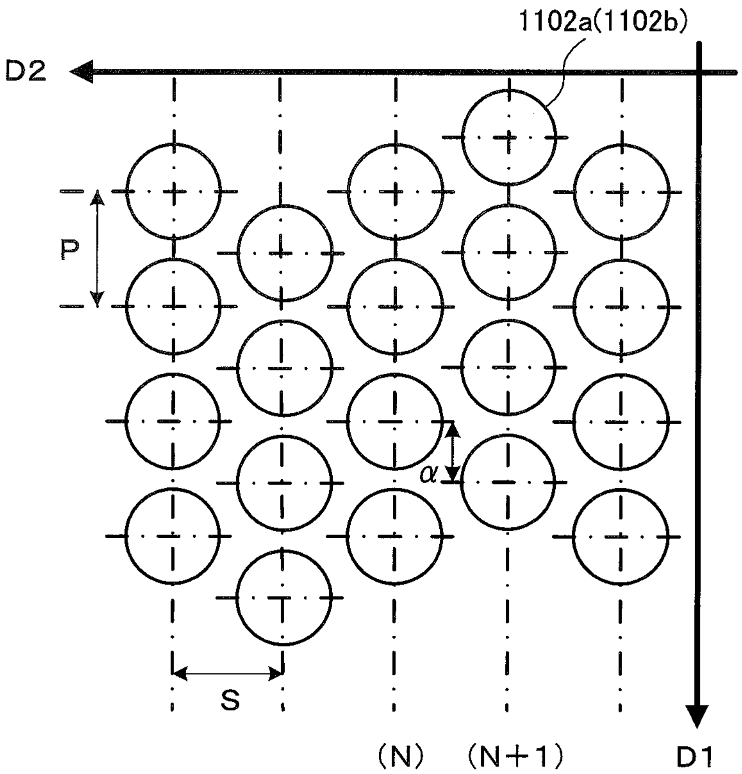
1102a(1102b)
D2
P
α
S
(N)
(N+1)
D1

FIG.39

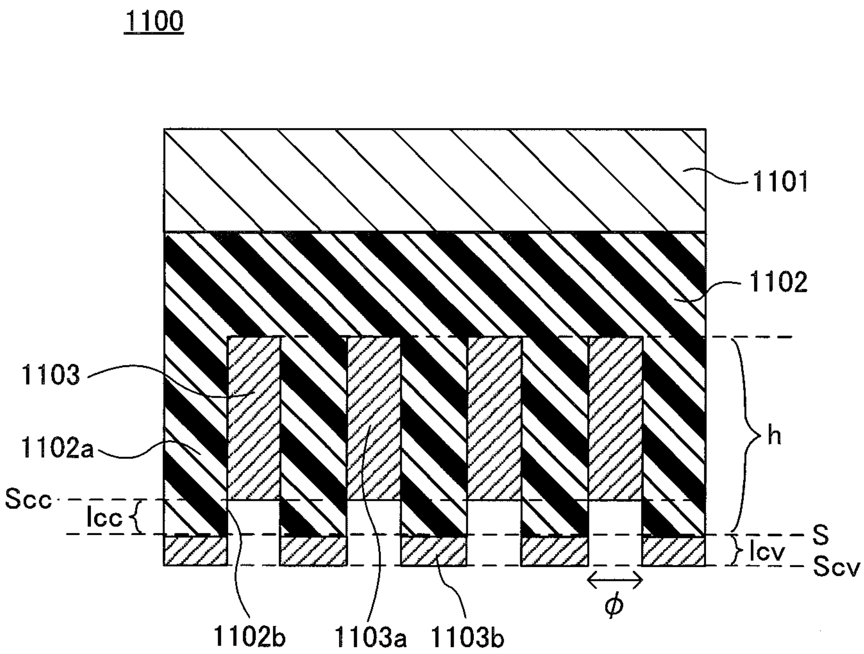
1100
1101
1102
1103
1102a
Scc
lcc
h
S
lcv
Scv
ϕ
1102b
1103a
1103b

FIG.40

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011020272 A
- JP 4943876 B
- US 2011195189 A
- US 2011290759 A
- JP 2010284814 A
- JP 2007144995 A
- US 2009046362 A
- JP 2009190300 A
- JP 2006164365 A